(19) Europäisches Patentamt
European Patent Office
Office européen des brevets

(11) **EP 4 547 614 B1**

(12) **EUROPEAN PATENT SPECIFICATION**

(45) Date of publication and mention
of the grant of the patent:
**29.04.2026  Bulletin 2026/18**

(21) Application number: **23741201.0**

(22) Date of filing: **21.06.2023**

(51) International Patent Classification (IPC):
*C03C 3/091* $^{(2006.01)}$          *C03C 4/08* $^{(2006.01)}$
*H01L 21/66* $^{(2006.01)}$          *H01L 23/15* $^{(2006.01)}$
*H01L 25/18* $^{(2023.01)}$

(52) Cooperative Patent Classification (CPC):
**C03C 3/091; C03C 4/08; H10W 90/00**

(86) International application number:
**PCT/US2023/025797**

(87) International publication number:
**WO 2024/006119 (04.01.2024 Gazette 2024/01)**

(54) **REDUCED OPTICAL TRANSMITTANCE GLASSES FOR EMISSIVE DISPLAYS**

GLÄSER MIT REDUZIERTER OPTISCHER DURCHLÄSSIGKEIT FÜR EMISSIONSANZEIGEN

VERRES À TRANSMITTANCE OPTIQUE RÉDUITE POUR AFFICHAGES ÉMISSIFS

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **29.06.2022  US 202263367225 P
15.12.2022  US 202263432889 P
13.06.2023  US 202363507744 P**

(43) Date of publication of application:
**07.05.2025  Bulletin 2025/19**

(73) Proprietor: **Corning Incorporated
Corning, New York 14831 (US)**

(72) Inventors:
• **GUO, Xiaoju
Pittsford, New York 14534 (US)**

• **LI, Shenping
Painted Post, New York 14870 (US)**
• **LOCKER, Sean Thomas Ralph
Corning, New York 14830 (US)**
• **WILES, Nicole Taylor
Horseheads, New York 14845 (US)**
• **ZHANG, Lu
Ithaca, New York 14850 (US)**

(74) Representative: **Elkington and Fife LLP
Prospect House
8 Pembroke Road
Sevenoaks, Kent TN13 1XR (GB)**

(56) References cited:
**WO-A2-2014/035791      US-A- 4 084 974
US-A- 5 256 607      US-A1- 2017 152 170
US-A1- 2018 016 183**

**Description**

CROSS-REFERENCE TO RELATED APPLICATIONS

This application claims the benefit of priority under 35 U.S.C. §119 of U.S. Provisional Application Serial No. 63/367225 filed on June 29, 2022, and U.S. Provisional Application Serial No. 63/432889 filed on December 15, 2022, and U.S. Provisional Application Serial No. 63/507744 filed on June 13, 2023.

TECHNICAL FIELD

Embodiments of the present disclosure relate to emissive displays. More particularly, embodiments of the present disclosure relate to a glass substrate suitable for emissive display devices, wherein the glass substrate exhibits a reduced transmittance.

BACKGROUND

US2017152170A1 and US2018016183A1 disclose alkali-free aluminosilicate glasses for display applications. While emissive displays, such as Micro-LED ($\mu$LED) displays and organic light emitting diode) OLED displays are highly desired, mass production of such displays suffers from low production yields and high cost and presents technical challenges for emerging high-resolution displays.

One challenge pertains to the manufacture of large-area emissive displays. A well-accepted, cost-effective approach for creating a large-area emissive display is to arrange multiple small format displays (tiles) to form a large-area display. However, such designs may experience light leakage at edges of individual tiles. This light leakage may be visible to the viewer as a bright line at the seam between tiles. There are several existing methods to mitigate seam visibility - one is edge coating. Another is lamination of a low transmission film. For edge coating, coating precision and reliability are challenging. For lamination of low transmission film, the main issue is reliability, including both mechanical and environmental durability.

Another issue that may be experienced by an emissive display is the degradation of contrast ratio. Because light confinement of the lightguide formed by encapsulation layers of an emissive display (such as an optically clear adhesive layer and a cover plate (e.g., glass cover plate), the light emitted from one pixel emitter may bleed into neighboring pixels through the lightguide. This can result in a reduction in display contrast and cause a "halo" effect.

SUMMARY

In a first aspect, a glass article is disclosed comprising a glass having a composition comprising in mole percent on an oxide basis:

| | |
|---|---|
| $SiO_2$ | 61 - 74; |
| $Al_2O_3$ | 9 - 14; |
| $B_2O_3$ | 0 - 12; |
| MgO | 0 - 9; |
| CaO | 3.5 - 12; |
| SrO | 0 - 5; |
| BaO | 0 - 5; |
| $SnO_2$ | 0 - 0.15; |
| NiO | 0.025 - 0.13; |
| $Co_3O_4$ | 0.005 - 0.04; and |

wherein $(MgO+CaO+SrO+BaO)/Al_2O_3$ is equal to or greater than about 1, and an average optical transmittance of the glass article over a wavelength range from 450 nm to 650 nm for a thickness of 0.7 mm is less than about 90%. The glass may be an alkali free glass.

In a second aspect, the average optical transmittance of the glass article of the first aspect may be in a range from about 60% to about 82%. An optical transmittance of the glass article over the wavelength range from 450 nm to 650 nm for a thickness of 0.7 mm may be equal to or less than about +/- 5%.

In a third aspect, an anneal point of the glass of the first aspect or the second aspect may be greater than about 700°C.

In a fourth aspect, the anneal point of the third aspect may be in a range from about 710°C to about 810°C.

In a fifth aspect, a liquidus temperature of the glass of any one of the first aspect to the fourth aspect may be greater than about 1000°C.

In a sixth aspect, the liquidus temperature of the fifth aspect may be in a range from about 1000°C to about 1300°C.

In a seventh aspect, a coefficient of thermal expansion of the glass article of any one of the first aspect to the sixth aspect may be in a range from about $29 \times 10^{-7}$ to about $40 \times 10^{-7}$ over a temperature range of 0°C to 300°C.

In an eighth aspect, a density of the glass article of any one of the first aspect of the seventh aspect may be equal to or less than about 2.65 g/cc$^3$.

In a ninth aspect, the glass of any one of the first aspect to the eighth aspect may comprise $B_2O_3$ in an amount in a range from about 0.2 mol% to about 12 mol%.

In a tenth aspect, the glass of any one of the first aspect to the ninth aspect may comprise MgO in an amount in a range from about 0.9 mol% to about 8 mol%.

In an eleventh aspect, the glass of the first aspect may comprise:

| | |
|---|---|
| $SiO_2$ | 67 - 74; |
| $Al_2O_3$ | 10 - 14; |
| $B_2O_3$ | 0 - 3; |
| MgO | 3 - 8; |
| CaO | 3.9 - 8; |
| SrO | 0 - 2; and |
| BaO | 2 - 5. |

In a twelfth aspect, the glass of the eleventh aspect may comprise:

| | |
|---|---|
| $SiO_2$ | 68 - 74; |
| $B_2O_3$ | 0.2 - 2; |
| MgO | 3.5 - 8; |
| CaO | 3.9 - 6; |
| SrO | 1 - 1.6; and |
| BaO | 3-5. |

In a thirteenth aspect, the anneal point of the twelfth aspect may be greater than about 800°C.

In a fourteenth aspect, a coefficient of thermal expansion of the glass article of any one of the twelfth aspect to the thirteenth aspect may be in a range from about $34 \times 10^{-7}$ to about $40 \times 10^{-7}$ over a temperature range of 0°C to 300°C.

In a fifteenth aspect, a liquidus temperature of the glass of any one of the twelfth aspect of the fourteenth aspect may be greater than about 1100°C.

In a sixteenth aspect, the glass of the first aspect may comprise:

| | |
|---|---|
| $SiO_2$ | 64 - 71; |
| $Al_2O_3$ | 9 - 12; |
| $B_2O_3$ | 7 - 12; |
| MgO | 0.9 - 3; |
| CaO | 6 - 12; |
| SrO | 0 - 2; and |
| BaO | 0 - 1. |

In a seventeenth aspect, the glass of the sixteenth aspect may comprise:

| | |
|---|---|
| $SiO_2$ | 66 - 71; |
| MgO | 0.9 - 2; |
| CaO | 7 - 11.5; |
| SrO | 0.5 - 1.5; and |

(continued)

| | |
|---|---|
| BaO | 0 - 0.1. |

In an eighteenth aspect, the glass of the first aspect may comprise:

| | |
|---|---|
| $SiO_2$ | 61 - 69; |
| $Al_2O_3$ | 11 - 14; |
| $B_2O_3$ | 5 - 9; |
| MgO | 2 - 9; |
| CaO | 3 - 9; and |
| SrO | 1 - 5. |

In a nineteenth aspect, the glass of the eighteenth aspect may comprise:

| | |
|---|---|
| $SiO_2$ | 64 - 69; |
| $B_2O_3$ | 6 - 9; |
| MgO | 3 - 6; |
| CaO | 5 - 7; and |
| SrO | 3-5. |

In a twentieth aspect, the glass of the first aspect may comprise:

| | |
|---|---|
| $SiO_2$ | 66 - 71; |
| $Al_2O_3$ | 11 - 14; |
| $B_2O_3$ | 3 - 6; |
| MgO | 3 - 6; |
| CaO | 4 - 7; |
| SrO | 1 - 5; and |
| BaO | 0 - 2. |

In a twenty first aspect, a coefficient of thermal expansion of the glass article of the twentieth aspect may be in a range from about $33 \times 10^{-7}$ to about $40 \times 10^{-7}$ over a temperature range of 0°C to 300°C.
In a twenty second aspect, a liquidus temperature of the glass of any one of the twentieth aspect to the twenty first aspect may be greater than about 1100°C.
In a twenty third aspect, the glass of the twentieth aspect may comprise:

| | |
|---|---|
| $SiO_2$ | 66 - 69; |
| $Al_2O_3$ | 12 - 14; |
| $B_2O_3$ | 4 - 5; |
| MgO | 4 - 6; |
| CaO | 5 - 7; and |
| SrO | 1 - 4. |

In a twenty fourth aspect, the glass of any one of the first aspect to the twenty third aspect may comprise:

| | |
|---|---|
| NiO | 0.055 - 0.065; and |
| $Co_3O_4$ | 0.011 - 0.013. |

In a twenty fifth aspect, the glass of any one of the first aspect to the twenty third aspect may comprise:

| NiO | 0.077 - 0.128; and |
| Co$_3$O$_4$ | 0.025 - 0.037. |

In a twenty sixth aspect, a display device is disclosed, comprising a plurality of display substrates arranged on a base plate comprising the glass of any one of the first aspect to the twenty seventh aspect, each display substrate comprising a plurality of light emitters disposed thereon and configured to direct light through the base plate.

In a twenty seventh aspect, each display substrate may comprise a barrier layer comprising at least one of silica or silicon nitride deposited on the display substrate between the glass and the plurality of light emitters.

In a twenty eighth aspect, a display device is disclosed, comprising a display substrate comprising a plurality of light emitters disposed thereon, an optically clear adhesive layer disposed over the plurality of light emitters on the display substrate, and a glass cover plate disposed over the OCA layer, the glass cover plate comprising the glass of any one of of the first aspect to the twenty seventh aspect.

In a twenty ninth aspect, the display substrate may comprise the glass of any one of the first aspect to the twenty seventh aspect.

In a thirtieth aspect, the display substrate of the twenty ninth aspect may comprise a barrier layer comprising at least one of silica or silicon nitride deposited on the display substrate between the glass and the plurality of light emitters.

In a thirty first aspect, the display device of the thirtieth aspect may comprise a top emission display device and the plurality of light emitters are configured to direct light through the glass cover plate.

Additional embodiments of the disclosure are directed to an object comprising the glass produced by a downdraw sheet fabrication process. Further embodiments are directed to glass produced by the fusion process or variants thereof.

BRIEF DESCRIPTION OF THE DRAWINGS

The accompanying figures, which are incorporated in and constitute a part of this specification, illustrate several embodiments described below.

FIG. 1 is a top view of an exemplary bottom emission display device comprising a plurality of display tiles arranged in rows and columns;

FIG. 2 is a cross-section of a portion of the display device of FIG. 1;

FIG. 3 is a close-up cross-sectional view of a portion of the display device of FIG. 2;

FIG. 4 is a schematic view of a forming body used to make precision sheet in a fusion down draw process;

FIG. 5 is a cross-sectional view of the forming body of FIG. 4; and

FIG. 6 is a plot of percent transmittance for the exemplary glass compositions of Table 1 as measured with an optical power meter;

FIG. 7 is another top view of a top emission tiled display comprising a plurality of display tiles arranged in rows and columns;

FIG. 8 is a side cross-sectional view of the display of FIG. 7;

FIG. 9 is a top view of an individual display tile of FIG. 7 showing individual light emitters arranged on the display tile;

FIG. 10 is a cross-sectional view of a portion of the display of FIG. 7 showing several ways in which light may leak from edges of individual tiles of the display;

FIG. 11 is a cross sectional view of a portion of the display of FIG. 7 showing several additional ways light may leak from edges of individual tiles of the display;

FIG. 12 is a side cross-sectional view of a light emitter of the display tile of FIG. 9;

FIG. 13 is a top view of several light emitters of a display tile of FIG. 9 showing dimensional parameters;

FIG. 14 is a series of schematic views for the manufacture of ring FET devices subjected to experimentation as described herein;

FIG. 15 is a top view of a ring FET device shown in FIG. 14;

FIG. 16 is a plot of a typical transfer curve (drain current as a function of gate voltage) of the ring FET of FIGS. 14-15.

FIG. 17 is a chart showing FET device off-current (Min (Id)) extracted from transfer curves and plotted with different drain voltages (Vd); and

FIG. 18 is a plot of time-of-flight secondary ion mass spectrometry (TOF-SIMS) measurements used to determine the Ni$^+$ and Co$^+$ ions concentration depth profiles on Lotus NXT® glass with and without Ni and Co doping after the ring FET fabrication.

FIG. 19 is a top view of a central portion of a top emission display device subjected to experimentation as described herein showing "on" state light emitters compared to "off" state light emitters;

FIG. 20 is a plot showing the modeled normalized average illuminances of active and dark pixels as a function of cover glass transmission for the display of FIG. 19, wherein a refractive index of an OCA layer of the display was 1.49;

FIG. 21 is a plot showing the contrast of the display as a function of the cover glass transmission, wherein a refractive index of an OCA layer of the display was 1.49;

FIG. 22 is a plot showing contrast improvement of the display of FIG. 19 as a function of the cover glass transmission, wherein a refractive index of an OCA layer of the display was 1.49;

FIG. 23 is a plot showing the modeled normalized average illuminances of active and dark pixels as a function of cover glass transmission for the display of FIG. 19, wherein a refractive index of an OCA layer of the display was 1.40;

FIG. 24 is a plot showing the contrast of the display as a function of the cover glass transmission, wherein a refractive index of an OCA layer of the display was 1.40; and

FIG. 25 is a plot showing contrast improvement of the display of FIG. 19 as a function of the cover glass transmission, wherein a refractive index of an OCA layer of the display was 1.4;

FIG. 26 is a plot obtained from TOF-SIMS analysis of a simulated TFT device disposed on a glass substrate comprising an exemplary transition metal-doped glass described herein, the glass substrate having a barrier layer disposed between the glass substrate and the simulated TFT device, the data showing a lack of diffusion of the transition metal into the simulated TFT device during common deposition conditions;

FIG. 27 is another plot obtained from TOF-SIMS analysis of a simulated TFT device disposed on a glass substrate comprising an exemplary transition metal-doped glass described herein, the glass substrate having a barrier layer disposed between the glass substrate and the simulated TFT device, the data showing a lack of diffusion of the transition metal into the simulated TFT device during common deposition conditions; and

FIG. 28 is a plot obtained from TOF-SIMS analysis of a silicon wafer heated under common TFT deposition conditions in close proximity to glass substrate doped with transition metal dopants (e.g., Ni, Co) showing a virtual lack of, and subsequent contamination from, transition metal dopants evaporating from the glass substrate.

## DETAILED DESCRIPTION

Various disclosed embodiments may involve particular features, elements or steps that are described in connection with that particular embodiment. A particular feature, element, or step, although described in relation to one particular embodiment, may be interchanged or combined with alternate embodiments in various non-illustrated combinations or permutations.

As used herein the terms "the," "a," or "an," mean "at least one," and should not be limited to "only one" unless explicitly indicated to the contrary.

Ranges can be expressed herein as from "about" one particular value, and/or to "about" another particular value. When such a range is expressed, examples include from the one particular value and/or to the other particular value, for example within a measurement error of such value. Similarly, when values are expressed as approximations, by use of the antecedent "about," it will be understood that the particular value forms another aspect. It will be further understood that the endpoints of each of the ranges are significant both in relation to the other endpoint, and independently of the other endpoint.

The terms "substantial," "substantially," and variations thereof as used herein are intended to note that a described feature is equal or approximately equal to a value or description. Moreover, "substantially similar" is intended to denote that two values are equal or approximately equal. In some embodiments, "substantially" or variations thereof (e.g., substantially similar) may denote values within about 10% of each other, such as within about 5% of each other, within about 2% of each other, or within about 1% of each other.

Unless otherwise expressly stated, it is in no way intended that any method set forth herein be construed as requiring its steps be performed in a specific order. Accordingly, where a method claim does not actually recite an order to be followed by its steps or it is not otherwise specifically stated in the claims or descriptions that the steps are to be limited to a specific order, it is in no way intended any order be inferred.

While various features, elements, or steps of embodiments may be disclosed using the transitional phrase "comprising," alternative embodiments, including those that may be described using the transitional phrases "consisting of" or "consisting essentially of," are implied. Thus, for example, implied alternative embodiments to an apparatus that comprises A+B+C include embodiments where an apparatus consists of A+B+C and embodiments where an apparatus consists essentially of A+B+C.

As used herein, transitional phrases "comprising," "including," and "having" are to be considered open ended, unless otherwise explicitly stated.

For brevity, ranges of values disclosed herein, including compositional ranges or attribute (performance) ranges, or series of ranges, may be appended by the phrase "including all ranges and subranges therebetween," which is to be interpreted as including whole number or decimal subranges as though explicitly presented. Thus, by way of example, a range between 6 and 8 (units omitted) implicitly includes a subrange between 6.4 and 8, or a subrange between 6 and 7.2, or a subrange between 6 and 7, and so forth. Additionally, a series of ranges, such as "in a range from 6 to 11 or in a range from 6 to 8" implicitly includes a range from 7 to 10, or subranges therebetween, such as 7.2 to 10.4, as though explicitly presented, provided the range does not exceed the minimum or maximum endpoints of the explicitly presented range or series of ranges. Thus, for example, "in a range from 6 to 11 or in a range from 6 to 8" has as endpoints 6 and 11.

Unless otherwise indicated, all constituents of exemplary glass compositions disclosed herein are presented in mole percent (mol%) on an oxide basis unless otherwise explicitly stated.

As used herein, transmittance (or transmission) is defined as the ratio of the incident light falling on a body to that transmitted through the body. The transmittance of a body may be within a range between about 0 percent, where all incident light is blocked from passing through the body, to about 100 percent, where all incident light passes through the body.

As used herein, refractive index is defined as the ratio of the velocity of light in a vacuum to the velocity of light in a specified medium.

MicroLED is one of several next generation display technologies. MicroLED can provide high brightness, high contrast ratio, low power consumption, and high reliability, attributes that can meet or exceed the performance of competitive technologies, such as liquid crystal displays or organic light emitting diode displays.

Large area displays are highly desired by consumers and for public information systems. However, high cost and low production yields present technical challenges for mass production of such large area displays. This is particularly true for high resolution micro-Light Emitting Diode (microLED) displays, owing at least to the small size of the light emitters. One solution to the manufacture of large area displays is to tile multiple individual small displays on a base plate, thereby forming a tiled display device wherein the individual small displays constitute the tiles. These tiles may be arranged, for example, in rows and/or columns such that the size of the large area display is scalable based on the number of individual small displays. While the underlying substrates for microLED displays can be glass or polymer, glass provides high temperature compatibility and stable dimensions, making glass a preferred substrate material.

An ongoing issue for tiling applications is light leakage at edges of the tiles. That is, light emitted by light emitters disposed on a tile can be diverted through an edge of a tile and subsequently directed toward a viewer, such as by reflection within the display, for example from a backplane substrate on which the light emitters are mounted. Several methods have been proposed to mitigate light leakage, e.g., by applying a coating to the tile edges and/or lamination of low transmission films to the backplane substrate. However, both suffer drawbacks. For example, the ability to precisely deposit a coating, reliability, and durability, and particularly the mechanical and environmental durability of laminated films.

Another approach to suppress light leakage from gaps (seams) between the tiles of tiled display devices as disclosed herein is to reduce the brightness of the leaked light. This may be achieved by employing glass substrates exhibiting reduced transmittance. In other words, the glass can be intentionally doped with a material that "colors" the glass, thereby increasing the optical attenuation of the glass.

Another issue experienced by an emissive display is the degradation of contrast ratio. The encapsulation layers (such as plate and optical adhesive layer) in an emissive display tend to form a lightguide that confines and channels light. Thus, light from one pixel emitter may leak to neighboring pixels through the lightguide, which results in a display contrast reduction that can manifest as a "halo" effect to the viewer. This issue may also be solved by employing glass substrates exhibiting reduced transmittance.

Glass compositions disclosed herein are generally alkali (alkali metal) free. However, the glasses may contain some alkali metal as contaminants. In the case of display applications, it is desirable to keep alkali metal levels below 0.1 mole percent (mol%) to avoid a negative impact on thin film transistor (TFT) performance through diffusion of alkali ions from the glass into the silicon of the TFT. As used herein, an "alkali-free glass" is a glass having a total alkali metal concentration less than or equal to 0.1 mole percent, where the total alkali metal concentration is the sum of the $Na_2O$, $K_2O$, and $Li_2O$ concentrations.

Glasses disclosed herein also relate to a semiconductor assembly that includes a semiconductor disposed on a glass substrate, wherein said glass substrate comprises an alkali-free glass of the present disclosure. Examples of semiconductors that can be used in the aforementioned semiconductor assemblies include transistors, diodes, silicon transistors, silicon diodes, and other silicon semiconductors; field effect transistors (FETs), thin-film transistors (TFTs), organic light-emitting diodes (OLEDs) and other light-emitting diodes; as well as semiconductors that are useful in electro-optic (EO) applications, in two photon mixing applications, in non-linear optical (NLO) applications, in electroluminescent applications, and in photovoltaic and sensor applications. Such semiconductor assemblies may comprise a subassembly of a larger assembly. For example, in embodiments, such semiconductor assemblies may comprise a display assembly, for example a display tile assembly, which may itself form part of a larger display apparatus, e.g., flat panel display devices that include a flat, transparent glass substrate carrying polycrystalline silicon thin film transistors, wherein said glass substrate comprises an alkali-free glass of the present disclosure.

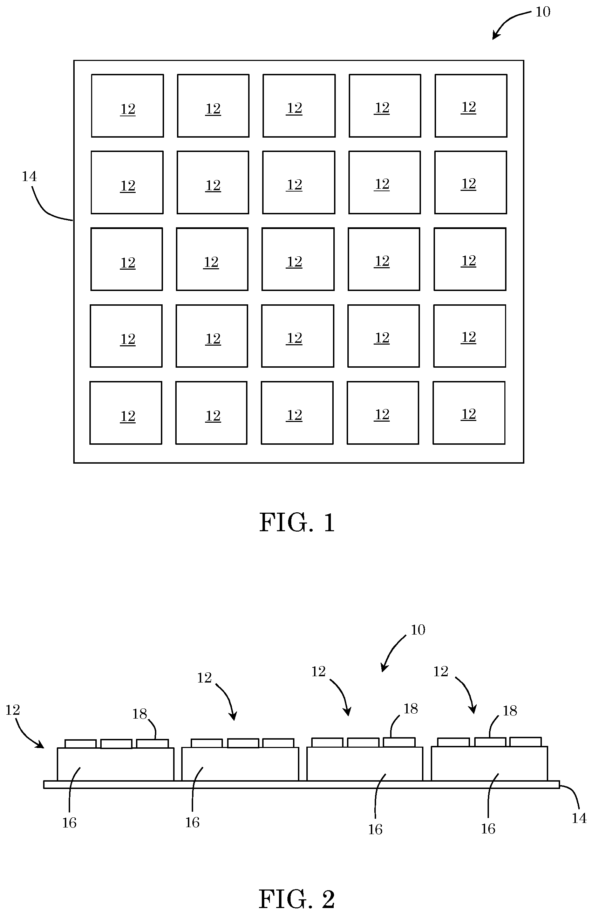

FIGS. 1-3 are several views of an exemplary display device 10 (e.g., large area display) comprising a plurality of display tiles 12 (small format displays) disposed on a base plate 14. FIG. 1 is a top view of display device 10 showing the plurality of display tiles arranged in rows and columns on base plate 14. Referring to FIGS. 2-3, each display tile 12 comprises a transparent substrate 16 including a plurality of light emitters 18 disposed thereon. Transparent substrate 16 may comprise glass, for example, or may comprise another electrically nonconducting material, such as a polymer material. Light emitters 18 may be light emitting diodes (LEDs). For example, light emitters 18 may be microLEDs, wherein each microLED may comprise a light emitting area with a dimension (length and/or width) in a range from about 1 micrometer ($\mu$m) to about 100 micrometers, although other dimensions, for example in excess of 100 $\mu$m, are contemplated. Light emitters 18 may be bottom emission light emitters, wherein light is emitted primarily from bottom surfaces of the light emitter through substrate 16.

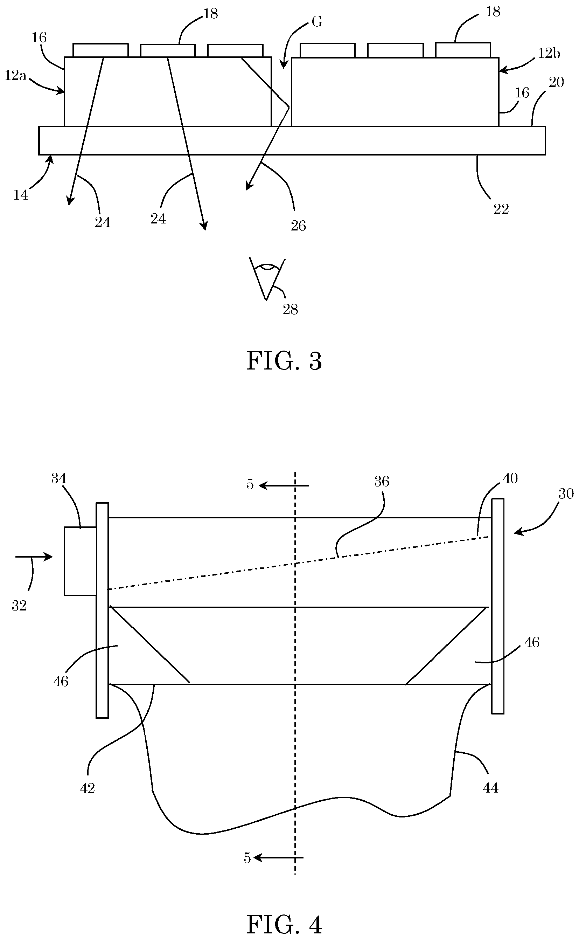

As best seen in FIG. 3 depicting a close-up view of a portion of display device 10, base plate 14 comprises a glass substrate including a first major surface 20 and a second major surface 22 opposite first major surface 20. Second major surface 22 may be parallel, or substantially parallel to first major surface 20. Two display tiles, first display tile 12a and second display tile 12b are shown disposed on first major surface 20, although more than two tiles may be disposed on first major surface 20. A gap (seam) G separates first display tile 12a from second display tile 12b. As further shown, light emitted from light emitters 18 is directed through base plate 14. While a first portion 24 of the light travels directly through base plate 14, a second portion 26 of the light emitted by light emitters 18 may be directed into gap G, at least a portion of which may be directed outward from the display device 10 through base plate 14 and be visible to viewer 28 as a bright line. To mitigate light observed at the gap, base plate 14 may be formed of a glass exhibiting an optical attenuation (e.g., percent transmittance) that reduces the brightness of light traversing the base plate.

Glasses suitable for use as base plate 14 as described herein include alkali-free glasses that possess high anneal points (temperatures) and high Young's moduli, allowing the glasses to possess excellent dimensional stability (e.g., low compaction), thereby reducing variability during the post-glass manufacture processes. For example, in embodiments, the substantially alkali-free glasses can have anneal points greater than about 700°C.

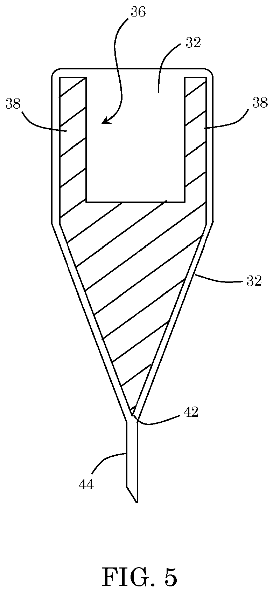

In embodiments, exemplary glasses may be manufactured into glass sheets via a fusion down draw process. The fusion down draw process can produce a pristine, fire-polished glass surface that reduces surface-mediated distortion to high resolution TFT backplanes and color filters. FIG. 4 is a schematic drawing of a fusion forming body 30 in a non-limiting fusion down draw process, while FIG. 5 is a cross-sectional view of the forming body along line 5-5. Molten glass 32 is introduced through inlet 34, flows along the bottom of trough 36 formed by weirs 38 to the opposing end of trough 36. Molten glass overflows weirs 38 on both sides of forming body 30 (see FIG. 5), and the two streams of molten glass join or fuse at a bottom edge (root) 42 of the forming body where converging forming surfaces of the forming body meet and form a ribbon of glass 44. Edge directors 46 at the opposing ends of forming body 30 minimize lateral contraction of glass ribbon 44 and create a thicker strip along the edges of the glass ribbon called a bead. The bead is engaged by and pulled down by counterrotating pulling rolls (not shown), hence enabling glass ribbon formation at high viscosity. By adjusting the rate at which glass ribbon 44 is pulled from forming body 30, it is possible to use the fusion down draw process to produce a very wide range of glass ribbon thicknesses. Once formed, glass ribbon 44 can be cut to a desired sheet size.

A fusion down draw process that can be used to form glasses disclosed herein is described in U.S. Pat. Nos. 3,338,696 and 3,682,609. The fusion down draw process can produce glass substrates that do not require polishing. Current glass substrate polishing can produce glass substrates having an average surface roughness (Ra) greater than about 0.5 nanometers (nm), as measured by atomic force microscopy. Glass substrates produced by the fusion down draw process can have an average surface roughness measured by atomic force microscopy of less than about 0.5 nm. Glass substrates produced by the fusion down draw process may also have an average internal stress as measured by optical retardation that is less than or equal to about 150 psi ($1.03 \times 10^6$ Pascal). Of course, claims appended herewith should not be limited to fusion down draw processes as embodiments described herein are equally applicable to other forming processes such as, but not limited to, float forming processes, slot draw processes, rolling processes, and other sheet-forming processes known to those skilled in the art.

Relative to these alternative methods for creating sheets of glass, a fusion down draw process, such as the one discussed above, can produce very thin, very flat, very uniform glass sheets with a pristine surface. Slot draw processes also can result in a pristine surface, but due to changes in orifice shape over time, accumulation of volatile debris at the orifice-glass interface, and the challenge of creating an orifice to deliver truly flat glass, the dimensional uniformity and surface quality of slot-drawn glass are generally inferior to fusion-drawn glass. The float process can produce very large, uniform sheets, but the surface may be substantially compromised by contact with the float bath on one side, and by exposure to condensation products from the float bath on the other side. This means float glass may require polishing for use in high performance display applications.

The fusion down draw process may involve rapid cooling of the glass from high temperature, resulting in a high fictive temperature $T_f$. The fictive temperature can be thought of as representing the discrepancy between the structural state of the glass and the state it would assume if fully relaxed at the temperature of interest. Reheating a glass with a glass transition temperature $T_g$ to a process temperature $T_p$ such that $T_p < T_g \leq T_f$ may be affected by the viscosity of the glass. Since $T_p$ is less than $T_f$, the structural state of the glass is out of equilibrium at $T_p$, and the glass will spontaneously relax toward a structural state that is in equilibrium at $T_p$. The rate of this relaxation scales inversely with the effective viscosity of the glass at $T_p$, such that high viscosity results in a slow rate of relaxation, and a low viscosity results in a fast rate of relaxation. The effective viscosity varies inversely with the fictive temperature of the glass, such that a low fictive temperature results in a high viscosity, and a high fictive temperature results in a comparatively low viscosity. Therefore, the rate of relaxation at $T_p$ scales directly with the fictive temperature of the glass. A process that introduces a high fictive temperature produces a comparatively high rate of relaxation when the glass is reheated at $T_p$.

One means to reduce the rate of relaxation at $T_p$ is to increase the viscosity of the glass at that temperature. As temperature decreases below the anneal point, the viscosity of the melt increases. At a fixed temperature below $T_g$, a glass with a higher anneal point has a higher viscosity than a glass with a lower anneal point. Therefore, increasing the anneal point may increase the viscosity of a substrate glass at $T_p$. Generally, the compositional changes necessary to increase the anneal point also increase viscosity at all other temperatures. In a non-limiting embodiment, the fictive temperature of a glass made by the fusion process corresponds to a viscosity of about $10^{11}$ to about $10^{12}$ poise (here and in the following, 1 poise = 0.1 Pa s), so an increase in anneal point for a fusion-compatible glass generally increases its fictive temperature as well. For a given glass, regardless of the forming process, higher fictive temperature results in lower viscosity at temperatures below $T_g$. Thus, increasing fictive temperature works against the viscosity increase that would otherwise be obtained by increasing the anneal point. To have a substantial change in the rate of relaxation at $T_p$, it is generally necessary to make relatively large changes in the anneal point. An aspect of exemplary glasses disclosed herein is that they may have an anneal point equal to or greater than about 700°C. It is believed that such anneal points may result in acceptably low rates of thermal relaxation during low-temperature processing, e.g., typical low-temperature polysilicon rapid thermal anneal cycles.

In addition to its impact on fictive temperature, increasing the anneal point also increases temperatures throughout the melting and forming system, particularly the temperatures on the forming body. For example, Eagle XG® glass and Lotus™ glass (Corning Incorporated, Corning, NY) have anneal points that differ by about 50°C, and the temperature at which they are delivered to the forming body may also differ by about 50°C. When held for extended periods of time above about 1310°C, a zircon refractory forming the forming body can show thermal creep, which can be accelerated by the weight of the forming body itself plus the weight of the glass on the forming body. A second aspect of exemplary glasses disclosed herein is that their delivery temperatures may be less than or equal to about 1350°C, less than or equal to about 1345°C, less than or equal to about 1340°C, less than or equal to about 1335°C, less than or equal to about 1330°C, less than or equal to about 1325°C, less than or equal to about 1320°C, less than or equal to about 1315°C, or less than or equal to about 1310°C. Such delivery temperatures may permit extended manufacturing campaigns without a need to replace the forming body or extend the time between forming body replacements.

In manufacturing trials of glasses with high anneal points and delivery temperatures below 1310°C, the glass may show a greater tendency toward devitrification on the root (bottom edge) of the forming body and especially the edge directors used to guide the glass over the forming body relative to glasses with lower anneal points. Careful measurement of the temperature profile on the forming body showed edge director temperatures were much lower relative to the center temperature along the bottom edge (root) of the forming body than had been anticipated and is believed to be due to radiative heat loss. The edge directors are maintained at a temperature below the center temperature at the root of the forming body to ensure the glass is viscous enough as it leaves the root to put the ribbon between the edge directors under tension, thus maintaining a flat shape to the ribbon. As edge directors are located at opposing ends of the forming body, the edge directors are difficult to heat, and thus the temperature difference between the center of the root and the edge directors may differ by 50°C or more.

It is believed the increased tendency toward devitrification in the fusion down draw process can be understood in terms of the radiative heat loss of glass as a function of temperature. Fusion is substantially an isothermal process, so glass enters the inlet to the forming body at a particular viscosity and exits the root at a much higher viscosity, but the actual values for the viscosity are not strongly dependent on the identity of the glass or the temperature of the process. Thus, a glass with a higher anneal point generally requires much higher forming body temperatures than a glass with a lower anneal point just to match the delivery and exit viscosities.

It is also believed that since radiative heat loss increases with temperature, and since high anneal point glasses generally are formed at higher temperatures than lower anneal point glasses, the temperature difference between the center root and the edge directors generally increases with the anneal point of the glass. This may have a direct relationship to the tendency of a glass to form devitrification products on the forming body or edge directors.

The liquidus temperature of a glass is defined as the highest temperature at which a crystalline phase would appear if a glass were held indefinitely at that temperature. The liquidus viscosity is the viscosity of a glass at the liquidus temperature. To avoid devitrification on a forming body, it may be helpful for the liquidus viscosity to be high enough to ensure glass is no longer on the forming body refractory or edge director material at or near the liquidus temperature.

In practice, few alkali-free glasses have liquidus viscosities of the desired magnitude. Experience with display substrate glasses (e.g., Corning® Eagle XG® glass) has shown that edge directors can be held continuously at temperatures up to 60°C below the liquidus temperature of certain alkali-free glasses. While it was understood that glasses with higher anneal points would require higher forming temperatures, it was not anticipated that the edge directors would be so much cooler relative to the center root temperature. A useful metric for keeping track of this effect is the difference between the delivery temperature of the molten glass to the forming body and the liquidus temperature of the glass, $T_{liq}$. In a fusion down draw process, it is generally desirable to deliver molten glass at about 35,000 poise. The temperature at which the glass assumes a viscosity of 35,000 poise is designated as $T_{35kP}$. For a particular delivery temperature, it may be useful to make $T_{35kP}$ - $T_{liq}$ as large as possible, but for a display substrate such as Corning® Eagle XG® glass, extended manufacturing campaigns can be conducted if $T_{35kP}$ - $T_{liq}$ is about 80°C or more. As temperature increases, $T_{35kP}$ - $T_{liq}$ must increase as well, such that for $T_{35kP}$ near 1300°C, it may be helpful to have $T_{35kP}$ - $T_{liq}$ equal to or greater than about 100°C. The minimum useful value for $T_{35kP}$ - $T_{liq}$ varies approximately linearly with temperature from about 1200°C to about 1320°C and can be expressed according to equation (1).

$$\text{Minimum } T_{35kP} - T_{liq} = 0.25T_{35kP} - 225, \tag{1}$$

where all temperatures are in °C. Thus, one or more exemplary glasses disclosed herein may have $T_{35kP}$ - $T_{liq}$ > $0.25T_{35kP}$-225°C.

In addition, the forming process may require glass with a high liquidus viscosity to avoid devitrification products at interfaces with the glass and to minimize visible devitrification products in the final glass. Thus, for a given glass compatible with fusion for a particular ribbon size and thickness, adjusting the process to manufacture wider ribbon or thicker ribbon generally results in lower temperatures at opposing ends of the forming body. Some embodiments have higher liquidus viscosities to provide greater flexibility for manufacturing via the fusion process.

In tests of the relationship between liquidus viscosity and subsequent devitrification tendencies in the fusion process, high delivery temperatures, such as those of exemplary glasses, generally require higher liquidus viscosities for long-term production than would be the case for typical display substrate compositions with lower anneal points. It is believed this arises from accelerated rates of crystal growth as temperature increases. Fusion is essentially an isoviscous process, so a more viscous glass at some fixed temperature may be formed by fusion at higher temperature than a less viscous glass. While some degree of undercooling (cooling below the liquidus temperature) can be sustained for extended periods in a glass at lower temperature, crystal growth rates increase with temperature, and thus more viscous glasses may grow an equivalent, unacceptable amount of devitrification products in a shorter time than less viscous glasses. Depending on where formed, devitrification products can compromise forming stability and introduce visible defects into the final glass.

To be formed by the fusion down draw process, one or more embodiments of the glass compositions may have a liquidus viscosity equal to or greater than about 100,000 poise, equal to or greater than about 120,000 poise, equal to or greater than about 140,000 poise, equal to or greater than about 175,000 poise, or equal to or greater than about 200,000 poise, including all ranges and subranges therebetween. Throughout the range of exemplary glasses, it is possible to obtain a liquidus temperature low enough, and a viscosity high enough, that the liquidus viscosity of the glass is unusually high compared to other compositions.

In addition to the glass formers ($SiO_2$, $Al_2O_3$, and $B_2O_3$), glasses described herein may also include alkaline earth oxides. For example, one or more of at least three alkaline earth oxides may be part of the glass composition, e.g., MgO, CaO, and BaO, and, optionally a fourth, SrO. The alkaline earth oxides provide the glass with various properties important to melting, fining, forming, and ultimate use. Accordingly, to improve glass performance in these regards, the (MgO+CaO+SrO+BaO)/$Al_2O_3$ ratio may be equal to or greater than about 1 (one). As this ratio increases, viscosity tends to increase more strongly than liquidus temperature, and thus it is increasingly difficult to obtain suitably high values for $T_{35kP}$ - $T_{liq}$. Thus, in aspects, the ratio (MgO+CaO+SrO+BaO)/$Al_2O_3$ may be less than or equal to about 2. In some embodiments, the (MgO+CaO+SrO+BaO)/$Al_2O_3$ ratio may be in a range from about 1 to about 1.8, in a range from about 1 to about 1.6, in a range from about 1 to about 1.4, in a range from about 1 to about 1.2, in a range from about 1 to about 1.16, or in a range from about 1.1 to about 1.6. For example, the (MgO+CaO+SrO+BaO)/$Al_2O_3$ ratio may be less than about 1.7, less than about 1.6, or less than about 1.5.

For certain embodiments, the alkaline earth oxides may be treated as what is, in effect, a single compositional component. This is because their impact on viscoelastic properties, liquidus temperatures, and liquidus phase relationships are qualitatively more similar to one another than they are to the glass forming oxides $SiO_2$, $Al_2O_3$, and $B_2O_3$. However, the alkaline earth oxides CaO, SrO, and BaO can form feldspar minerals, notably anorthite ($CaAl_2Si_2O_8$) and celsian ($BaAl_2Si_2O_8$), and strontium-bearing solid solutions of the same, but MgO does not participate in these crystals to a significant degree. Therefore, when a feldspar crystal is already in the liquidus phase, a superaddition of MgO may serve to stabilize the liquid relative to the crystal and thus lower the liquidus temperature. At the same time, the viscosity curve typically becomes steeper, reducing melting temperatures while having little or no impact on low-temperature viscosities.

The addition of small amounts of MgO may benefit melting and forming by reducing melting temperatures by reducing liquidus temperatures and increasing liquidus viscosity, while preserving a high annealing point and, thus, low compaction.

For glasses with suitably high values of $T_{35kP}$ - $T_{liq}$, the ratio of MgO to the other alkaline earths, MgO/(MgO+CaO+SrO+BaO), may fall within a relatively narrow range. As noted above, an addition of MgO can destabilize feldspar minerals, and thus stabilize the liquid and lower liquidus temperature. However, once MgO reaches a certain level, mullite, $Al_6Si_2O_{13}$, may be stabilized, thus increasing the liquidus temperature and reducing the liquidus viscosity. Moreover, higher concentrations of MgO tend to decrease the viscosity of the liquid, and thus even if the liquidus viscosity remains unchanged by addition of MgO, it will eventually be the case that the liquidus viscosity will decrease. Thus, in embodiments, $0.10 \leq$ MgO/(MgO+CaO+SrO+BaO) $\leq 0.40$ or in other embodiments, $0.2 \leq$ MgO/(MgO+CaO+SrO+BaO) $\leq 0.4$. Within these ranges, MgO may be varied relative to the glass formers and the other alkaline earth oxides to maximize the value of $T_{35kP}$ - $T_{liq}$ consistent with obtaining other desired properties.

It is believed that calcium oxide present in the glass compositions can produce low liquidus temperatures (high liquidus viscosities), high anneal points and Young's moduli, and CTE's in the most desired ranges for flat panel display applications. It also contributes favorably to chemical durability, and compared to other alkaline earth oxides, calcium oxide is relatively inexpensive as a batch material. However, at high concentrations, CaO increases density and CTE. Furthermore, at sufficiently low $SiO_2$ concentrations, CaO may stabilize anorthite, thus decreasing liquidus viscosity.

SrO and BaO can both contribute to low liquidus temperatures (high liquidus viscosities). Thus, glasses described herein may contain one or both oxides. However, the concentration of these oxides may be selected to avoid an increase in CTE and density and a decrease in Young's modulus and anneal point. The relative proportions of SrO and BaO can be balanced to obtain a suitable combination of physical properties and liquidus viscosity such that the glass can be formed by a down draw process.

To summarize the effects and roles of the central components of glasses of the disclosure, $SiO_2$ is the basic glass former. $Al_2O_3$ and $B_2O_3$ are also glass formers and can be selected as a pair with, for example, an increase in $B_2O_3$ and a corresponding decrease in $Al_2O_3$ used to obtain a lower density and CTE, while an increase in $Al_2O_3$ and a corresponding decrease in $B_2O_3$ can be used to increase anneal point, Young's modulus, and durability, provided the increase in $Al_2O_3$ does not reduce the RO/$AL_2O_3$ ratio much below about 1, where RO = (MgO+CaO+SrO+BaO). If the ratio goes too low, meltability is compromised, i.e., the melting temperature becomes too high. For example, it may be difficult to remove gaseous inclusions from the glass due to late stage melting of the silica raw material. $B_2O_3$ can be used to bring the melting temperature down, but high levels of $B_2O_3$ may compromise the anneal point.

Furthermore, when (MgO+CaO+SrO+BaO)/$Al_2O_3$ is less than or equal to about 1.05, mullite, an aluminosilicate crystal, can appear as a liquidus phase. Once mullite is present as a liquidus phase, the composition sensitivity of liquidus increases considerably, and mullite devitrification products both grow very quickly and may be very difficult to remove once established.

The $Al_2O_3$ and $B_2O_3$ concentrations can be selected as a pair to increase the anneal point, increase Young's modulus, improve durability, reduce density, and reduce the coefficient of thermal expansion (CTE), while maintaining the melting and forming properties of the glass. For example, an increase in $B_2O_3$ and a corresponding decrease in $Al_2O_3$ can be helpful in obtaining a lower density and CTE, while an increase in $Al_2O_3$ and a corresponding decrease in $B_2O_3$ can be helpful in increasing the anneal point, Young's modulus, and durability, provided the increase in $Al_2O_3$ does not reduce the (MgO+CaO+SrO+BaO)/$Al_2O_3$ ratio much below about 1.

In addition to meltability and anneal point considerations, for display applications, the CTE of the glass may be selected to be compatible with the CTE of silicon. To achieve such CTE values, the RO content of glasses disclosed herein can be controlled. For a given $Al_2O_3$ content, controlling the RO content corresponds to controlling the RO/$Al_2O_3$ ratio. In practice, glasses having suitable CTE's are produced if the RO/$Al_2O_3$ ratio is below about 1.6.

On top of these considerations, one or more glasses disclosed herein are formable by a down draw process, e.g., a fusion process, which means the liquidus viscosity of the glass should be relatively high. Individual alkaline earths play an important role in this regard since they can destabilize the crystalline phases that would otherwise form. BaO and SrO are particularly effective in controlling liquidus viscosity and may be included in exemplary glasses for at least this purpose. Various combinations of alkaline earths may be used to produce glasses having high liquidus viscosities, with the total of the alkaline earths satisfying the RO/$Al_2O_3$ ratio constraints needed to achieve low melting temperatures, high annealing points, and suitable CTE's.

In addition to the above components, glass compositions described herein may include various other oxides to adjust various physical, melting, fining, and forming attributes of the glasses. Examples of such other oxides may include, but are not limited to, $TiO_2$, $MnO$, $Fe_2O_3$, $ZnO$, $Nb_2O_5$, $MoO_3$, $Ta_2O_5$, $WO_3$, $Y_2O_3$, $La_2O_3$, and $CeO_2$. In embodiments, the amount of any of these oxides can be less than or equal to 2.0 mole percent, and their total combined concentration can be less than or equal to 5.0 mole percent.

Glass compositions described herein can also include various contaminants associated with batch materials and/or introduced into the glass by the melting, fining, and/or forming equipment used to produce the glass, particularly $Fe_2O_2$ and $ZrO_2$. The glasses can also contain $SnO_2$ either as a result of Joule melting using tin oxide electrodes and/or through the batching of tin containing materials, e.g., $SnO_2$, $SnO$, $SnCO_3$, $SnC_2O_2$, etc.

To mitigate light leakage at edges of the display tiles, glasses disclosed herein may comprise transition metal components intentionally added to increase the transmission loss (decrease the optical transmittance) of the glass. For example, the glass may comprise nickel or cobalt in amounts sufficient to obtain reduced transmittance.

Taking the foregoing into account, various glass compositions are described in the disclosure. In these glass compositions, $SiO_2$ serves as the basic glass former. In embodiments, the concentration of $SiO_2$ can be greater than about 60 mole percent to provide the glass with a density and chemical durability suitable for a flat panel display glass substrate, and a liquidus temperature (liquidus viscosity) that allows the glass to be formed by a down draw process (e.g., a fusion down draw process). In terms of an upper limit, in general, the $SiO_2$ concentration can be equal to or less than about 80 mol% to allow batch materials to be melted using conventional high volume melting techniques, e.g., Joule melting in a refractory melting vessel. As the concentration of $SiO_2$ increases, the 200-poise temperature $T_{200P}$ (melting temperature) generally rises. In various applications, the $SiO_2$ concentration may be adjusted so the glass composition has a melting temperature less than or equal to about 1,750°C.

Accordingly, one or more embodiments of the present disclosure may be directed to glass comprising, on an oxide basis, $SiO_2$ in a range from about 60 mol% to about 80 mol%, in a range from about 60 mol% to about 78 mol%, in a range from about 60 mol% to about 76 mol%, in a range from about 60 mol% to about 72 mol%, in a range from about 60 mol% to about 70 mol%, in a range from about 60 mol% to about 68 mol%, in a range from about 60 mol% to about 66 mol%, in a range from about 60 mol% to about 64 mol%, or in a range from about 60 mol% to about 62 mol%, including all ranges and subranges therebetween.

In particular embodiments, the glass may comprise $SiO_2$ in an amount in a range from about 61 mol% to about 80 mol%, for example in a range from about 62 mol% to about 80 mol%, in a range from about 63 mol% to about 80 mol%, in a range from about 64 mol% to about 80 mol%, in a range from about 65 mol% to about 80 mol%, in a range from about 66 mol% to about 80 mol%, in a range from about 67 mol% to about 80 mol%, in a range from about 68 mol% to about 80 mol%, in a range from about 69 mol% to about 80 mol%, in a range from about 70 mol% to about 80 mol%, in a range from about 71 mol% to about 80 mol%, in a range from about 72 mol% to about 80 mol%, in a range from about 73 mol% to about 80 mol%, in a range from about 74 mol% to about 80 mol%, in a range from about 75 mol% to about 80 mol%, in a range from about 76 mol% to about 80 mol%, in a range from about 77 mol% to about 80 mol%, or in a range from about 78 mol% to about 80 mol%, including all ranges and subranges therebetween.

In still further embodiments, the exemplary glass may comprise $SiO_2$ in a range from about 61 mol% to about 73 mol%, for example in a range from about 61 mol% to about 72 mol%, in a range from about 61 mol% to about 71 mol%, in a range from about 61 mol% to about 70 mol%, in a range from about 61 mol% to about 69 mol%, in a range from about 61 mol% to about 68 mol%, in a range from about 61 mol% to about 67 mol%, in a range from about 61 mol% to about 66 mol%, in a range from about 61 mol% to about 65 mol%, in a range from about 61 mol% to about 64 mol%, in a range from about 61 mol% to about 63 mol%, or in a range from about 61 mol% to about 62 mol%, including all ranges and subranges therebetween.

$Al_2O_3$ is another glass former used to make glasses described herein. An $Al_2O_3$ concentration equal to or greater than about 9 mole percent provides the glass with a low liquidus temperature and high viscosity, resulting in a high liquidus viscosity. The use of at least 9 mole percent $Al_2O_3$ also improves the glass's anneal point and Young's modulus. To obtain a ratio $(MgO+CaO+SrO+BaO)/Al_2O_3$ greater than or equal to about 1, the $Al_2O_3$ concentration may be less than about 15 mol%. For example, the glass may comprise $Al_2O_3$ in an amount equal to or greater than about 9 mol%, for example in a range from about 9 mol% to about 14 mol%, in a range from about 10 mol% to about 14 mol%, in a range from about 11 mol% to about 14 mol%, in a range from about 12 mol% to about 14 mol%, or in a range from about 13 mol% to about 14 mol%, including all ranges and subranges therebetween. In further embodiments, the glass may comprise $Al_2O_3$ in an amount in a range from about 9 mol% to about 13 mol%, in a range from about 9 mol% to about 12 mol%, in a range from about 9 mol% to about 11 mol%, or in a range from about 9 mol% to about 10 mol%, including all ranges and subranges therebetween.

$B_2O_3$ is both a glass former and a flux that aids melting and lowers melting temperature. $B_2O_3$ has an impact on both liquidus temperature and viscosity. Increasing $B_2O_3$ can be used to increase the liquidus viscosity of a glass. To achieve these effects, glass compositions disclosed herein may have $B_2O_3$ concentrations equal to or greater than 0 mole percent. As discussed above, glass durability is important for LCD applications. Durability can be controlled somewhat by elevated concentrations of alkaline earth oxides, and significantly reduced by elevated $B_2O_3$ content. Anneal point decreases as $B_2O_3$ increases, so it may be helpful to keep $B_2O_3$ content low relative to its typical concentration in amorphous silicon display substrates. Accordingly, the glass may include $B_2O_3$ in an amount equal to or less than about 12 mol%, for example in a range from about 0 mol% to about 12 mol%, such as in a range from about 0.1 mol% to about 12 mol%, in a range from about 0.5 mol% to about 12 mol%, in a range from about 1 mol% to about 12 mol%, in a range from about 2 mol% to about 12 mol%, in a range from about 3 mol% to about 12 mol%, in a range from about 4 mol% to about 12 mol%, in a range from about 5 mol% to about 12 mol%, in a range from about 6 mol% to about 12 mol%, in a range from about 7 mol% to about 12 mol%, in a range from about 8 mol% to about 12 mol%, in a range from about 9 mol% to about 12 mol%, in a range from about 10 mol% to about 12 mol%, or in a range from about 11 mol% to about 12 mol%, including all ranges and subranges therebetween.

In further embodiments, the glass may comprise $B_2O_3$ in an amount in a range from about 0 mol% to about 11 mol%, in a range from about 0.1 mol% to about 10 mol%, in a range from about 0.1 mol% to about 9 mol%, in a range from about 0.1 mol% to about 8 mol%, in a range from about 0.1 mol% to about 7 mol%, in a range from about 0.1 mol% to about 6 mol%, in a range from about 0.1 to about 5 mol%, in a range from about 0.1 mol% to about 4 mol%, in a range from about 0.1 mol% to about 3 mol%, in a range from about 0.1 mol% to about 2 mol%, in a range from about 0.1 mol% to about 1 mol%, or in a range from about 0.1 mol% to about 0.5 mol%, including all ranges and subranges therebetween.

The glass may further comprise MgO in an amount equal to or less than about 9 mol%, for example in a range from about 0 mol% to about 9 mol%, such as in a range from about 0.5 mol% to about 9 mol%, in a range from about 1 mol% to about 9 mol%, such as in a range from about 2 mol% to about 9 mol%, in a range from about 3 mol% to about 9 mol%, in a range from about 4 mol% to about 9 mol%, in a range from about 5 mol% to about 9 mol%, in a range from about 6 mol% to about 9 mol%, or in a range from about 7 mol% to about 9 mol%, including all ranges and subranges therebetween.

In further embodiments, the glass may comprise MgO in an amount in a range from about 0 mol% to about 8 mol%, in a range from about 0.5 mol% to about 7 mol%, in a range from about 0.5 mol% to about 6 mol%, in a range from about 0.5 mol% to about 5 mol%, in a range from about 0.5 mol% to about 4 mol%, in a range from about 0.5 mol% to about 3 mol%, in a range from about 0.5 mol% to about 2 mol%, or in a range from about 0.5 mol% to about 1 mol%, including all ranges and subranges therebetween.

The glass may further comprise CaO in a range from about 3 mol% to about 12 mol%, for example in a range from about 3 mol% to about 11 mol%, in a range from about 3 mol% to about 10 mol%, in a range from about 3 mol% to about 9 mol%, in a range from about 3 mol% to about 8 mol%, in a range from about 3 mol% to about 7 mol%, in a range from about 3 mol% to about 6 mol%, in a range from about 3 mol% to about 5 mol%, or in a range from about 3 mol% to about 4 mol%.

In further embodiments, the glass may comprise CaO in an amount in a range from about 4 mol% to about 12 mol%, in a range from about 5 mol% to about 12 mol%, in a range from about 6 mol% to about 12 mol%, in a range from about 7 mol% to about 12 mol%, in a range from about 8 mol% to about 12 mol%, in a range from about 9 mol% to about 12 mol%, in a range from about 10 mol% to about 12 mol%, or in a range from about 11 mol% to about 12 mol%, including all ranges and subranges therebetween.

The glass may further comprise SrO in an amount equal to or less than about 5 mol%, for example in a range from about 0 mol% to about 5 mol%, such as in a range from about 0 mol% to about 4 mol%, in a range from about 0 mol% to about 3 mol%, in a range from about 0 mol% to about 2 mol%, or in a range from about 0 mol% to about 1 mol%.

In further embodiments, the glass may comprise SrO in an amount in a range from about 0.05 mol% to about 5 mol%, in a range from about 0.1 mol% to about 5 mol%, in a range from about 0.2 mol% to about 5 mol%, in a range from about 0.5 mol% to about 5 mol%, in a range from about 1 mol% to about 5 mol%, in a range from about 2 mol% to about 5 mol%, in a range from about 3 mol% to about 5 mol%, or in a range from about 4 mol% to about 5 mol%, including all ranges and subranges therebetween.

The glass may further comprise BaO in an amount equal to or less than about 5 mol%, for example in a range from about 0 mol% to about 5 mol%, such as in a range from about 0 mol% to about 4 mol%, in a range from about 0 mol% to about 3 mol%, in a range from about 0 mol% to about 2 mol%, or in a range from about 0 mol% to about 1 mol%, including all ranges and subranges therebetween.

In further embodiments, the glass may comprise BaO in an amount in a range from about 0.1 mol% to about 5 mol%, in a range from about 0.2 mol% to about 5 mol%, in a range from about 0.5 mol% to about 5 mol%, in a range from about 1 mol% to about 5 mol%, in a range from about 2 mol% to about 5 mol%, in a range from about 3 mol% to about 5 mol%, or in a range from about 4 mol% to about 5 mol%, including all ranges and subranges therebetween.

The glass may include RO (i.e., MgO, CaO, SrO, and/or BaO) such that $(MgO+CaO+SrO+BaO)/Al_2O_3$ is equal to or less than about 1.6, for example in a range from about 1 to about 1.5, in a range from about 1 to about 1.4, in a range from about 1 to about 1.3, in a range from about 1 to about 1.2, or in a range from about 1 to about 1.1, including all ranges and subranges therebetween. In further embodiments, the glass may comprise RO in an amount such that $(MgO+CaO+SrO+BaO)/Al_2O_3$ is in a range from about 1.1 to about 1.6, in a range from about 1.2 to about 1.6, in a range from about 1.3 to about 1.6, in a range from about 1.4 to about 1.6, or in a range from about 1.5 to about 1.6, including all ranges and subranges therebetween.

As discussed previously, $(MgO+CaO+SrO+BaO)/Al_2O_3$ ratios equal to or greater than about 1 can improve fining, i.e., the removal of gaseous inclusions from the melted batch materials. This allows for more environmentally friendly fining. Accordingly, glasses disclosed herein may include a chemical fining agent. Suitable fining agents may include, but are not limited to, $SnO_2$, $As_2O_3$, $Sb_2O_3$, F, Cl, and Br. In embodiments, the chemical fining agent may comprise one or more of $SnO_2$, $As_2O_3$, $Sb_2O_3$, F, Cl, and/or Br in a concentration less than or equal to about 0.5 mol%, for example equal to or less than about 0.45 mol%, equal to or less than about 0.4 mol%, equal to or less than about 0.35 mol%, equal to or less than about 0.3 mol%, or equal to or less than about 0.25 mol%. In embodiments, the glass may comprise in the range of about 0.01 mol% to about 0.4 mol% of any one or combination of $SnO_2$, $As_2O_3$, $Sb_2O_3$, F, Cl, and/or Br. In specific embodiments, the glass composition may comprise in the range of about 0.005 mol% to about 0.2 mol% of any one or combination of $Fe_2O_3$, $CeO_2$ and/or $MnO_2$.

$As_2O_3$ is an effective high temperature fining agent for display glasses, and in some embodiments described herein, $As_2O_3$ may be used for fining because of its superior fining properties. However, $As_2O_3$ is poisonous and requires special handling during the glass manufacturing process. Accordingly, in embodiments, fining may be performed without the use of substantial amounts of $As_2O_3$, i.e., the finished glass may have at most 0.05 mole percent $As_2O_3$. In various

embodiments, no $As_2O_3$ is used in the fining of the glass. In such cases, the finished glass will typically have at most 0.005 mole percent $As_2O_3$ as a result of contaminants present in the batch materials and/or the equipment used to melt the batch materials.

Although not as toxic as $As_2O_3$, $Sb_2O_3$ is also poisonous and requires special handling. In addition, $Sb_2O_3$ raises the density of the glass, raises the CTE, and lowers the annealing point in comparison to glasses that use $As_2O_3$ or $SnO_2$ as a fining agent. Accordingly, in certain embodiments, fining may be performed without the use of substantial amounts of $Sb_2O_3$, i.e., the finished glass has at most 0.05 mole percent $Sb_2O_3$. In other embodiments, no $Sb_2O_3$ is purposely used in the fining of the glass. In such cases, the finished glass will typically have at most 0.005 mole percent $Sb_2O_3$ resulting from contaminants present in the batch materials and/or the equipment used to melt the batch materials.

Compared to $As_2O_3$ and $Sb_2O_3$ fining, tin fining (i.e., $SnO_2$ fining) is less effective, but $SnO_2$ is a ubiquitous material that has no known hazardous properties. Also, for many years $SnO_2$ has been a component of display glasses made using tin oxide electrodes during Joule melting of the batch materials. The presence of $SnO_2$ in display glasses has not resulted in any known adverse effects in the manufacture of flat panel displays. However, high concentrations of $SnO_2$ are not preferred as this can result in the formation of crystalline defects in display glasses. Accordingly, the concentration of $SnO_2$ in the finished glass may be kept to less than or equal to 0.25 mole percent.

Higher viscosity glasses described herein can allow a higher concentration of $SnO_2$ without resulting in any deleterious effects. For example, conventional wisdom suggests a glass with a high anneal point results in a high melting temperature. Such high melting temperatures can result in an increased inclusion presence in the respective glass. To address such inclusion presence, fining agents can be added. However, glasses having low viscosity generally do not permit the addition of $SnO_2$ due to crystallization thereof in the glass. Exemplary glasses, as described herein, however, can possess higher viscosities that result in higher forming temperatures. Accordingly, a greater concentration of fining agent can be added to the glass and produce fewer inclusions. Simply put, by varying the composition of an exemplary glass to create a higher processing temperature, a greater amount of fining agent can be added to remove inclusions before crystallization occurs. Thus, an exemplary glass can include $SnO_2$ at a concentration of between about 0.001 mol% and about 0.5 mol% and have a $T_{35kP}$ equal to or greater than about 1170°C, equal to or greater than about 1200°C, equal to or greater than about 1290°C, or equal to or greater than about 1300°C. Exemplary glasses can include $SnO_2$ at a concentration in a range from about 0.001 mol% to about 0.5 mol% and have a $T_{200P}$ equal to or greater than about 1530°C, equal to or greater than about 1600°C, equal to or greater than about 1670°C, or equal to or greater than about 1700°C. Further exemplary glasses can include $SnO_2$ at a concentration in a range from about 0.001 mol% to about 0.5 mol% and a liquidus temperature equal to or greater than about 1080°C, equal to or greater than about 1150°C, or equal to or greater than about 1290°C. Such a glass can also have a $T_{35kP}$ and/or a $T_{200P}$ as discussed above. As previously stated, $SnO_2$ can be incorporated into the glass from Joule melting using tin-oxide electrodes and/or through the batching of tin containing materials, e.g., $SnO_2$, $SnO$, $SnCO_3$, $SnC_2O_2$, etc.

Tin fining can be used alone or in combination with other fining techniques if desired. For example, tin fining can be combined with halide fining, e.g., bromine fining. Other possible combinations include, but are not limited to, tin fining plus sulfate, sulfide, cerium oxide, mechanical bubbling, and/or vacuum fining. It is contemplated that these other fining techniques can be used alone. In embodiments, maintaining $(MgO+CaO+SrO+BaO)/Al_2O_3$ and individual alkaline earth concentrations within ranges discussed herein makes the fining process easier to perform and more effective.

Glass compositions disclosed herein may comprise transition metal oxides added specifically to reduce the average optical transmittance of the glasses. For example, glasses described herein may comprise nickel, e.g., NiO, and/or cobalt, e.g., $Co_3O_4$, in an amount sufficient to produce an average optical transmittance in the glass article in a range from about 50% to about 90% over a wavelength range from about 450 nm to about 650 nm when measured through a thickness of 0.7 mm with an optical power meter, for example in a range from about 60% to 85%, in a range from about 60% to about 83%, in a range from about 60% to about 81%, in a range from about 60% to about 79%, in a range from about 60% to about 77%, in a range from about 60% to about 75%, in a range from about 60% to about 73%, in a range from about 60% to about 71%, in a range from about 60% to about 69%, in a range from about 60% to about 67%, or in a range from about 60% to about 65%.

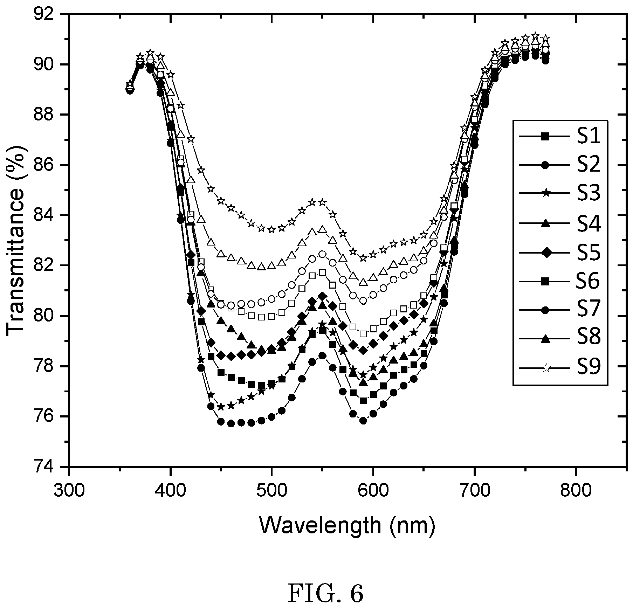

In further embodiments, the glass may have an average transmittance in a range from about 62% to about 90%, in a range from about 64% to about 90%, in a range from about 66% to about 90%, in a range from about 68% to about 90%, in a range from about 70% to about 90%, in a range from about 72% to about 90%, in a range from about 74% to about 90%, in a range from about 76% to about 90%, in a range from about 78% to about 90%, in a range from about 80% to about 90%, or in a range from about 82% to about 90%, including all ranges and subranges therebetween. As used herein, average transmittance refers to the average of all transmittances for a given glass article, such as a glass substrate, over the stated wavelength range. See for example, FIG. 6 depicting transmittances for several different compositions. Indeed, the data show that transmittances between 450 nanometers and 650 nanometers fall within +/- 5% of the average transmittance for any given sample, indicating a very flat transmittance response to wavelength over that wavelength range.

The glass may comprise NiO in a range from about 0 mol% to about 0.15 mol%, in a range from about 0.025 mol% to about 0.15 mol%, in a range from about 0.035 mol%) to about 0.15 mol%, in a range from about 0.045 mol% to about 0.15 mol%, in a range from about 0.055 mol% to about 0.15 mol%, in a range from about 0.065 mol% to about 0.15 mol%, in a range from about 0.075 mol% to about 0.15 mol%, in a range from about 0.085 mol% to about 0.15 mol%, in a range from about 0.095 mol% to about 0.15 mol%, in a range from about 0.105 mol% to about 0.15 mol%, in a range from about 0.110 mol% to about 0.15 mol%, in a range from about 0.115 mol% to about 0.15 mol%, in a range from about 0.120 mol% to about 0.15 mol%, or in a range from about 0.125 mol% to about 1.5 mol%, including all ranges and subranges therebetween.

In further embodiments, the glass may comprise NiO in a range from about 0 mol% to about 0.14 mol%, in a range from about 0 mol% to about 0.13 mol%, in a range from about 0 mol% to about 0.12 mol%, in a range from about 0 mol% to about 0.11 mol%, in a range from about 0 mol% to about 0.10 mol%, in a range from about 0 mol% to about 0.09 mol%, in a range from about 0 mol% to about 0.08 mol%, in a range from about 0 mol% to about 0.07 mol%, in a range from about 0 mol% to about 0.06 mol%, or in a range from about 0 mol% to about 0.05 mol%, including all ranges and subranges therebetween.

Alternatively, or in addition, the glass may comprise $Co_3O_4$ in a range from about 0 mol% to about 0.05 mol%, for example in a range from about 0 mol% to about 0.045 mol%, in a range from about 0 mol% to about 0.04 mol%, in a range from about 0 mol% to about 0.035 mol%, in a range from about 0 mol% to about 0.03 mol%, in a range from about 0 mol% to about 0.025 mol%, in a range from about 0 mol% to about 0.02 mol%, in a range from about 0 mol% to about 0.015 mol%, or in a range from about 0 mol% to about 0.01 mol%, including all ranges and subranges therebetween.

In further embodiments, the glass may comprise $Co_3O_4$ in a range from about 0.01 mol% to about 0.05 mol%, in a range from about 0.015 mol% to about 0.05 mol%, in a range from about 0.02 mol% to about 0.05 mol%, in a range from about 0.025 mol% to about 0.05 mol%, in a range from about 0.03 mol% to about 0.05 mol%, in a range from about 0.035 mol% to about 0.05 mol%, in a range from about 0.04 mol% to about 0.05 mol%, or in a range from about 0.045 mol% to about 0.05 mol%, including all ranges and subranges therebetween. In particular embodiments, the glass may comprise $Co_3O_4$ in a range from about 0.005 mol% to about 0.05 mol%, for example in a range from about 0.01 mol% to about 0.04 mol%, including all ranges and subranges therebetween.

The glass may contain $Fe_2O_3$ in an amount equal to or less than about 0.02 mol%, such as equal to or less than about 0.01 mol%.

Reduced optical transmittance glasses disclosed herein may have color coordinates comprising a lightness value L* less than about 94, for example in a range from about 83 to about 94, a red-green coordinate a* in a range from about -0.87 to about 0.02 and a yellow-blue coordinate b* in a range from about -2.30 to about 1.85 when tested with a Cary 60 spectrometer from Agilent Technologies using FL2 lighting, a 10-degree observer angle, and a sample thickness of 0.7 mm.

The anneal point (i.e., anneal temperature) is the temperature at which the viscosity of the glass, on heating, falls below $10^{13}$ poise ($10^{13}$ dyne-second/$cm^2$). At such a viscosity the glass is still too hard for significant external deformation without breaking, but soft enough to relax internal strains. Glasses disclosed herein may have an anneal point equal to or greater than about 700°C, for example in a range from about 700°C to about 810°C, in a range from about 710°C to about 810°C, in a range from about 720°C to about 810°C, in a range from about 730°C to about 810°C, in a range from about 740°C to about 810°C, in a range from about 750°C to about 810°C, in a range from about 760°C to about 810°C, in a range from about 770°C to about 810°C, in a range from about 780°C to about 810°C, in a range from about 790°C to about 810°C, or in a range from about 800°C to about 810°C, including all ranges and subranges therebetween.

In further embodiments, the glass may have an anneal point in a range from about 700°C to about 800°C, in a range from about 700°C to about 790°C, in a range from about 700°C to about 780°C, in a range from about 700°C to about 770°C, in a range from about 700°C to about 760°C, in a range from about 700°C to about 750°C, in a range from about 700°C to about 740°C, in a range from about 700°C to about 730°C, in a range from about 700°C to about 720°C, or in a range from about 700°C to about 710°C, including all ranges and subranges therebetween.

Strain point is the temperature at which the viscosity of the glass, on cooling, exceeds $10^{14.5}$ poise. Glass disclosed herein may comprise a strain point in a range from about 660°C to about 760°C, for example in a range from about 660°C to about 750°C, in a range from about 660°C to about 740°C, in a range from about 660°C to about 730°C, in a range from about 660°C to about 720°C, in a range from about 660°C to about 710°C, in a range from about 660°C to about 700°C, in a range from about 660°C to about 680°C, or in a range from about 660°C to about 670°C, including all ranges and subranges therebetween.

In further embodiments, the glass may comprise a strain point in a range from about 670°C to about 760°C, for example in a range from about 680°C to about 760°C, in a range from about 690°C to about 760°C, in a range from about 700°C to about 760°C, in a range from about 710°C to about 760°C, in a range from about 720°C to about 760°C, in a range from about 730°C to about 760°C, in a range from about 740°C to about 760°C, or in a range from about 750°C to about 760°C, including all ranges and subranges therebetween. In specific embodiments, the glass may comprise a strain point in a range from about 667°C to about 752°C, including all ranges and subranges therebetween.

Young's modulus is a measure of the tensile or compressive stress (i.e., force per unit area) and the resultant strain in the linear elastic region of the glass as a result of that force. Glass disclosed herein may exhibit a Young's modulus greater than about 69 GPa, for example in a range from about 69 GPa to about 85 GPa, in a range from about 70 GPa to about 85 GPa, in a range from about 71 GPa to about 85 GPa, in a range from about 72 GPa to about 85 GPa, in a range from about 73 GPa to about 85 GPa, in a range from about 74 GPa to about 85 GPa, in a range from about 75 GPa to about 85 GPa, in a range from about 76 GPa to about 85 GPa, in a range from about 77 GPa to about 85 GPa, in a range from about 78 GPa to about 85 GPa, in a range from about 79 GPa to about 85 GPa, in arrange from about 80 GPa to about 85 GPa, in arrange from about 81 GPa to about 85 GPa, in arrange from about 82 GPa to about 85 GPa, in a range from about 83 GPa to about 85 GPa, or in a range from about 84 GPa to about 85 GPa, including all ranges and subranges therebetween.

In further embodiments, the glass may comprise a Young's modulus in a range from about 69 gigapascal (GPa) to about 84 GPa, for example in a range from about 69 GPa to about 83 GPa, in a range from about 69 GPa to about 82 GPa, in a range from about 69 GPa to about 81 GPa, in a range from about 69 GPa to about 80 GPa, in a range from about 69 GPa to about 79, in a range from about 69 GPa to about 78 GPa, in a range from about 69 GPa to about 77 GPa, in a range from about 69 GPa to about 76 GPa, in a range from about 69 GPa to about 75 GPa, in a range from about 69 GPa to about 74 GPa, in a range from about 69 GPa to about 73 GPa, in a range from about 69 GPa to about 72 GPa, in a range from about 69 GPa to about 71 GPa, or in a range from about 69 GPa to about 70 GPa, including all ranges and subranges therebetween.

In embodiments, the temperature of the glasses at a viscosity of about 35,000 poise ($T_{35kP}$) may be equal to or less than about 1340°C, equal to or less than about 1330°C, equal to or less than about 1320°C, equal to or less than about 1310°C, equal to or less than about 1300°C, equal to or less than about 1280°C, equal to or less than about 1260°C, equal to or less than about 1240°C, equal to or less than about 1220°C, equal to or less than about 1200°C, or equal to or less than about 1180°C. For example, the glass may have a $T_{35kP}$ in a range from about 1160°C to about 1340°C, in a range from about 1170°C to about 1340°C, in a range from about 1200°C to about 1340°C, in a range from about 1220°C to about 1340°C, in a range from about 1240°C to about 1340°C, in a range from about 1260°C to about 1340°C, in a range from about 1280°C to about 1340°C, in a range from about 1300°C to about 1340°C, or in a range from about 1320°C to about 1340°C, including all ranges and subranges therebetween.

In embodiments, the temperature of the glasses at a viscosity of about 200 poise ($T_{200P}$) may be equal to or less than about 1700°C, for example in a range from about 1530°C to about 1700°C, in a range from about 1540°C to about 1700°C, in a range from about 1550°C to about 1700°C, in a range from about 1560°C to about 1700°C, in a range from about 1570°C to about 1700°C, in a range from about 1580°C to about 1700°C, in a range from about 1590°C to about 1700°C, in a range from about 1600°C to about 1700°C, in a range from about 1610°C to about 1700°C, in a range from about 1620°C to about 1700°C, in a range from about 1630°C to about 1700°C, in a range from about 1640°C to about 1700°C, in a range from about 1650°C to about 1700°C, in a range from about 1660°C to about 1700°C, in a range from about 1670°C to about 1700°C, in a range from about 1680°C to about 1700°C, or in a range from about 1690°C to about 1700°C, including all ranges and subranges therebetween.

In further embodiments, $T_{200P}$ may be in a range from about 1530°C to about 1690°C, in a range from about 1530°C to about 1680°C, in a range from about 1530°C to about 1660°C, in a range from about 1530°C to about 1630°C, in a range from about 1530°C to about 1640°C, in a range from about 1530°C to about 1630°C, in a range from about 1530°C to about 1620°C, in a range from about 1530°C to about 1610°C, in a range from about 1530°C to about 1600°C, in a range from about 1530 °C to about 1590°C, in a range from about 1530°C to about 1580°C, in a range from about 1530°C to about 1570°C, in a range from about 1530°C to about 1560°C, in a range from about 1530°C to about 1150°C, or in a range from about 1530°C to about 1540°C, including all ranges and subranges therebetween.

The liquidus temperature of a glass ($T_{liq}$) is the temperature above which no crystalline phases can coexist in equilibrium with the glass. In embodiments, glasses disclosed herein may have a $T_{liq}$ in a range from about 1090°C to about 1290°C, for example in a range from about 1090°C to about 1260°C, in a range from about 1090°C to about 1230°C, in a range from about 1090°C to about 1200°C, in a range from about 1090°C to about 1180°C, in a range from about 1090°C to about 1160°C, in a range from about 1090°C to about 1140°C, or in a range from about 1090°C to about 1120°C. This ensures minimum tendency to devitrify on the forming body of the forming process.

In further embodiments, $T_{liq}$ may be in a range from about 1100°C to about 1290°C, in a range from about 1120°C to about 1290°C, in a range from about 1140°C to about 1290°C, in a range from about 1160°C to about 1290°C, in a range from about 1180°C to about 1290°C, in a range from about 1200°C to about 1290°C, in a range from about 1220°C to about 1290°C, in a range from about 1240°C to about 1290°C, or in a range from about 1260°C to about 1290°C, including all ranges and subranges therebetween.

Glasses disclosed herein may exhibit a liquidus viscosity at the liquidus temperature in a range from about 69 kiloPoise (kP) to about 630 kP, for example in a range from about 100 kP to about 500 kP, in a range from about 100 kP to about 400 kP, in a range from about 100 kP to about 300 kP, or in a range from about 100 kP to about 200 kP, including all ranges and subranges therebetween. In further embodiments, glasses disclosed herein may comprise a liquidus viscosity in a range from about 200 kP to about 400 kP, or in a range from about 300 kP to about 400 kP, including all ranges and subranges therebetween.

In embodiments, exemplary glasses can exhibit $T_{35kP}$ - $T_{liq}$ > 0.25$T_{35kP}$ - 225°C.

In aspects, the density of glasses disclosed herein may be less than about 2.7 g/cc, less than about 2.65 g/cc, less than about 2.61 g/cc, less than about 2.6 g/cc, or less than about 2.55 g/cc. In various embodiments, the density may be in a range from about 2.34 g/cc to about 2.65 g/cc, or in a range from about 2.40 g/cc to about 2.62 g/cc, including all ranges and subranges therebetween.

In one or more embodiments, glasses disclosed herein may have a coefficient of thermal expansion (over a temperature range from 0°C to 300°C), in a range from about $28\times10^{-7}$/°C to about $40\times10^{-7}$/°C, in a range from about $28\times10^{-7}$/°C to about $38\times10^{-7}$/°C, in a range from about $28\times10^{-7}$/°C to about $36\times10^{-7}$/°C, in a range from about $28\times10^{-7}$/°C to about $34\times10^{-7}$/°C, in a range from about $28\times10^{-7}$/°C to about $32\times10^{-7}$/°C, or in a range from about $28\times10^{-7}$/°C to about $30\times10^{-7}$/°C, including all ranges and subranges therebetween. In further embodiments, the glass may comprise a coefficient of thermal expansion in a range from about $30\times10^{-7}$/°C to about $40\times10^{-7}$/°C, in a range from about $32\times10^{-7}$/°C to about $40\times10^{-7}$/°C, in a range from about $34\times10^{-7}$/°C to about $40\times10^{-7}$/°C, in a range from about $36\times10^{-7}$/°C to about $40\times10^{-7}$/°C, or in a range from about $38\times10^{-7}$/°C to about $40\times10^{-7}$/°C, including all ranges and subranges therebetween.

One or more particular embodiments may be directed to glass comprising, in mole percent on an oxide basis, $SiO_2$ in a range from about 68 mol% to about 72 mol%, for example in a range from about 69 mol% to about 72 mol%, in a range from about 70 mol% to about 72 mol%, or in a range from about 71 mol% to about 72 mol%, including all ranges and subranges therebetween.

In further embodiments, the glass may comprise $SiO_2$ in a range from about 68 mol% to about 71 mol%, in a range from about 68 mol% to about 70 mol%, or in a range from about 68 mol% to about 69 mol%, including all ranges and subranges therebetween.

The glass may comprise $Al_2O_3$ in a range from about 10 mol% to about 14 mol%, for example in a range from about 10.5 mol% to about 14 mol%, in a range from about 11 mol% to about 14 mol%, in a range from about 11.5 mol% to about 14 mol%, in a range from about 12 mol% to about 14 mol%, in a range from about 12.5 mol% to about 14 mol%, in a range from about 13 mol% to about 14 mol%, or in a range from about 13.5 mol% to about 14 mol%, including all ranges and subranges therebetween.

The glass may comprise $B_2O_3$ in a range from equal to or greater than 0 mol% to about 2 mol%, for example in a range from about 0.1 mol% to about 2 mol%, in a range from about 0.2 mol% to about 2 mol%, in a range from about 0.4 mol% to about 2 mol%, in a range from about 0.6 mol% to about 2 mol%, in a range from about 0.8 mol% to about 2 mol%, in a range from about 1 mol% to about 2 mol%, in a range from about 1.2 mol% to about 2 mol%, in a range from about 1.4 mol% to about 2 mol%, in a range from about 1.6 mol% to about 2 mol%, or in a range from about 1.8 mol% to about 2 mol%, including all ranges and subranges therebetween.

The glass may comprise MgO in a range from about 3 mol% to about 9 mol%, for example in a range from about 3.5 mol% to about 9 mol%, in a range from about 4 mol% to about 9 mol%, in a range from about 4.5 mol% to about 9 mol%, in a range from about 5 mol% to about 9 mol%, in a range from about 5.5 mol% to about 9 mol%, in a range from about 6 mol% to about 9 mol%, in a range from about 6.5 mol% to about 9 mol%, in a range from about 7 mol% to about 9 mol%, in a range from about 7.5 mol% to about 9 mol%, in a range from about 8 mol% to about 9 mol%, or in a range from about 8.5 mol% to about 9 mol%, including all ranges and subranges therebetween.

The glass may comprise CaO in a range from about 3.5 mol% to about 6 mol%, for example in a range from about 3.75 mol% to about 6 mol%, in a range from about 4 mol% to about 6 mol%, in a range from about 4.5 mol% to about 6 mol%, in a range from about 5 mol% to about 6 mol%, or in a range from about 5.5 mol% to about 6 mol%, including all ranges and subranges therebetween.

The glass may comprise SrO in a range from about 1 mol% to about 2 mol%, for example in a range from about 1.2 mol% to about 2 mol%, in a range from about 1.4 mol% to about 2 mol%, in a range from about 1.6 mol% to about 2 mol%, in a range from about 1.8 mol%) to about 2 mol%, including all ranges and subranges therebetween

The glass may comprise BaO in a range from about 3 mol% to about 5 mol%, for example in a range from about 3.5 mol% to about 5 mol%, in a range from about 4 mol% to about 5 mol%, in a range from about 4.5 mol% to about 5 mol%, including all ranges and subranges therebetween.

The glass may include RO (i.e., MgO, CaO, SrO, and BaO) such that (MgO+CaO+SrO+BaO)/$Al_2O_3$ is equal to or greater than about 1, for example in a range from about 1 to about 1.6, in a range from about 1 to about 1.5, in a range from about 1 to about 1.4, in a range from about 1 to about 1.3, or in a range from about 1 to about 1.2, including all ranges and subranges therebetween.

In further embodiments, the glass may comprise RO in an amount such that (MgO+CaO+SrO+BaO)/$Al_2O_3$ is in a range from about 1.1 to about 1.6, for example in a range from about 1.2 to about 1.6, in a range from about 1.3 to about 1.6, in a range from about 1.4 to about 1.6, or in a range from about 1.5 to about 1.6, including all ranges and subranges therebetween.

The glass may comprise NiO in a range from about 0.05 mol% to about 0.15 mol%, for example in a range from about 0.075 mol% to about 0.15 mol%, in a range from about 0.1 mol% to about 0.15 mol%, or in a range from about 0.125 mol% to about 0.15 mol%, including all ranges and subranges therebetween.

The glass may comprise $Co_3O_4$ in a range from about 0.01 mol% to about 0.05 mol%, for example in a range from about 0.02 mol% to about 0.05 mol%, in a range from about 0.03 mol% to about 0.05 mol%, or in a range from about 0.04 mol% to about 0.05 mol%, including all ranges and subranges therebetween.

The glass may comprise $Fe_2O_3$ in an amount equal to or less than about 0.02 mol%, such as equal to or less than about 0.01 mol%.

The glass may be substantially free of alkali metal oxides.

The glass may have an anneal point equal to or greater than about 800°C, for example in a range from about 800°C to about 810°C, in a range from about 802°C to about 810°C, in a range from about 804°C to about 810°C, in a range from about 806°C to about 810°C, or in a range from about 808°C to about 810°C, including all ranges and subranges therebetween.

In further embodiments, the glass may have an anneal point in a range from about 800°C to about 808°C, in a range from about 800°C to about 806°C, in a range from about 800°C to about 804°C, or in a range from about 800°C to about 802°C, including all ranges and subranges therebetween. In specific embodiments, the glass may have an anneal point in a range from about 801°C to 805°C, including all ranges and subranges therebetween.

The glass may comprise a strain point in a range from about 740°C to about 760°C, for example in a range from about 740°C to about 758°C, in a range from about 740°C to about 756°C, in a range from about 740°C to about 754°C, in a range from about 740°C to about 752°C, in a range from about 740°C to about 750°C, in a range from about 740°C to about 748°C, in a range from about 740°C to about 746°C, in a range from about 740°C to about 744°C, or in a range from about 740°C to about 742°C, including all ranges and subranges therebetween.

In further embodiments, the glass may comprise a strain point in a range from about 742°C to about 760°C, for example in a range from about 744°C to about 760°C, in a range from about 746°C to about 760°C, in a range from about 748°C to about 760°C, in a range from about 750°C to about 760°C, in a range from about 752°C to about 760°C, in a range from about 754°C to about 760°C, in a range from about 756°C to about 760°C, or in a range from about 758°C to about 760°C, including all ranges and subranges therebetween. In specific embodiments, the glass may comprise a strain point in a range from about 748°C to about 752°C, including all ranges and subranges therebetween.

The glass may comprise a Young's modulus equal to or greater than about 81 GPa, for example in a range from about 81 GPa to about 85 GPa, in a range from about 82 GPa to about 85 GPa, or in a range from about 84 GPa to about 85 GPa, including all ranges and subranges therebetween.

In further embodiments, the glass may comprise a Young's modulus in a range from about 82 GPa to about 85 GPa, in a range from about 83 GPa to about 85 GPa, or in a range from about 84 GPa to about 85 GPa, including all ranges and subranges therebetween. In specific embodiments, the glass may comprise a Young's modulus in a range from about 81.9 GPa to about 84.4 GPa, including all ranges and subranges therebetween.

The glass may have a $T_{200P}$ equal to or less than about 1700°C, for example in a range from about 1680°C to about 1700°C, in a range from about 1682°C to about 1700°C, in a range from about 1684°C to about 1700°C, in a range from about 1686°C to about 1700°C, in a range from about 1688°C to about 1700°C, in a range from about 1690°C to about 1700°C, in a range from about 1692°C to about 1700°C, in a range from about 1694°C to about 1700°C, in a range from about 1696°C to about 1700°C, in a range from about 1698 °C to about 1700°C, including all ranges and subranges therebetween.

In further embodiments, $T_{200P}$ may be in a range from about 1680°C to about 1698°C, in a range from about 1680°C to about 1696°C, in a range from about 1680°C to about 1694°C, in a range from about 1680°C to about 1692°C, in a range from about 1680°C to about 1690°C, in a range from about 1680°C to about 1688°C, in a range from about 1680°C to about 1686°C, in a range from about 1680 °C to about 1684°C, or in a range from about 1680°C to about 1682°C, including all ranges and subranges therebetween. In specific embodiments, $T_{200P}$ may be in a range from about 1681°C to about 1696°C, including all ranges and subranges therebetween.

In embodiments, the temperature of the glass at a viscosity of about 35,000 poise ($T_{35kP}$) may be in a range from about 1290°C to about 1310°C, in a range from about 1300°C to about 1310°C, in a range from about 1302°C to about 1310°C, in a range from about 1304°C to about 1310°C, in a range from about 1306°C to about 1310°C, or in a range from about 1308°C to about 1310°C, including all ranges and subranges therebetween.

In further embodiments, the glass may comprise a $T_{35kP}$ in a range from about 1290°C to about 1308°C, in a range from about 1290°C to about 1306°C, in a range from about 1290°C to about 1304°C, in a range from about 1290°C to about 1302°C, in a range from about 1290°C to about 1300°C, in a range from about 1290°C to about 1298°C, in a range from about 1290°C to about 1296°C, in a range from about 1290°C to about 1294°C, or in a range from about 1290°C to about 1292°C, including all ranges and subranges therebetween. In specific embodiments, $T_{35kP}$ may be in a range from about 1290°C to about 1305°C, including all ranges and subranges therebetween.

In embodiments, the glass may have a $T_{liq}$ in a range from about 1195°C to about 1270°C, for example in a range from about 1195°C to about 1260°C, in a range from about 1195°C to about 1250°C, in a range from about 1195°C to about 1240°C, in a range from about 1195°C to about 1220°C, or in a range from about 1195°C to about 1210°C, including all ranges and subranges therebetween.

In further embodiments, $T_{liq}$ may be in a range from about 1200°C to about 1270°C, in a range from about 1210°C to about 1270°C, in a range from about 1220°C to about 1270°C, in a range from about 1240°C to about 1270°C, or in a range from about 1260°C to about 1270°C, including all ranges and subranges therebetween.

The glass may exhibit a liquidus viscosity at the liquidus temperature in a range from about 69 kP to about 350 kP, for example in a range from about 100 kP to about 350 kP, in a range from about 120 kP to about 350 kP, in a range from about 140 kP to about 350 kP, in a range from about 160 kP to about 350 kP, in a range from about 180 kP to about 350 kP, in a range from about 200 kP to about 350 kP, in a range from about 220 kP to about 350 kP, in a range from about 240 kP to about 350 kP, in a range from about 260 kP to about 350 kP, in a range from about 280 kP to about 350 kP, in a range from about 300 kP to about 350 kP, or in a range from about 320 kP to about 350 kP, including all ranges and subranges therebetween.

In further embodiments, the glass may comprise a liquidus viscosity in a range from about 69 kP to about 350 kP, in a range from about 69 kP to about 320 kP, in a range from about 69 kP to about 300 kP, in a range from about 69 kP to about 280 kP, in a range from about 69 kP to about 260 kP, in a range from about 69 kP to about 260 kP, in a range from about 69 kP to about 240 kP, in a range from about 69 kP to about 220 kP, in a range from about 69 kP to about 200 kP, in a range from about 69 kP to about 180 kP, in a range from about 69 kP to about 160 kP, in a range from about 69 kP to about 140 kP, in a range from about 69 kP to about 120 kP, or in a range from about 69 kP to about 100 kP, including all ranges and subranges therebetween.

The glass may have a linear coefficient of thermal expansion (over a temperature range from 0°C to 300°C) in a range from about $29 \times 10^{-7}$/°C to about $40 \times 10^{-7}$/°C, in a range from about $29 \times 10^{-7}$/°C to about $39 \times 10^{-7}$/°C, in a range from about $29 \times 10^{-7}$/°C to about $38 \times 10^{-7}$/°C, in a range from about $29 \times 10^{-7}$/°C to about $37 \times 10^{-7}$/°C, in a range from about $29 \times 10^{-7}$/°C to about $36 \times 10^{-7}$/°C, in a range from about $29 \times 10^{-7}$/°C to about $35 \times 10^{-7}$/°C, in a range from about $29 \times 10^{-7}$/°C to about $34 \times 10^{-7}$/°C, in a range from about $29 \times 10^{-7}$/°C to about $33 \times 10^{-7}$/°C, in a range from about $29 \times 10^{-7}$/°C to about $32 \times 10^{-7}$/°C, in a range from about $29 \times 10^{-7}$/°C to about $31 \times 10^{-7}$/°C, or in a range from about $29 \times 10^{-7}$/°C to about $30 \times 10^{-7}$/°C, including all ranges and subranges therebetween.

In further embodiments, the glass may comprise a linear coefficient of thermal expansion in a range from about $30 \times 10^{-7}$/°C to about $36 \times 10^{-7}$/°C, in a range from about $31 \times 10^{-7}$/°C to about $36 \times 10^{-7}$/°C, in a range from about $32 \times 10^{-7}$/°C to about $36 \times 10^{-7}$/°C, in a range from about $33 \times 10^{-7}$/°C to about $36 \times 10^{-7}$/°C, in a range from about $34 \times 10^{-7}$/°C to about $36 \times 10^{-7}$/°C, or in a range from about $35 \times 10^{-7}$/°C to about $36 \times 10^{-7}$/°C, including all ranges and subranges therebetween.

The glass may have a density in a range from about 2.5 g/cc$^3$ to about 2.62 g/cc$^3$, in a range from about 2.55 g/cc$^3$ to about 2.62 g/cc$^3$, or in a range from about 2.6 g/cc$^3$ to about 2.66 g/cc$^3$, including all ranges and subranges therebetween.

The glass may have an average transmittance in a range from about 60% to about 80%, for example in a range from about 62% to about 80%, in a range from about 64% to about 80%, in a range from about 66% to about 80%, in a range from about 68% to about 80%, in a range from about 70% to about 80%, in a range from about 72% to about 80%, in a range from about 74% to about 80%, in a range from about 76% to about 80%, or in a range from about 78% to about 80%, including all ranges and subranges therebetween.

One or more other particular embodiments may be directed to glass comprising, in mole percent on an oxide basis, $SiO_2$ in a range from about 66 mol% to about 71 mol%, for example in a range from about 66.5 mol% to about 71 mol%, in a range from about 67 mol% to about 71 mol%, in a range from about 67.5 mol% to about 71 mol%, in a range from about 68 mol% to about 71 mol%, in a range from about 68.5 mol% to about 71 mol%, in a range from about 69 mol% to about 71 mol%, in a range from about 69.5 mol% to about 71 mol%, in a range from about 70 mol% to about 71 mol%, or in a range from about 70.5 mol% to about 71 mol%, including all ranges and subranges therebetween.

The glass may comprise $Al_2O_3$ in a range from about 9 mole% to about to about 12 mol%, for example in a range from about 9.5 mol% to about 12 mol%, in a range from about 10 mol% to about 12 mol%, in a range from about 10.5 mol% to about 12 mol%, in a range from about 11 mol% to about 12 mol%, or in a range from about 11.5 mol% to about 12 mol%, including all ranges and subranges therebetween.

The glass may comprise $B_2O_3$ in a range from about 7 mol% to about 12 mol%, for example in a range from about 7.5 mol% to about 12 mol%, in a range from about 8 mol% to about 12 mol%, in a range from about 8.5 mol% to about 12 mol%, in a range from about 9 mol% to about 12 mol%, in a range from about 9.5 mol% to about 12 mol%, in a range from about 10 mol% to about 12 mol%, in a range from about 10.5 mol% to about 12 mol%, in a range from about 11 mol% to about 12 mol%, or in a range from about 11.5 mol% to about 12 mol%, including all ranges and subranges therebetween.

The glass may comprise MgO in a range from about 0.9 mol% to about 2.0 mol%, for example in a range from about 1 mol% to about 2 mol%, in a range from about 1.2 mol% to about 2 mol%, in a range from about 1.4 mol% to about 2 mol%, in a range from about 1.6 mol% to about 2 mol%, or in a range from about 1.8 mol% to about 2 mol%, including all ranges and subranges therebetween.

The glass may comprise CaO in a range from about 7 mol% to about 11.5 mol%, for example in a range from about 7.5 mol% to about 11.5 mol%, in a range from about 8 mol% to about 11.5 mol%, in a range from about 8.5 mol% to about 11.5 mol%, in a range from about 9 mol% to about 11.5 mol%, in a range from about 9.5 mol% to about 11.5 mol%, in a range from about 10 mol% to about 11.5 mol%, in a range from about 10.5 mol% to about 11.5 mol%, or in a range from about 11 mol% to about 11.5 mol%, including all ranges and subranges therebetween.

The glass may comprise SrO in a range from about 0.5 mol% to about 1.1 mol%, for example in a range from about 0.6 mol% to about 1.1 mol%, in a range from about 0.7 mol% to about 1.1 mol%, in a range from about 0.8 mol% to about 1.1 mol%, in a range from about 0.9 mol% to about 1.1 mol%, or in a range from about 1 mol% to about 1.1 mol%, including all ranges and subranges therebetween.

The glass may comprise BaO in a range from about 0 to about 0.1 mol%. For example, the glass may be free of BaO.

The glass may include RO (i.e., MgO, CaO, SrO, and BaO) such that $(MgO+CaO+SrO+BaO)/Al_2O_3$ may be in a range from about 1 to about 1.2, or in a range from about 1 to about 1.1, including all ranges and subranges therebetween.

The glass may comprise NiO in a range from about 0.05 mol% to about 0.15 mol%, for example in a range from about 0.075 mol% to about 0.15 mol%, in a range from about 0.1 mol% to about 0.15 mol%, or in a range from about 0.125 mol% to about 0.15 mol%, including all ranges and subranges therebetween.

The glass may comprise $Co_3O_4$ in a range from about 0.01 mol% to about 0.05 mol%, for example in a range from about 0.02 mol% to about 0.05 mol%, in a range from about 0.03 mol% to about 0.05 mol%, or in a range from about 0.04 mol% to about 0.05 mol%, including all ranges and subranges therebetween.

The glass may contain $Fe_2O_3$ in an amount equal to or less than about 0.02 mol%, such as equal to or less than about 0.01 mol%.

The glass may be free of alkali metal oxides.

The glass may have an anneal point in a range from about 720°C to about 750°C, for example in a range from about 730°C to about 750°C, or in a range from about 740°C to about 750°C, including all ranges and subranges therebetween. In further embodiments, the glass may have an anneal point in a range from about 720°C to about 740°C, or in a range from about 720°C to about 730°C, including all ranges and subranges therebetween. In specific embodiments, the glass may have an anneal point in a range from about 723°C to 745°C, including all ranges and subranges therebetween.

The glass may comprise a strain point in a range from about 660°C to about 700°C, for example in a range from about 665°C to about 700°C, in a range from about 670°C to about 700°C, in a range from about 675°C to about 700°C, in a range from about 680°C to about 700°C, in a range from about 685°C to about 700°C, in a range from about 690°C to about 700°C, or in a range from about 695°C to about 700°C, including all ranges and subranges therebetween. In specific embodiments, the glass may comprise a strain point in a range from about 667°C to about 693°C, including all ranges and subranges therebetween.

The glass may comprise a Young's modulus in a range from about 69 to about 78 GP, for example in a range from about 69 GPa to about 76 GPa, in a range from about 69 GPa to about 74 GPa, or in a range from about 69 GPa to about 72 GPa, including all ranges and subranges therebetween. In further embodiments, the glass may comprise a Young's modulus in a range from about 72 GPa to about 78 GPa, in a range from about 74 GPa to about 78 GPa, or in a range from about 76 GPa to about 78 GPa, including all ranges and subranges therebetween. In specific embodiments, the glass may comprise a Young's modulus in a range from about 81.9 GPa to about 84.4 GPa, including all ranges and subranges therebetween.

The glass may comprise a $T_{200P}$ equal to or less than about 1680°C, for example in a range from about 1590°C to about 1680°C, in a range from about 1600°C to about 1680°C, in a range from about 1610°C to about 1680°C, in a range from about 1620 °C to about 1680°C, in a range from about 1630°C to about 1680°C, in a range from about 1640°C to about 1680°C, in a range from about 1650°C to about 1680°C, in a range from about 1660°C to about 1680°C, in a range from about 1670°C to about 1680°C, including all ranges and subranges therebetween.

In further embodiments, $T_{200P}$ may be in a range from about 1590°C to about 1670°C, in a range from about 1590°C to about 1660°C, in a range from about 1590°C to about 1650°C, in a range from about 1590°C to about 1640°C, in a range from about 1590°C to about 1630°C, in a range from about 1590°C to about 1620°C, in a range from about 1590°C to about 1610°C, or in a range from about 1590°C to about 1600°C, including all ranges and subranges therebetween. In specific embodiments, $T_{200P}$ may be in a range from about 1590°C to about 1675°C.

In embodiments, the temperature of the glass at a viscosity of about 35,000 poise ($T_{35kP}$) may be in a range from about 1210°C to about 1260°C, in a range from about 1210°C to about 1250°C, in a range from about 1210°C to about 1240°C, in a range from about 1210°C to about 1230°C, or in a range from about 1210°C to about 1220°C, including all ranges and subranges therebetween. In further embodiments, the glass may comprise a $T_{35kP}$ in a range from about 1220°C to about 1260°C, in a range from about 1230°C to about 1260°C, in a range from about 1240°C to about 1260°C, or in a range from about 1250°C to about 1260°C, including all ranges and subranges therebetween. In specific embodiments, $T_{35kP}$ may be in a range from about 1216°C to about 1255°C, including all ranges and subranges therebetween.

In embodiments, the glass may comprise a $T_{liq}$ in a range from about 1090°C to about 1170°C, for example in a range from about 1090°C to about 1160°C, in a range from about 1090°C to about 1150°C, in a range from about 1090°C to about 1140°C, in a range from about 1090°C to about 1120°C, or in a range from about 1090°C to about 1110°C, including all ranges and subranges therebetween.

In further embodiments, $T_{liq}$ may be in a range from about 1100°C to about 1170°C, in a range from about 1110°C to about 1170°C, in a range from about 1120 °C to about 1170°C, in a range from about 1140°C to about 1170°C, or in a range from about 1160°C to about 1170°C, including all ranges and subranges therebetween.

The glass may exhibit a liquidus viscosity at the liquidus temperature in a range from about 200 kP to about 630 kP, for example in a range from about 300 kP to about 630 kP, in a range from about 400 kP to about 630 kP, or in a range from about 500 kP to about 630 kP, including all ranges and subranges therebetween.

In further embodiments, the glass may comprise a liquidus viscosity in a range from about 250 kP to about 630 kP, in a range from about 300 kP to about 630 kP, in a range from about 350 kP to about 630 kP, in a range from about 400 kP to about 630 kP, in a range from about 450 kP to about 630 kP, in a range from about 500 kP to 630 kP, or in a range from about 550 kP to about 630 kP, including all ranges and subranges therebetween.

The glass exhibit a linear coefficient of thermal expansion (over a temperature range from 0°C to 300°C) in a range from about $33 \times 10^{-7}$/°C to about $40 \times 10^{-7}$/°C, in a range from about $33 \times 10^{-7}$/°C to about $39 \times 10^{-7}$/°C, in a range from about $33 \times 10^{-7}$/°C to about $38 \times 10^{-7}$/°C, in a range from about $33 \times 10^{-7}$/°C to about $37 \times 10^{-7}$/°C, in a range from about $33 \times 10^{-7}$/°C to about $36 \times 10^{-7}$/°C, in a range from about $33 \times 10^{-7}$/°C to about $35 \times 10^{-7}$/°C, in a range from about $33 \times 10^{-7}$/°C to about $34 \times 10^{-7}$/°C including all ranges and subranges therebetween.

In further embodiments, the glass may comprise a linear coefficient of thermal expansion in a range from about $34 \times 10^{-7}$/°C to about $40 \times 10^{-7}$/°C, in a range from about $35 \times 10^{-7}$/°C to about $40 \times 10^{-7}$/°C, in a range from about $36 \times 10^{-7}$/°C to about $40 \times 10^{-7}$/°C, in a range from about $37 \times 10^{-7}$/°C to about $40 \times 10^{-7}$/°C, in a range from about $38 \times 10^{-7}$/°C to about $40 \times 10^{-7}$/°C, or in a range from about $39 \times 10^{-7}$/°C to about $40 \times 10^{-7}$/°C, including all ranges and subranges therebetween.

The glass may have a density in a range from about 2.3 g/cc$^3$ to about 2.5 g/cc$^3$, for example in a range from about 2.35 g/cc$^3$ to about 2.5 g/cc$^3$, in a range from about 2.4 g/cc$^3$ to about 2.5 g/cc$^3$, in a range from about 2.45 g/cc$^3$ to about 2.5 g/cc$^3$, including all ranges and subranges therebetween. In specific embodiments, the glass may comprise a density in a range from about 2.34 g/cc$^3$ to about 2.45 g/cc$^3$.

The glass may have an average transmittance in a range from about 64% to about 82%, for example in a range from about 64% to about 80%, in a range from about 64% to about 78%, in a range from about 64% to about 76%, in a range from about 64% to about 74%, in a range from about 64% to about 72%, in a range from about 64% to about 70%, in a range from about 64% to about 68%, or in a range from about 64% to about 66%, including all ranges and subranges therebetween.

In further embodiments, the glass may have an average transmittance in a range from about 66% to about 82%, in a range from about 68% to about 82%, in a range from about 70% to about 82%, in a range from about 72% to about 82%, in a range from about 74% to about 82%, in a range from about 76% to about 82%, in a range from about 78% to about 82%, or in a range from about 80% to about 82%, including all ranges and subranges therebetween.

Still other particular embodiments may be directed to glass comprising, SiO$_2$ in a range from about 61 mol% to about 68 mol%, for example in a range from about 61.5 mol% to about 68 mol%, in a range from about 62 mol% to about 68 mol%, in a range from about 62.5 mol% to about 68 mol%, in a range from about 63 mol% to about 68 mol%, in a range from about 63.5 mol% to about 68 mol%, in a range from about 64 mol% to about 68 mol%, in a range from about 64.5 mol% to about 68 mol%, in a range from about 65 mol% to about 68 mol%, in a range from about 65.5 mol% to about 68 mol%, in a range from about 66 mol% to about 68 mol%, in a range from about 66.5 mol% to about 68 mol%, in a range from about 67 mol% to about 68 mol%, or in a range from about 67.5 mol% to about 68 mol%, including all ranges and subranges therebetween.

The glass may comprise Al$_2$O$_3$ in a range from about 11 mol% to about 14 mol%, for example in a range from about 11.5 mol% to about 14 mol%, in a range from about 12 mol% to about 14 mol%, in a range from about 12.5 mol% to about 14 mol%, in a range from about 13 mol% to about 14 mol%, or in a range from about 13.5 mol% to about 14 mol%, including all ranges and subranges therebetween.

The glass may comprise B$_2$O$_3$ in a range from about 6 mol% to about 8.5 mol%, for example in a range from about 6.5 mol% to about 8.5 mol%, in a range from about 7 mol% to about 8.5 mol%, in a range from about 7.5 mol% to about 8.5 mol%, or in a range from about 8 mol% to about 8.5 mol%, including all ranges and subranges therebetween.

The glass may comprise MgO in a range from about 3.5 mol% to about 6.0 mol%, for example in a range from about 4 mol% to about 6.0 mol%, in a range from about 4.5 mol% to about 6.0 mol%, in a range from about 5 mol% to about 6.0 mol%, or in a range from about 5.5 mol% to about 6 mol%, including all ranges and subranges therebetween.

The glass may comprise CaO in a range from about 5 mol% to about 7 mol%, for example in a range from about 5.5 mol% to about 7 mol%, in a range from about 6 mol% to about 7 mol%, or in a range from about 6.5 mol% to about 7 mol%, including all ranges and subranges therebetween.

The glass may comprise SrO in a range from about 3 mol% to about 5 mol%, for example, in a range from about 3.5 mol% to about 5 mol%, in a range from about 4 mol% to about 5 mol%, or in a range from about 4.5 mol% to about 5 mol%, including all ranges and subranges therebetween.

The glass may comprise BaO in a range from about 0 to about 0.1 mol%. For example, the glass may be free of BaO.

The glass may include RO (i.e., MgO, CaO, SrO, and BaO) such that $(MgO+CaO+SrO+BaO)/Al_2O_3$ may be in a range from about 1.05 to about 1.3, in a range from about 1.1 to about 1.3, or in a range from about 1.2 to about 1.3, including all ranges and subranges therebetween.

The glass may be substantially free of alkali metal oxides.

The glass may have an anneal point in a range from about 700°C to about 760°C, for example in a range from about 700°C to about 750°C, in a range from about 700°C to about 740°C, in a range from about 700°C to about 730°C, in a range from about 700°C to about 720°C, or in a range from about 700°C to about 710°C, including all ranges and subranges therebetween.

The glass may comprise NiO in a range from about 0.05 mol% to about 0.15 mol%, for example in a range from about 0.075 mol% to about 0.15 mol%, in a range from about 0.1 mol% to about 0.15 mol%, or in a range from about 0.125 mol% to about 0.15 mol%, including all ranges and subranges therebetween.

The glass may comprise $Co_3O_4$ in a range from about 0.01 mol% to about 0.05 mol%, for example in a range from about 0.02 mol% to about 0.05 mol%, in a range from about 0.03 mol% to about 0.05 mol%, or in a range from about 0.04 mol% to about 0.05 mol%, including all ranges and subranges therebetween.

The glass may contain $Fe_2O_3$ in an amount equal to or less than about 0.02 mol%, such as equal to or less than about 0.01 mol%.

The glass may be free of alkali metal oxides.

In further embodiments, the glass may have an anneal point in a range from about 710°C to about 760°C, in a range from about 720°C to about 760°C, in a range from about 730°C to about 760°C, in a range from about 740°C to about 760°C, or in a range from about 750°C to about 760°C, including all ranges and subranges therebetween. In specific embodiments, the glass may have an anneal point in a range from about 713°C to 754°C, including all ranges and subranges therebetween.

The glass may comprise a strain point in a range from about 670°C to about 710°C, for example in a range from about 675°C to about 710°C, in a range from about 680°C to about 710°C, in a range from about 685°C to about 710°C, in a range from about 690°C to about 710°C, or in a range from about 700°C to about 710°C, including all ranges and subranges therebetween.

In further embodiments, the glass may comprise a strain point in a range from about 670°C to about 700°C, in a range from about 670°C to about 690°C, or in a range from about 670°C to about 680°C, including all ranges and subranges therebetween. In specific embodiments, the glass may comprise a strain point in a range from about 676°C to about 701°C, including all ranges and subranges therebetween.

The glass may comprise a Young's modulus in a range from about 75 to about 81 GP, for example in a range from about 76 GPa to about 81 GPa, in a range from about 77 GPa to about 81 GPa, in a range from about 78 GPa to about 81 GPa, or in a range from about 79 GPa to about 81 GPa, including all ranges and subranges therebetween. In further embodiments, the glass may comprise a Young's modulus in a range from about 75 GPa to about 79 GPa, in a range from about 75 GPa to about 78 GPa, in a range from about 75 GPa to about 77 GPa, or in a range from about 75 GPa to about 76 GPa, including all ranges and subranges therebetween. In specific embodiments, the glass may comprise a Young's modulus in a range from about 78.8 GPa to about 80.6 GPa, including all ranges and subranges therebetween.

The glass may have a $T_{200P}$ equal to or less than about 1680°C, for example in a range from about 1530°C to about 1610°C, in a range from about 1530°C to about 1600°C, in a range from about 1530°C to about 1590°C, in a range from about 1530°C to about 1580°C, in a range from about 1530°C to about 1570°C, in a range from about 1530°C to about 1560 °C, in a range from about 1530°C to about 1550°C, or in a range from about 1530°C to about 1540°C, including all ranges and subranges therebetween.

In further embodiments, $T_{200P}$ may be in a range from about 1540°C to about 1610°C, in a range from about 1550°C to about 1610°C, in a range from about 1560°C to about 1610°C, in a range from about 1570°C to about 1610°C, in a range from about 1580°C to about 1610°C, or in a range from about 1590°C to about 1610°C, including all ranges and subranges therebetween. In specific embodiments, $T_{200P}$ may be in a range from about 1530°C to about 1606°C, including all ranges and subranges therebetween.

In embodiments, the temperature of the glass at a viscosity of about 35,000 poise ($T_{35kP}$) may be in a range from about 1170°C to about 1240°C, in a range from about 1180°C to about 1240°C, in a range from about 1200°C to about 1240°C, in a range from about 1210°C to about 1240°C, in a range from about 1220°C to about 1240°C, or in a range from about 1230°C to about 1240°C, including all ranges and subranges therebetween. In further embodiments, the glass may comprise a $T_{35kP}$ in a range from about 1170°C to about 1230°C, in a range from about 1170°C to about 1220°C, in a range from about 1170°C to about 1210°C, in a range from about 1170°C to about 1200°C, in a range from about 1170°C to about 1190°C, or in a range from about 1170°C to about 1180°C, including all ranges and subranges therebetween. In specific embodiments, $T_{35kP}$ may be in a range from about 1179°C to about 1237°C, including all ranges and subranges therebetween.

In embodiments, the glass may have a $T_{liq}$ in a range from about 1125°C to about 1155°C, for example in a range from about 1125°C to about 1150°C, in a range from about 1125°C to about 1145°C, in a range from about 1125°C to about 1140°C, in a range from about 1125°C to about 1135°C, or in a range from about 1125°C to about 1130°C, including all ranges and subranges therebetween.

In further embodiments, $T_{liq}$ may be in a range from about 1130°C to about 1155°C, in a range from about 1135°C to about 1155°C, in a range from about 1140°C to about 1155°C, in a range from about 1145°C to about 1155°C, or in a range from about 1150°C to about 1155°C, including all ranges and subranges therebetween.

The glass may exhibit a liquidus viscosity at the liquidus temperature in a range from about 120 kP to about 270 kP, for example in a range from about 160 kP to about 270 kP, in a range from about 200 kP to about 270 kP, or in a range from about 250 kP to about 270 kP, including all ranges and subranges therebetween. In further embodiments, the glass may comprise a liquidus viscosity in a range from about 120 kP to about 250 kP, in a range from about 120 kP to about 200 kP, or in a range from about 120 kP to about 160 kP, including all ranges and subranges therebetween.

The glass may have a linear coefficient of thermal expansion (over a temperature range from 0°C to 300°C) in a range from about $33\times10^{-7}$/°C to about $40\times10^{-7}$/°C, or in a range from about $33\times10^{-7}$/°C to about $39\times10^{-7}$/°C, in a range from about $33\times10^{-7}$/°C to about $38\times10^{-7}$/°C, in a range from about $33\times10^{-7}$/°C to about $37\times10^{-7}$/°C, in a range from about $33\times10^{-7}$/°C to about $36\times10^{-7}$/°C, in a range from about $33\times10^{-7}$/°C to about $35\times10^{-7}$/°C, or in a range from about $33\times10^{-7}$/°C to about $34\times10^{-7}$/°C, including all ranges and subranges therebetween. In further embodiments, the glass may comprise a coefficient of thermal expansion in a range from about $34\times10^{-7}$/°C to about $35\times10^{-7}$/°C, including all ranges and subranges therebetween.

The glass may have a density in a range from about 2.45 g/cc$^3$ to about 2.52 g/cc$^3$, for example in a range from about 2.47 g/cc$^3$ to about 2.52 g/cc$^3$, or in a range from about 2.49 g/cc$^3$ to about 2.52 g/cc$^3$, including all ranges and subranges therebetween. In specific embodiments, the glass may comprise a density in a range from about 2.48 g/cc$^3$ to about 2.51 g/cc$^3$.

The glass may have an average transmittance in a range from about 63% to about 80%, for example in a range from about 63% to about 78%, in a range from about 63% to about 76%, in a range from about 63% to about 74%, in a range from about 63% to about 72%, in a range from about 63% to about 70%, in a range from about 63% to about 68%, or in a range from about 63% to about 66%, including all ranges and subranges therebetween. In further embodiments, the glass may have an average transmittance in a range from about 66% to about 80%, in a range from about 68% to about 80%, in a range from about 70% to about 80%, in a range from about 72% to about 80%, in a range from about 74% to about 80%, or in a range from about 76% to about 80%, in a range from about 78% to about 80%, including all ranges and subranges therebetween.

One or more other embodiments of the disclosure may be directed to a glass comprising $SiO_2$ in a range from about 66 mol% to about to about 69 mol%, for example in a range from about 66.5 mol% to about 69 mol%, in a range from about 67 mol% to about 69 mol%, in a range from about 67.5 mol% to about 69 mol%, in a range from about 68 mol% to about 69 mol%, or in a range from about 68.5 mol% to about 69 mol%, including all ranges and subranges therebetween.

The glass may comprise $Al_2O_3$ in a range from about 12 mol% to about 14 mol%, for example in a range from about 12.2 mol% to about 14 mol%, in a range from about 12.4 mol% to about 14 mol%, for example in a range from about 12.6 mol% to about 14 mol%, in a range from about 12.8 mol% to about 14 mol%, for example in a range from about 13 mol%) to about 14 mol%, in a range from about 13.2 mol% to about 14 mol%, in a range from about 13.4 mol% to about 14 mol%, in a range from about 13.6 mol% to about 14 mol%, or in a range from about 13.8 mol% to about 14 mol%, including all ranges and subranges therebetween.

The glass may further comprise $B_2O_3$ in a range from about 4 mol% to about 5 mol%, for example in a range from about 4.2 mol% to about 5 mol%, in a range from about 4.4 mol% to about 5 mol%, in a range from about 4.6 mol% to about 5 mol%, or in a range from about 4.8 mol% to about 5 mol%, including all ranges and subranges therebetween.

The glass may further comprise MgO in a range from about 4 mole% to about 6 mol%, for example in a range from about 4.2 mol% to about 6 mol%, in a range from about 4.4 mol% to about 6 mol%, in a range from about 4.6 mol% to about 6 mol%, in a range from about 4.8 mol% to about 6 mol%, in a range from about 5 mol% to about 6 mol%, in a range from about 5.2 mol% to about 6 mol%, in a range from about 5.4 mol% to about 6 mol%, in a range from about 5.6 mol% to about 6 mol%, or in a range from about 5.8 mol% to about 6 mol%. In further embodiments, the glass may comprise MgO in an amount in a range from about 4 mol% to about 5.8 mol%, in a range from about 4 mol% to about 5.6 mol%, in a range from about 4 mol% to about 5.4 mol%, in a range from about 4 mol% to about 5.2 mol%, in a range from about 4 mol% to about 5 mol%, in a range from about 4 mol% to about 4.8 mol%, in a range from about 4 mol% to about 4.6 mol%, in a range from about 4 mol% to about 4.4 mol%, or in a range from about 4 mol% to about 4.2 mol%, including all ranges and subranges therebetween. In still further embodiments, the glass may comprise MgO in a range from about 4.2 mol% to about 5.8 mol%, in a range from about 4.4 mol% to about 5.6 mol%, in a range from about 4.6 mol% to about 5.4 mol%, or in a range from about 4.8 mol% to about 5.2 mol%, including all ranges and subranges therebetween. In specific embodiments, the glass may comprise MgO in a range from about 4.5 mol% to about 5.3 mol%, including all ranges and subranges therebetween.

The glass may comprise CaO in a range from about 5 mol% to about 7 mol%, for example in a range from about 5.2 mol% to about 7 mol%, in a range from about 5.4 mol% to about 7 mol%, in a range from about 5.6 mol% to about 7 mol%, in a range from about 5.8 mol% to about 7 mol%, in a range from about 6 mol% to about 7 mol%, in a range from about 6.2 mol% to about 7 mol%, in a range from about 6.4 mol% to about 7 mol%, in a range from about 6.6 mol% to about 7 mol%, or in a range from about 6.8 mol% to about 7 mol%, including all ranges and subranges therebetween.

In further embodiments, the glass may comprise CaO in a range from about 5 mol% to about 6.8 mol%, in a range from about 5 mol% to about 6.6 mol%, in a range from about 5 mol% to about 6.4 mol%, in a range from about 5 mol% to about 6.2 mol%, in a range from about 5 mol% to about 6 mol%, in a range from about 5 mol% to about 5.8 mol%, in a range from about 5 mol% to about 5.6 mol%, in a range from about 5 mol% to about 5.4 mol%, or in a range from about 5 mol% to about 5.2 mol%, including all ranges and subranges therebetween. In specific embodiments, the glass may comprise CaO in a range from about 5.5 mol% to about 6.5 mol%, including all ranges and subranges therebetween.

The glass may comprise SrO in a range from about 1.25 mol% to about 3.6 mol%, for example in a range from about 1.5 mol% to about 3.6 mol%, in a range from about 1.75 mol% to about 3.6 mol%, in a range from about 2 mol% to about 3.6 mol%, in a range from about 2.25 mol% to about 3.6 mol%, in a range from about 2.5 mol% to about 3.6 mol%, in a range from about 2.75 mol% to about 3.6 mol%, in a range from about 3 mol% to about 3.6 mol%, or in a range from about 3.25 mol% to about 3.6 mol%, including all ranges and subranges therebetween. In specific embodiments, the glass may comprise SrO in an amount in a range from about 1.5 mol% to about 3.6 mol%, including all ranges and subranges therebetween.

The glass may comprise BaO in a range from about 0.5 mol% to about 2 mol%, for example in a range from about 0.75 mol% to about 2 mol%, in a range from about 1 mol% to about mol% 2, in a range from about 1.25 mol% to about 2 mol%, in a range from about 1.5 mol% to about 2 mol%, or in a range from about 1.75 mol% to about 2 mol%, including all ranges and subranges therebetween. In specific embodiments, the glass may comprise BaO in an amount in a range from about 0.7 mol% to about 1.8 mol%, including all ranges and subranges therebetween.

The glass may include RO (i.e., MgO, CaO, SrO, and BaO) such that $(MgO+CaO+SrO+BaO)/Al_2O_3$ may be in a range from about 1.10 to about 1.14, in a range from about 1.12 to about 1.14, or in a range from about 1.13 to about 1.14, including all ranges and subranges therebetween.

The glass may comprise NiO in a range from about 0.05 mol% to about 0.15 mol%, for example in a range from about 0.075 mol% to about 0.15 mol%, in a range from about 0.1 mol% to about 0.15 mol%, or in a range from about 0.125 mol% to about 0.15 mol%, including all ranges and subranges therebetween.

The glass may comprise $Co_3O_4$ in a range from about 0.01 mol% to about 0.05 mol%, for example in a range from about 0.02 mol% to about 0.05 mol%, in a range from about 0.03 mol% to about 0.05 mol%, or in a range from about 0.04 mol% to about 0.05 mol%, including all ranges and subranges therebetween.

The glass may contain $Fe_2O_3$ in an amount equal to or less than about 0.02 mol%, such as equal to or less than about 0.01 mol%.

The glass may be substantially free of alkali metal oxides.

The glass may have an anneal point in a range from about 760°C to about 765°C, for example in a range from about 763°C to about 765°C.

The glass may comprise a strain point in a range from about 700°C to about 720°C, for example in a range from about 710°C to about 720°C, including all ranges and subranges therebetween.

The glass may comprise a Young's modulus in a range from about 75 to about 83 GP, for example in a range from about 76 GPa to about 83 GPa, in a range from about 78 GPa to about 83 GPa, or in a range from about 80 GPa to about 83 GPa, including all ranges and subranges therebetween. In further embodiments, the glass may comprise a Young's modulus in a range from about 75 GPa to about 80 GPa, in a range from about 75 GPa to about 78 GPa, or in a range from about 75 GPa to about 76 GPa, including all ranges and subranges therebetween. In specific embodiments, the glass may comprise a Young's modulus in a range from about 78.3 GPa to about 82.4 GPa, including all ranges and subranges therebetween.

The glass may have a $T_{200P}$ equal to or less than about 1680°C, for example in a range from about 1600°C to about 1680°C, in a range from about 1610°C to about 1680°C, in a range from about 1620°C to about 1680°C, or in a range from about 1630°C to about 1680°C, in a range from about 1640°C to about 1680°C, in a range from about 1650°C to about 1680°C, in a range from about 1660°C to about 1680°C, or in a range from about 1670°C to about 1680°C including all ranges and subranges therebetween. In further embodiments, $T_{200P}$ may be in a range from about 1600°C to about 1670°C, in a range from about 1600°C to about 1660°C, in a range from about 1600°C to about 1650°C, in a range from about 1600 °C to about 1640°C, or in a range from about 1600°C to about 1630°C, including all ranges and subranges therebetween. In specific embodiments, $T_{200P}$ may be in a range from about 1608°C to about 1639°C, including all ranges and subranges therebetween.

In embodiments, the temperature of the glass at a viscosity of about 35,000 poise ($T_{35kP}$) may be in a range from about 1230°C to about 1270°C, in a range from about 1240°C to about 1270°C, in a range from about 1250°C to about 1270°C, or in a range from about 1260°C to about 1270°C, including all ranges and subranges therebetween. In further embodiments, the glass may comprise a $T_{35kP}$ in a range from about 1230°C to about 1260°C, in a range from about 1230°C to about 1250°C, or in a range from about 1230°C to about 1240°C, including all ranges and subranges therebetween. In specific embodiments, $T_{35kP}$ may be in a range from about 1238°C to about 1264°C, including all ranges and subranges therebetween.

In embodiments, the glass may have a $T_{liq}$ in a range from about 1135°C to about 1185°C, for example in a range from about 1135°C to about 1175°C, in a range from about 1135°C to about 1165°C, in a range from about 1135°C to about 1155°C, or in a range from about 1135°C to about 1145°C, including all ranges and subranges therebetween. In further embodiments, $T_{liq}$ may be in a range from about 1145°C to about 1185°C, in a range from about 1155°C to about 1185°C, in a range from about 1165°C to about 1185°C, or in a range from about 1175°C to about 1185°C, including all ranges and subranges therebetween.

The glass may exhibit a liquidus viscosity at the liquidus temperature in a range from about 200 kP to about 390 kP, for example in a range from about 250 kP to about 390 kP, in a range from about 300 kP to about 390 kP, or in a range from about 350 kP to about 390 kP, including all ranges and subranges therebetween. In further embodiments, the glass may comprise a liquidus viscosity in a range from about 200 kP to about 350 kP, in a range from about 200 kP to about 300 kP, or in a range from about 200 kP to about 250 kP, including all ranges and subranges therebetween.

The glass may have a linear coefficient of thermal expansion (over a temperature range from 0°C to 300°C) in a range from about $33\times10^{-7}$/°C to about $40\times10^{-7}$/°C, in a range from about $33\times10^{-7}$/°C to about $39\times10^{-7}$/°C, in a range from about $33\times10^{-7}$/°C to about $38\times10^{-7}$/°C, in a range from about $33\times10^{-7}$/°C to about $37\times10^{-7}$/°C, in a range from about $33\times10^{-7}$/°C to about $36\times10^{-7}$/°C, in a range from about $33\times10^{-7}$/°C to about $35\times10^{-7}$/°C, or in a range from about $33\times10^{-7}$/°C to about $34\times10^{-7}$/°C, including all ranges and subranges therebetween. In further embodiments, the glass may comprise a coefficient of thermal expansion in a range from about $34\times10^{-7}$/°C to about $40\times10^{-7}$/°C, in a range from about $35\times10^{-7}$/°C to about $40\times10^{-7}$/°C, in a range from about $36\times10^{-7}$/°C to about $40\times10^{-7}$/°C, in a range from about $37\times10^{-7}$/°C to about $40\times10^{-7}$/°C, in a range from about $38\times10^{-7}$/°C to about $40\times10^{-7}$/°C, or in a range from about $39\times10^{-7}$/°C to about $40\times10^{-7}$/°C, including all ranges and subranges therebetween.

The glass may have a density in a range from about 2.5 g/cc$^3$ to about 2.6 g/cc$^3$, for example in a range from about 2.52 g/cc$^3$ to about 2.6 g/cc$^3$, in a range from about 2.54 g/cc$^3$ to about 2.6 g/cc$^3$, in a range from about 2.56 g/cc$^3$ to about 2.6 g/cc$^3$, or in a range from about 2.58 g/cc$^3$ to about 2.6 g/cc$^3$, including all ranges and subranges therebetween. In specific embodiments, the glass may comprise a density in a range from about 2.52 g/cc$^3$ to about 2.54 g/cc$^3$.

The glass may have an average transmittance in a range from about 63% to about 80%, for example in a range from about 63% to about 78%, in a range from about 63% to about 76%, in a range from about 63% to about 74%, in a range from about 63% to about 72%, in a range from about 63% to about 70%, in a range from about 63% to about 68%, or in a range from about 63% to about 66%, including all ranges and subranges therebetween. In further embodiments, the glass may have an average transmittance in a range from about 66% to about 80%, in a range from about 68% to about 80%, in a range from about 70% to about 80%, in a range from about 72% to about 80%, in a range from about 74% to about 80%, or in a range from about 76% to about 80%, in a range from about 78% to about 80%, including all ranges and subranges therebetween.

Exemplary reduced optical transmittance glasses are listed in the following Tables 1-5. All glass constituents are listed in mole percent (mol%) on an oxide basis. The glasses were melted and formed into glass sheets with a thickness of 0.7 mm. The glasses include the addition of transition metal oxides, in particular NiO and $Co_3O_4$, to reduce the optical transmittance of the glasses. Optical transmittance was measured with an optical power meter. FIG. 6 is a plot of optical transmittance for glasses S1-S9 from Table 1.

Table 1

| | S1 | S2 | S3 | S4 | S5 | S6 | S7 | S8 | S9 |
|---|---|---|---|---|---|---|---|---|---|
| $SiO_2$ | 70.36 | 70.36 | 70.36 | 70.36 | 70.36 | 70.36 | 70.36 | 70.36 | 70.36 |
| $Al_2O_3$ | 13.23 | 13.23 | 13.23 | 13.23 | 13.23 | 13.23 | 13.23 | 13.23 | 13.23 |
| $B_2O_3$ | 1.62 | 1.62 | 1.62 | 1.62 | 1.62 | 1.62 | 1.62 | 1.62 | 1.62 |
| MgO | 4.27 | 4.27 | 4.27 | 4.27 | 4.27 | 4.27 | 4.27 | 4.27 | 4.27 |
| CaO | 5.64 | 5.64 | 5.64 | 5.64 | 5.64 | 5.64 | 5.64 | 5.64 | 5.64 |
| SrO | 1.19 | 1.19 | 1.19 | 1.19 | 1.19 | 1.19 | 1.19 | 1.19 | 1.19 |
| BaO | 3.56 | 3.56 | 3.56 | 3.56 | 3.56 | 3.56 | 3.56 | 3.56 | 3.56 |
| $SnO_2$ | 0.12 | 0.12 | 0.12 | 0.12 | 0.12 | 0.12 | 0.12 | 0.12 | 0.12 |
| NiO | 0.055 | 0.065 | 0.065 | 0.045 | 0.055 | 0.045 | 0.045 | 0.035 | 0.025 |

(continued)

|  | S1 | S2 | S3 | S4 | S5 | S6 | S7 | S8 | S9 |
|---|---|---|---|---|---|---|---|---|---|
| $Co_3O_4$ | 0.013 | 0.013 | 0.011 | 0.013 | 0.011 | 0.011 | 0.009 | 0.009 | 0.009 |
| F02-L* @ 0.7 mm | 90.76 | 90.32 | 91.5 | 91.17 | 91.17 | 91.0 | 91.88 | 92.32 | 92.71 |
| F02-a* @ 0.7 mm | -0.42 | -0.37 | -0.27 | -0.46 | -0.3 | -0.36 | -0.26 | -0.31 | -0.34 |
| F02-b* @ 0.7 mm | -0.5 | 0.16 | 0.88 | -1.24 | 0.24 | -0.54 | 0.2 | -0.5 | -1.13 |
| Average Transmittance (400 nm - 700 nm) @0.7 mm | 79.4 | 78.4 | 79.6 | 80.4 | 80.7 | 81.7 | 82.4 | 83.3 | 84.5 |
| Average Transmittance (450 nm - 650 nm) @0.7 mm | 77.8 | 76.7 | 78.1 | 78.8 | 79.3 | 80.3 | 81.2 | 82.2 | 83.5 |
| Max Transmittance (400 nm -700 nm) @0.7 mm | 87.5 | 86.8 | 87.5 | 88.2 | 87.7 | 88.3 | 88.3 | 88.8 | 89.6 |
| Max Transmittance (450 nm -650 nm) @0.7 mm | 79.4 | 78.4 | 79.8 | 80.4 | 80.8 | 81.7 | 82.4 | 83.4 | 84.6 |

Table 2

|  | S10 | S11 | S12 | S13 | S14 | S15 |
|---|---|---|---|---|---|---|
| $SiO_2$ | 70.30 | 70.33 | 70.27 | 70.29 | 70.05 | 70.18 |
| $Al_2O_3$ | 13.23 | 13.21 | 13.21 | 13.24 | 13.31 | 13.29 |
| $B_2O_3$ | 1.58 | 1.60 | 1.61 | 1.62 | 1.59 | 1.59 |
| MgO | 4.30 | 4.29 | 4.32 | 4.27 | 4.35 | 4.33 |
| CaO | 5.64 | 5.62 | 5.64 | 5.62 | 5.71 | 5.65 |
| SrO | 1.18 | 1.18 | 1.18 | 1.18 | 1.18 | 1.18 |
| BaO | 3.56 | 3.56 | 3.56 | 3.55 | 3.58 | 3.56 |
| $SnO_2$ | 0.12 | 0.12 | 0.13 | 0.12 | 0.13 | 0.13 |
| NiO | 0.077 | 0.085 | 0.094 | 0.103 | 0.122 | 0.128 |
| $Co_3O_4$ | 0.025 | 0.029 | 0.030 | 0.034 | 0.037 | 0.037 |
| F02-L* @ 0.7 mm | 87.48 | 86.26 | 86.04 | 84.69 | 84.49 | 84.05 |
| F02-a* @ 0.7 mm | -0.72 | -0.81 | -0.80 | -0.86 | -0.87 | -0.86 |
| F02-b* @ 0.7 mm | -1.89 | -2.25 | -2.00 | -2.29 | -2.30 | 1.85 |
| Young's Modulus, GPa |  |  |  |  |  |  |
| Refractive Index | 1.528 | 1.528 | 1.529 | 1.529 | 1.529 | 1.530 |
| Liquidus Temperature, °C | 1210 | 1210 | 1205 | 1200 | 1210 | 1210 |
| T(200P), °C |  | 1660 |  | 1652 |  |  |
| T(35kP), °C |  | 1276 |  | 1275 |  |  |
| Liquidus Viscosity, Poise |  | 140917 |  | 173918 |  |  |
| Average Transmittance (450 nm - 650 nm) @0.7 mm | 72.07 | 70.34 | 68.33 | 60.60 | 58.71 | 58.96 |

Table 3

|  | S16 | S17 | S18 | S19 | S20 | S21 | S22 | S23 | S24 |
|---|---|---|---|---|---|---|---|---|---|
| $SiO_2$ | 73.04 | 70.47 | 70.42 | 67.22 | 63.74 | 67.50 | 68.66 | 67.45 | 71.11 |

(continued)

|  | S16 | S17 | S18 | S19 | S20 | S21 | S22 | S23 | S24 |
|---|---|---|---|---|---|---|---|---|---|
| $Al_2O_3$ | 10.72 | 13.21 | 9.01 | 11.59 | 12.25 | 12.58 | 12.43 | 13.11 | 12.31 |
| $B_2O_3$ | 0.20 | 1.76 | 11.45 | 7.52 | 8.16 | 6.32 | 4.42 | 4.74 | 1.31 |
| MgO | 7.15 | 3.75 | 0.98 | 1.47 | 5.56 | 3.64 | 4.50 | 4.82 | 5.32 |
| CaO | 3.97 | 4.93 | 7.37 | 10.94 | 6.87 | 5.26 | 5.53 | 6.32 | 4.60 |
| SrO | 1.50 | 1.22 | 0.54 | 1.03 | 3.15 | 4.53 | 3.45 | 1.52 | 1.34 |
| BaO | 3.11 | 4.31 | 0.00 | 0.00 | 0.00 | 0.00 | 0.72 | 1.74 | 3.67 |
| $Fe_2O_3$ | 0.01 | 0.01 | 0.01 | 0.01 | 0.01 | 0.01 | 0.01 | 0.01 | 0.01 |
| $SnO_2$ | 0.09 | 0.10 | 0.07 | 0.08 | 0.00 | 0.00 | 0.11 | 0.11 | 0.11 |
| NiO | 0.103 | 0.106 | 0.099 | 0.1 | 0.101 | 0.101 | 0.103 | 0.105 | 0.107 |
| $Co_3O_4$ | 0.036 | 0.038 | 0.033 | 0.033 | 0.034 | 0.035 | 0.035 | 0.036 | 0.039 |
| $RO/Al_2O_3$ | 1.47 | 1.08 | 0.99 | 1.16 | 1.27 | 1.07 | 1.14 | 1.10 | 1.21 |
| Anneal (fiber), °C | 805 | 803 | 723 | 745 | 725 | 754 | 765 | 763 | 803 |
| Strain (fiber), °C | 751 | 748 | 667 | 693 | 676 | 701 | 711 | 711 | 751 |
| CTE (fiber), $x10^{-7}$ | 34.6 | 35.5 | 30 | 35.8 | 35.9 | 34.4 | 34.5 | 34.1 | 34.9 |
| Density, $g/cc^3$ | 2.583 | 2.616 | 2.343 | 2.449 | 2.497 | 2.505 | 2.527 | 2.531 | 2.591 |
| Young's Modulus | 84.30 | 82.66 | 69.48 | 77.69 | 79.93 | 79.46 | 81.52 | 82.41 | 82.63 |
| Temp (200P), °C | 1696 | 1681 | 1590 | 1675 | 1530 | 1606 | 1639 | 1608 | |
| Temp (35kP), °C | 1305 | 1298 | 1216 | 1255 | 1179 | 1237 | 1264 | 1238 | |
| Liquidus Viscosity (internal), Poise | 69839 | 340282 | 627801 | 203233 | 121171 | 269133 | 207246 | 380112 | |
| Liquidus Temperature , °C | 1270 | 1195 | 1095 | 1165 | 1125 | 1155 | 1185 | 1135 | 1225 |
| Av. Transmittan ce % (450-650 nm) @0.7 mm | 60.60 | 64.05 | 69.04 | 64.78 | 63.06 | 64.50 | 63.80 | 63.09 | 65.39 |

Table 4

|  | S25 | S26 | S27 | S28 | S29 | S30 | S31 | S32 | S33 |
|---|---|---|---|---|---|---|---|---|---|
| $SiO_2$ | 68.93 | 61.67 | 66.37 | 71.08 | 68.94 | 65.57 | 67.84 | 71.74 | 68.90 |
| $Al_2O_3$ | 10.21 | 13.65 | 13.15 | 12.31 | 10.24 | 12.40 | 12.85 | 10.83 | 13.48 |
| $B_2O_3$ | 9.44 | 7.70 | 4.51 | 1.31 | 9.45 | 7.59 | 4.52 | 0.20 | 1.77 |
| MgO | 1.20 | 5.88 | 5.30 | 5.46 | 1.19 | 4.55 | 4.70 | 7.99 | 4.05 |
| CaO | 9.20 | 6.78 | 6.44 | 4.62 | 9.22 | 5.97 | 5.95 | 4.26 | 5.57 |
| SrO | 0.77 | 4.12 | 2.54 | 1.34 | 0.78 | 3.83 | 2.52 | 1.53 | 1.23 |
| BaO | 0.00 | 0.00 | 1.41 | 3.61 | 0.00 | 0.00 | 1.39 | 3.21 | 4.68 |

(continued)

|  | S25 | S26 | S27 | S28 | S29 | S30 | S31 | S32 | S33 |
|---|---|---|---|---|---|---|---|---|---|
| $Fe_2O_3$ | 0.01 | 0.01 | 0.01 | 0.01 | 0.01 | 0.01 | 0.01 | 0.01 | 0.01 |
| $SnO_2$ | 0.08 | 0.00 | 0.11 | 0.11 | 0.08 | 0.00 | 0.11 | 0.10 | 0.11 |
| NiO | 0.101 | 0.116 | 0.108 | 0.058 | 0.053 | 0.052 | 0.056 | 0.058 | 0.060 |
| $Co_3O_4$ | 0.033 | 0.039 | 0.037 | 0.017 | 0.013 | 0.013 | 0.015 | 0.016 | 0.019 |
| $RO/Al_2O_3$ | 1.09 | 1.23 | 1.19 | 1.22 | 1.09 | 1.16 | 1.13 | 1.57 | 1.15 |
| Anneal (fiber), °C | 736 | 713 | 763 | 804 | 738 | 747 | 763 | 803 | 801 |
| Strain (fiber), °C | 682 | 688 | 711 | 752 | 682 | 695 | 711 | 752 | 748 |
| CTE (fiber) x$10^{-7}$ | 32.6 | 35.2 | 34.9 | 34.7 | 32.8 | 35.8 | 33.9 | 34.9 | 35.5 |
| Density, g/cc$^3$ | 2.391 | 2.489 | 2.540 | 2.590 | 2.388 | 2.489 | 2.544 | 2.581 | 2.620 |
| Young's Modulus | 73.14 | 80.55 | 78.30 | 82.47 | 73.09 | 78.88 | 79.75 | 84.323 | 81.907 |
| Temp (200P), °C |  |  |  |  |  |  |  |  |  |
| Temp (35kP), °C |  |  |  |  |  |  |  |  |  |
| Liquidus Viscosity (internal), Poise |  |  |  |  |  |  |  |  |  |
| Liquidus Temperatur e, °C | 1160 | 1150 | 1160 | 1215 | 1130 | 1130 | 1175 | 1290 | 1225 |
| Av. Transmittan ce, % (450-650 nm) @0.7 mm | 68.07 | 68.30 | 65.36 | 79.12 | 79.79 | 79.98 | 78.45 | 75.81 | 76.97 |

Table 5

|  | S34 | S35 | S36 | S37 | S38 | S39 |
|---|---|---|---|---|---|---|
| $SiO_2$ | 70.50 | 66.64 | 66.57 | 66.09 | 67.31 | 68.22 |
| $Al_2O_3$ | 9.00 | 11.68 | 11.43 | 13.09 | 13.00 | 12.84 |
| $B_2O_3$ | 11.45 | 7.54 | 8.11 | 6.34 | 4.47 | 4.76 |
| MgO | 0.96 | 1.59 | 4.58 | 4.15 | 4.91 | 4.50 |
| CaO | 7.38 | 11.34 | 6.20 | 5.56 | 5.74 | 6.19 |
| SrO | 0.54 | 1.03 | 3.01 | 4.66 | 3.59 | 1.51 |
| BaO | 0.00 | 0.00 | 0.00 | 0.00 | 0.74 | 1.76 |
| $Fe_2O_3$ | 0.01 | 0.01 | 0.01 | 0.01 | 0.01 | 0.01 |
| $SnO_2$ | 0.08 | 0.07 | 0.00 | 0.00 | 0.11 | 0.10 |
| NiO | 0.055 | 0.054 | 0.050 | 0.058 | 0.059 | 0.055 |
| $Co_3O_4$ | 0.013 | 0.014 | 0.012 | 0.014 | 0.015 | 0.015 |
| $RO/Al_2O_3$ | 0.99 | 1.20 | 1.21 | 1.10 | 1.15 | 1.09 |
| Anneal (fiber), °C | 723 | 743 | 750 | 748 | 764 | 763 |
| Strain (fiber), °C | 667 | 692 | 697 | 695 | 711 | 711 |
| CTE (fiber) x$10^{-7}$ | 29.9 | 35.2 | 36.4 | 33.6 | 34.7 | 33.9 |
| Density, g/cc$^3$ | 2.338 | 2.439 | 2.479 | 2.493 | 2.519 | 2.526 |
| Young's Modulus, GPa | 69.1 | 76.921 | 79.476 | 78.787 | 80.678 | 80.65 |
| Temp (200P), °C |  |  |  |  |  |  |
| Temp (35kP), °C |  |  |  |  |  |  |

(continued)

|  | S34 | S35 | S36 | S37 | S38 | S39 |
|---|---|---|---|---|---|---|
| Liquidus Viscosity (internal), Poise |  |  |  |  |  |  |
| Liquidus Temperature, °C | 1080 | 1185 | 1140 | 1145 | 1200 | 1165 |
| Av. Transmittance (450-650 nm) @0.7 mm | 81.14 | 77.40 | 77.13 | 79.47 | 80.00 | 78.88 |

Compositions of the glasses set forth in Tables 1-5 can be determined using quantitative analysis techniques well known in the art. Suitable techniques are X-ray fluorescence spectrometry (XRF) for elements with an atomic number higher than 8, inductively coupled plasma optical emission spectrometry (ICP-OES), inductively coupled plasma mass spectrometry (ICP-MS), and electron microprobe analysis. See, for example, J. Nolte, ICP Emission Spectrometry: A Practical Guide, Wiley-VCH (2003); H.E. Taylor, Inductively Coupled Plasma Mass Spectroscopy: Practices and Techniques, Academic Press (2000); and S.J.B. Reed, Electron Microprobe Analysis, Cambridge University Press; 2nd edition (1997).

The glass properties set forth in Tables 1-5 were determined in accordance with techniques conventional in the glass art. Thus, the linear coefficient of thermal expansion (CTE) over the temperature range 0-300°C is expressed in terms of x $10^{-7}$/°C and the anneal and strain points are expressed in terms of °C. These were determined from fiber elongation techniques (ASTM references E228-85 and C336, respectively). The density in terms of grams/$cm^3$ was measured via the Archimedes method (ASTM C693). The melting temperature in terms of °C (defined as the temperature $T_{200P}$ at which the glass melt demonstrates a viscosity of 200 poise) was calculated employing a Fulcher equation fit to high temperature viscosity data measured via rotating cylinders viscometry (ASTM C965-81).

The liquidus temperature of the glass in terms of °C was measured using the standard gradient boat liquidus method of ASTM C829-81. This involves placing crushed glass particles in a platinum boat, placing the boat in a furnace having a region of gradient temperatures, heating the boat in an appropriate temperature region for 24 hours, and determining by means of microscopic examination the highest temperature at which crystals appear in the interior of the glass. More particularly, the glass sample is removed from the Pt boat in one piece and examined using polarized light microscopy to identify the location and nature of crystals that have formed against the Pt and air interfaces, and in the interior of the sample. Because the gradient of the furnace is very well known, temperature vs. location can be well estimated, within 5-10°C. The temperature at which crystals are observed in the internal portion of the sample is taken to represent the liquidus of the glass (for the corresponding test period). Testing is sometimes carried out at longer times (e.g., 72 hours), to observe slower growing phases. The liquidus viscosity in poise was determined from the liquidus temperature and the coefficients of the Fulcher equation.

Young's modulus values in terms of GPa were determined using a resonant ultrasonic spectroscopy technique of the general type set forth in ASTM E1875-00e1.

Raw materials appropriate for producing exemplary glasses disclosed herein include commercially available sands as sources for $SiO_2$; alumina, aluminum hydroxide, hydrated forms of alumina, and various aluminosilicates, nitrates and halides as sources for $Al_2O_3$; boric acid, anhydrous boric acid and boric oxide as sources for $B_2O_3$; periclase, dolomite (also a source of CaO), magnesia, magnesium carbonate, magnesium hydroxide, and various forms of magnesium silicates, aluminosilicates, nitrates and halides as sources for MgO; limestone, aragonite, dolomite (also a source of MgO), wolastonite, and various forms of calcium silicates, aluminosilicates, nitrates and halides as sources for CaO; and oxides, carbonates, nitrates and halides of strontium and barium. If a chemical fining agent is desired, tin can be added as $SnO_2$, as a mixed oxide with another major glass component (e.g., $CaSnO_3$), or in oxidizing conditions as SnO, tin oxalate, tin halide, or other compounds of tin known to those skilled in the art.

In addition to the elements deliberately incorporated into exemplary glasses, nearly all stable elements in the periodic table are present in glasses at some level, either through low levels of contamination in the raw materials, through high-temperature erosion of refractories and precious metals in the manufacturing process, or through deliberate introduction at low levels to fine tune the attributes of the final glass. For example, zirconium may be introduced as a contaminant via interaction with zirconium-rich refractories. As a further example, platinum and rhodium may be introduced via interactions with precious metals incorporated into the glass manufacturing apparatus. As a further example, iron may be introduced as a tramp component in raw materials, or deliberately added to enhance control of gaseous inclusions. As a further example, manganese may be introduced to control color or to enhance control of gaseous inclusions. As a further example, alkalis may be present as a tramp component at levels up to about 0.1 mol% for the combined concentration of $Li_2O$, $Na_2O$, and $K_2O$.

Hydrogen is inevitably present in the form of the hydroxyl anion, $OH^-$, and its presence can be ascertained via standard infrared spectroscopy techniques. Dissolved hydroxyl ions significantly and nonlinearly impact the anneal point of exemplary glasses, and thus to obtain the desired anneal point it may be necessary to adjust the concentrations of major oxide components to compensate. Hydroxyl ion concentration can be controlled to some extent through choice of raw materials or choice of melting system. For example, boric acid is a major source of hydroxyls, and replacing boric acid with boric oxide can be a useful means to control hydroxyl concentration in the final glass. The same reasoning applies to other potential raw materials comprising hydroxyl ions, hydrates, or compounds comprising physisorbed or chemisorbed water molecules. If burners are used in the melting process, then hydroxyl ions can also be introduced through the combustion products from combustion of natural gas and related hydrocarbons, and thus it may be desirable to shift the energy used in melting from burners to electrodes to compensate. Alternatively, one might instead employ an iterative process of adjusting major oxide components so as to compensate for the deleterious impact of dissolved hydroxyl ions.

Sulfur is often present in natural gas, and likewise is a tramp component in many carbonate, nitrate, halide, and oxide raw materials. In the form of $SO_2$, sulfur can be a troublesome source of gaseous inclusions. The tendency to form $SO_2$-rich defects can be managed to a significant degree by controlling sulfur levels in the raw materials, and by incorporating low levels of comparatively reduced multivalent cations into the glass matrix. While not wishing to be bound by theory, it appears $SO_2$-rich gaseous inclusions arise primarily through reduction of sulfate ($SO_4^=$) dissolved in the glass. The elevated barium concentrations of exemplary glasses appear to increase sulfur retention in the glass in early stages of melting, but as noted above, barium is used to obtain low liquidus temperature, and hence high $T_{35k}$-$T_{liq}$ and high liquidus viscosity. Deliberately controlling sulfur levels in raw materials to a low level is a useful means of reducing dissolved sulfur (presumably as sulfate) in the glass. In particular, sulfur is preferably less than 200 ppm by weight in the batch materials, and more preferably less than 100 ppm by weight in the batch materials.

Reduced multivalent oxides can also be used to control the tendency of exemplary glasses to form $SO_2$ blisters. While not wishing to be bound to theory, these elements behave as potential electron donors that suppress the electromotive force for sulfate reduction. Sulfate reduction can be written in terms of a half reaction such as

$$SO_4^= \rightarrow SO_2 + O_2 + 2e^-$$

where $e^-$ denotes an electron. The "equilibrium constant" for the half reaction is

$$K_{eq} = [SO_2][O_2][e^-]^2/[SO_4^=]$$

where the brackets denote chemical activities. Ideally, one would like to force the reaction and create sulfate from $SO_2$, $O_2$, and $2e^-$. Adding nitrates, peroxides, or other oxygen-rich raw materials may help, but also may work against sulfate reduction in the early stages of melting, which may counteract the benefits of adding them in the first place. $SO_2$ has very low solubility in most glasses, and so is impractical to add to the glass melting process. Electrons may be "added" through reduced multivalents. For example, an appropriate electron-donating half reaction for ferrous iron ($Fe^{2+}$) is expressed as

$$2Fe^{2+} \rightarrow 2Fe^{3+} + 2e^-.$$

This "activity" of electrons can force the sulfate reduction reaction to the left, stabilizing $SO_4^=$ in the glass. Suitable reduced multivalents include, but are not limited to, $Fe^{2+}$, $Mn^{2+}$, $Sn^{2+}$, $Sb^{3+}$, $As^{3+}$, $V^{3+}$, $Ti^{3+}$, and others familiar to those skilled in the art. In each case, it may be important to minimize the concentrations of such components to avoid a deleterious impact on the color of the glass, or in the case of As and Sb, to avoid adding such components at a high enough level to complicate waste management in an end-user's process.

In addition to the major oxide components of exemplary glasses, and the minor or tramp constituents noted above, halides may be present at various levels, either as contaminants introduced through the choice of raw materials, or as deliberate components used to eliminate gaseous inclusions in the glass. Halides may be incorporated as a fining agent at a level of about 0.4 mol% or less, although it is generally desirable to use lower amounts to avoid corrosion of off-gas handling equipment. In some embodiments, the concentrations of individual halide elements are below about 200 ppm by weight for each individual halide, or below about 800 ppm by weight for the sum of all halide elements.

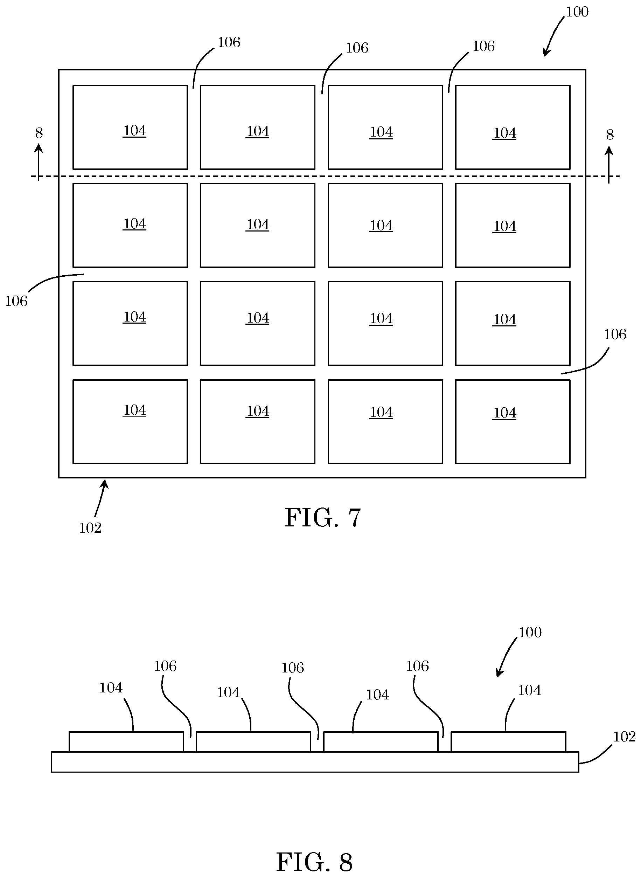

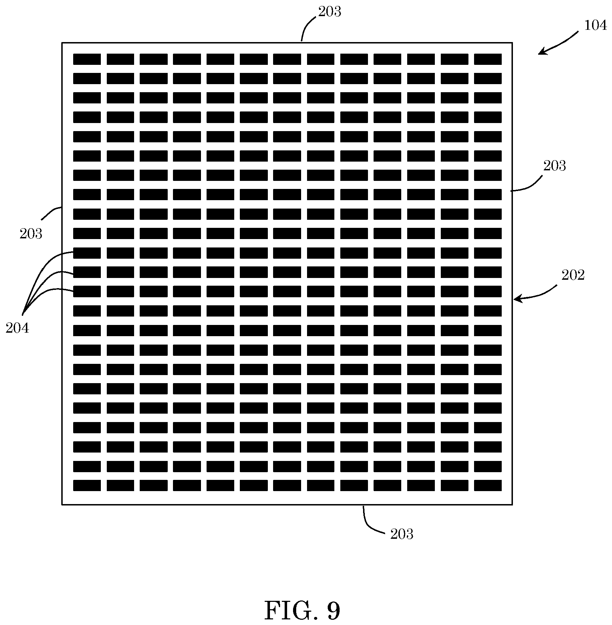

Referring now to FIGS. 7 and 8, a top view and a simplified cross-sectional view, respectively, of another exemplary large area display 100 are depicted. Large area display 100 includes a base plate 102 and a plurality of small format displays 104 arranged on base plate 102. Each small format display 104 may be a micro-LED display, such as a top-emission micro-LED display or a bottom-emission micro-LED display. Between the edges of the adjacent small format displays 104 are seams 106. As described in more detail below with reference to FIGS. 9-11, light emitted from small format displays 104 may leak from the edges of the small format displays at seams 106, resulting in visible seams when the large area display 100 is turned on.

Base plate 102 may be a glass substrate, a printed circuit board, or another suitable substrate including circuitry for routing power and signals to each small format display 104 to control the operation of each micro-LED of each small format display 104. Base plate 102 may, for example, be attached to small format displays 104 using fasteners and/or an adhesive material. While in this embodiment, large area display 100 includes 16 small format displays 104 arranged in four rows and four columns, in other embodiments, large area display 100 may include any suitable number of small format displays 104 arranged in any suitable numbers of rows and columns.

FIG. 9 is a top view of an exemplary small format display 104. Small format display 104 includes a backplane 202 and a plurality of pixels 204 electrically coupled to backplane 202. Each pixel 204 may include one, two, three, four, or more micro-LEDs to provide a monochrome or color display. Backplane 202 may be a glass substrate or printed circuit board including circuitry for routing power and signals to each pixel 204 to control the operation of each micro-LED of each pixel 204. Small format display 104 includes four edges 203 where light emitted by the display pixels may leak out. While in this embodiment small format display 104 includes 23 rows and 13 columns of pixels 204, in other embodiments, small format display 104 may include any suitable numbers of rows and columns of pixels.

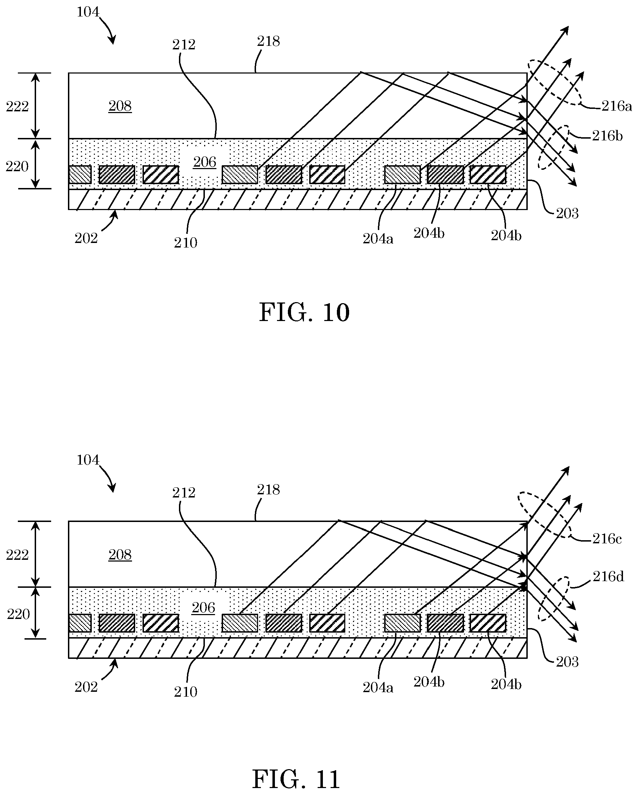

FIGS. 10 and 11 are simplified cross-sectional views of the exemplary small format display 104 of FIG. 9. In addition to backplane 202 and pixels 204, small format display 104 includes an optically clear adhesive (OCA) layer 206 and a glass layer (e.g., glass cover plate) 208. As used herein, an optically clear adhesive is an adhesive that is in an optical path, has a defined refractive index, high transmission, and makes a reliable bond between components. In this example, each pixel 204 includes a first (e.g., blue) microLED 204a, a second (e.g., green) microLED 204b, and a third (e.g., red) micro-LED 204c to provide a full color display. Thus, small format display 104 includes a plurality of microLEDs electrically coupled to the backplane 202. Each micro-LED 204a, 204b, 204c is electrically coupled to circuitry (not shown) on backplane 202 for controlling the operation of each microLED. In this embodiment, the plurality of microLEDs are top emission microLEDs, such that most of the light emitted by the microLEDs passes through the top of small format display 104. In embodiments, backplane 202 may comprise a glass substrate with an array of thin film transistors (TFTs) formed thereon, each TFT electrically coupled to a microLED. In other embodiments, backplane 202 may include a printed circuit board or another suitable substrate.

OCA layer 206 may include phenyl silicone or another suitable material, such as Norland Optical Adhesive 60 available from Norland Products Inc. in Jamesburg, NJ, USA, Dymax OP-60, available from Dymax® in Torrington, CT, USA, or NTT GA700H, available from NTT Advanced Technology Corporation in Tokyo, Japan. OCA layer 206 is positioned proximate (e.g., over) backplane 202 and the plurality of microLEDs (204a, 204b, 204c), such as directly contacting a top surface 210 of backplane 202 and directly contacting and encapsulating the plurality of microLEDs. Glass layer 208 may include a glass such as aluminosilicate, alkali-aluminosilicate, borosilicate, alkali-borosilicate, aluminoborosilicate, alkali-aluminoborosilicate, soda lime, or other suitable glasses (e.g., Gorilla® glass, Ceramic Shield, EAGLE XG® glass). Glass layer 208 is proximate (e.g., over) OCA layer 206, such as directly contacting a top surface 212 of OCA layer 206. Glass layer 208 may be laminated to backplane 202 and the plurality of microLEDs via OCA layer 206 to protect the microLEDs and to enhance mechanical properties of small format display 104.

OCA layer 206 and glass layer 208 may cause edge light leakage through the edges 203 of small format display 104 through several different mechanisms. As illustrated in FIG. 10 at 216a, a first way that OCA layer 206 and glass layer 208 may cause edge light leakage through edges 203 of small format display 104 includes light that escapes from the side walls of the micro-LEDs and goes directly out of the edges of OCA layer 206 and/or glass layer 208. Because OCA layer 206 has a higher refractive index than air, compared to a display without OCA layer 206 and glass layer 208, more light is emitted from the microLED side walls in a display including OCA layer 206 and glass layer 208. Thus, OCA layer 206 and glass layer 208 enhance edge light leakage. As illustrated in FIG. 10 at 216b, a second way OCA layer 206 and glass layer 208 may cause edge light leakage through edges 203 of small format display 104 includes light that escapes from the side walls of the micro-LEDs and first goes to top surface 218 of glass layer 208, is reflected by the interface between air and glass layer 208 (e.g., mainly through Total Internal Reflection (TIR)), and then exits from edges 203 of the display.

As illustrated in FIG. 11 at 216c, a third way that OCA layer 206 and glass layer 208 may cause edge light leakage through edges 203 of small format display 104 includes light emitted from top surfaces of the microLEDs that goes directly out of edges 203 of OCA layer 206 and glass layer 208. As illustrated in FIG. 11 at 216d, a fourth way OCA layer 206 and glass layer 208 may cause edge light leakage through edges 302 of small format display 104 includes light emitted from top surfaces of the microLEDs and first goes to top surface 216 of glass layer 208, is reflected by the interface between air and glass layer 208 (e.g., mainly through TIR), and then exits from edges 203 of small format display 104.

Other phenomena that can be mitigated by the use of reduced transmittance glass described herein include halo or blooming, particularly noticeable with local dimming displays, such as full array local dimming LCD displays. Full array local dimming displays have LEDs positioned behind the entire display panel, the LEDs divided into local dimming zones. To depict a bright area in one region of the display, LEDs in the zone behind the bright area are turned on while LEDs in surrounding regions are dimmed or turned off. The halo effect occurs when light from the isolated bright area of the display bleeds into surrounding darker areas. This can result in muddy blacks.

In much the same way reduced transmittance glass can be used to mitigate light leakage in a bottom emission display apparatus, reduced transmittance glass can be used to mitigate against light leakage from a top emission display apparatus. That is, when the glass is employed as a cover glass plate, light leaking from light emitters (e.g., from internal reflections and/or edge emission from the light emitters), typically intersecting the glass cover plate at an oblique angle relative to the major surfaces of the glass cover plate, can reduce the intensity of the leaked light and increase contrast. Light transmitted directly from the light emitters is attenuated less than the leaked light since the travel distance of the light through the glass is less than the obliquely transmitted light. In embodiments, the cover glass plate may be laminated directly (without air gaps) to the light emitter backplane substrate, for example via an OCA layer. These phenomena are not limited to tiled displays.

Accordingly, disclosed herein are displays configured to suppress unwanted light emitted from both self-emissive displays (e.g., microLED displays) and LCD displays. The display may include an OCA layer 206 and a glass layer 208, wherein the unwanted light can be mitigated by adjusting the geometric design (e.g., thicknesses of glass layer 208 and/or OCA layer 206) and the optical properties (e.g., refractive index and transmittance (or absorbance)) of glass layer 208 and/or the OCA layer 206. By considering the performance of edge light leakage suppression and display brightness at a normal to the display, optimal designs can be determined by ray-tracing modeling. The transmittance and refractive index of OCA and glass layers may be adjusted by adjusting the material properties of the OCA and glass layers.

In embodiments, as further described below with reference to FIGS. 10 and 11, to suppress edge light leakage from small format display 104, OCA layer 206 may have a thickness 220 between top surface 210 of backplane 202 and top surface 212 of OCA layer 206 within a range from about 0.005 millimeters to about 0.2 millimeters, a transmittance (over the OCA layer thickness at about 550 nanometers) within a range from about 40% to about 95 percent, and a refractive index (at about 550 nanometers) within a range from about 1.1 to about 1.6. In other embodiments, thickness 220 of OCA layer 206 may be in a range from about 0.01 millimeters to about 0.1 millimeters. In other embodiments, the transmittance of OCA layer 206 may be in a range from about 50 percent to about 90 percent, for example in a range from about 60% to about 85%, or in a range from about 60% to about 80%. In other embodiments, the refractive index of OCA layer 206 may be in a range from about 1.2 to about 1.4.

In embodiments, glass layer 208 may have a thickness 222 between top surface 212 of OCA layer 206 and top surface 218 of glass layer 208 within a range from about 0.05 millimeters to about 2 millimeters, for example in a range from about 0.1 millimeters to about 0.3 millimeters. It has been observed that by employing a glass cover plate 208 comprising a reduced transmittance glass on a top emission display, such as the reduced transmittance glasses disclosed herein, the contrast ratio of the display may be improved. Accordingly, glass layer 208 (i.e., the glass cover plate) may have a transmittance (over the glass layer thickness at about 550 nanometers) within a range from about 40% to about 95%, for example within a range between about 40% and about 90 %, in a range from about 50% to about 90%, in a range from about 50% to about 85%, or in a range from about 60% to about 80%. The glass layer 208 may have a refractive index (at about 550 nanometers) within a range from about 1.4 to about 2.0, for example in a range from about 1.5 and about 1.7.

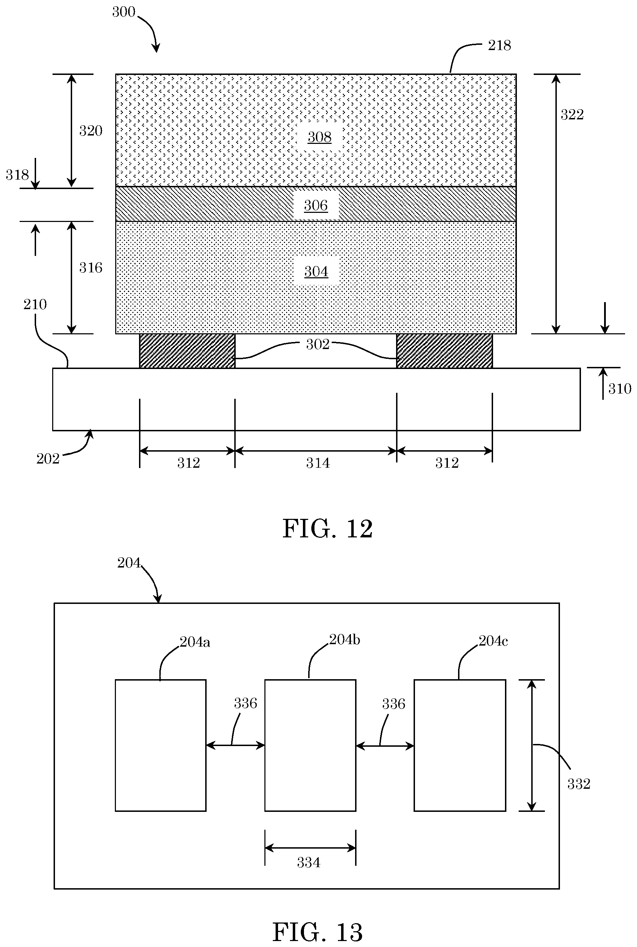

FIG. 12 is a side view of an exemplary microLED 300. In certain exemplary embodiments, microLED 300 may be used for microLED 204a, 204b, and/or 204c within each pixel 204 as previously described and illustrated with reference to FIGS. 9-11. MicroLED 300 may include contact pads 302 (e.g., metal pads), a bottom passivation layer 304, an active layer 306 (e.g., a Multiple Quantum Well (MQT) active layer), and a top passivation layer 308. Contact pads 302 are electrically coupled to top surface 210 of the backplane 202. The bottom surface of bottom passivation layer 304 contacts contact pads 302. The top surface of passivation layer 304 contacts the bottom surface of active layer 306. The top surface of active layer 306 contacts the bottom surface of top passivation layer 308. Each contact pad 302 may have a height (thickness) 310 of about 1 micrometer and a width 312 of about 10 micrometers. The distance 314 between contact pads 302 may be about 10 micrometers. The height (thickness) 316 of the bottom passivation layer 304 may be about 2.2 micrometers, the height (thickness) 318 of active layer 306 may be about 0.6 micrometers, and height 320 of top passivation layer 308 may be about 2.2 micrometers, such that the total height 322 Of microLED 300 may be about 5 micrometers. In other embodiments, microLED 300 may have other suitable dimensions.

FIG. 13 is a top view of an exemplary pixel 204 including microLEDs 204a, 204b, and 204c. Each microLED 204a, 204b, and 204c comprises a length 332 of about 30 micrometers and a width 334 of about 20 micrometers. The distance 336 between the microLEDs within the pixel 204 may be about 25 micrometers. In other embodiments, microLEDs 204a, 204b, and 204c and pixel 204 may have other suitable dimensions.

It should be clear that aspects described herein while discussed in relation to tiled displays may be applicable to singular display panels. For example, the use of reduced transmittance glass as a glass cover plate to improve contrast may be applicable to non-tiled display devices.

EXAMPLES

Example 1

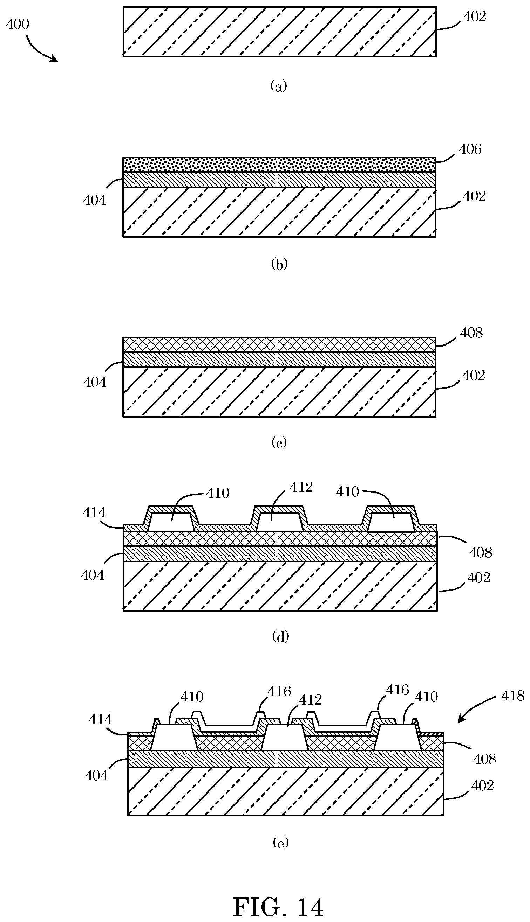

Poly-Si ring field effect transistors (FETs) were fabricated on Lotus NXT® glass wafers doped with Ni and Co and Lotus NXT® samples without Ni and Co as a reference. Three wafers were processed for each condition. The poly-Si ring FETs fabrication process 400 is shown in FIG. 14. Lotus NXT® Glass wafers 402 (FIG. 14(a)) were coated with a 100 nm $SiO_2$ layer 404 and a 60 nm a-Si layer 406, which were deposited on the glass wafers by a P5000 plasma-enhanced chemical vapor deposition (PECVD) at the same time without broken vacuum (FIG. 14(b)). The a-Si film was dehydrogenated at 450°C for one hour under vacuum, then annealed at 630°C for 12 hours to produce crystallization and a resultant poly silicon layer 408 over top the $SiO_2$ layer 404 (FIG. 14(c)). A 250-nanometer aluminum (Al) layer was sputter deposited, then patterned by photolithography to produce the source electrode 410 and drain electrode 412 (FIG. 14(d)). A 100 nanometer $SiO_2$ layer 414 was deposited as a gate insulator and a 250-nanometer Al layer was sputter deposited thereon. The top Al layer was patterned to form a top gate electrode 416, and the source and drain contacts were patterned. Finally, the devices were annealed at 450°C for 1 hour to form FETs 418.

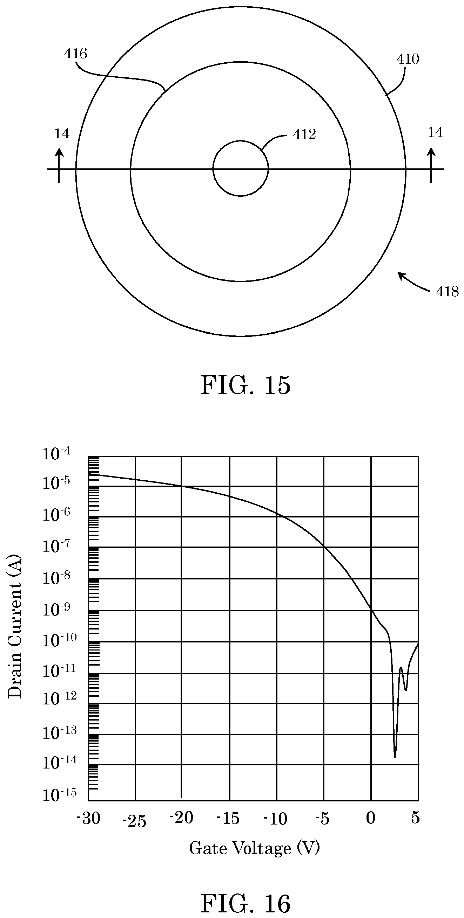

The ring FET layout is shown from the top in FIG. 15. The FET devices had a diameter of 140 $\mu$m and a thickness of 700 $\mu$m. The FET devices were measured by sweeping gate voltage from 5 volts to -30 volts while the drain was applied at -30 volts, -20 volts, -10 volts, - 5 volts, and -1 volts separately and the source was grounded. Fifty-seven FETs were measured on each wafer. A typical transfer curve (drain current as a function of gate voltage) of the ring FETs is shown in FIG. 16.

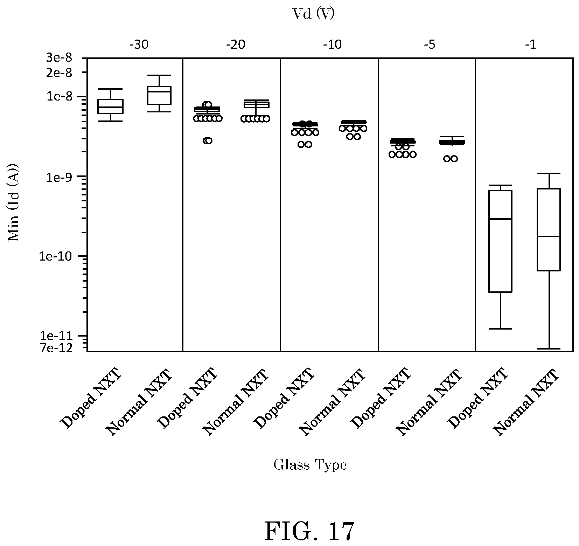

Transfer curves of the ring FETs with different drain voltages on Lotus NXT® glass both with Ni and Co doping and without doping (normal) of the glass were obtained. Under the same measurement conditions, all wafers exhibited identical performance. FET device off-current (Min (Id)) was extracted from the transfer curves and plotted with different drain voltages (Vd) and is shown in FIG. 17, which further confirmed observation from the transfer curves.

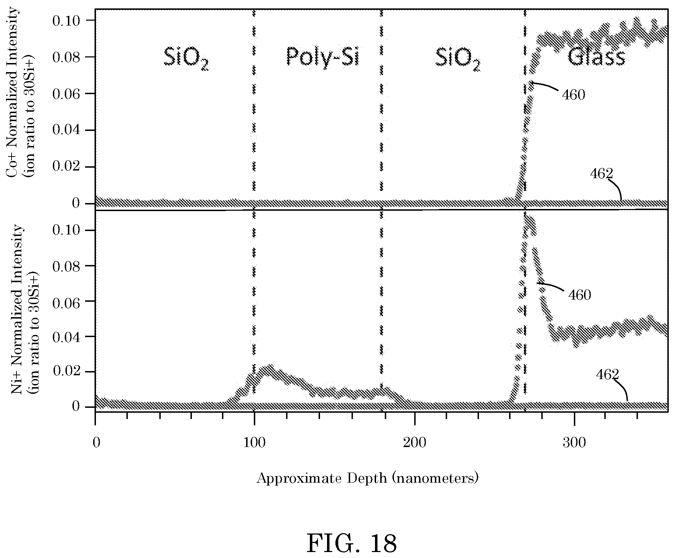

Time-of-flight secondary ion mass spectrometry (TOF-SIMS) was used to measure the $Ni^+$ and $Co^+$ ions concentration depth profiles on Lotus NXT® glass with Ni and Co doping (curves 460) and without Ni and Co doping (curves 462) after the ring FET TFT fabrication. To reduce the complexity of the thin film stack, the area without Al electrodes was measured by TOF-SIMS. TOF-SIMS results are shown in FIG. 18. Co ions showed good stability in the glass, and Ni ions diffused from the glass but concentrated in the poly-Si layer after the high temperature deposition process.

In summary, TFTs were deposited on a glass substrate comprising both nickel and cobalt. Measurements performed on the TFTs found no impact on performance parameters of the TFTs, showing the use of small amounts of Co and Ni to address light leakage is not likely to impact performance of devices that employ such doped glass.

Example 2

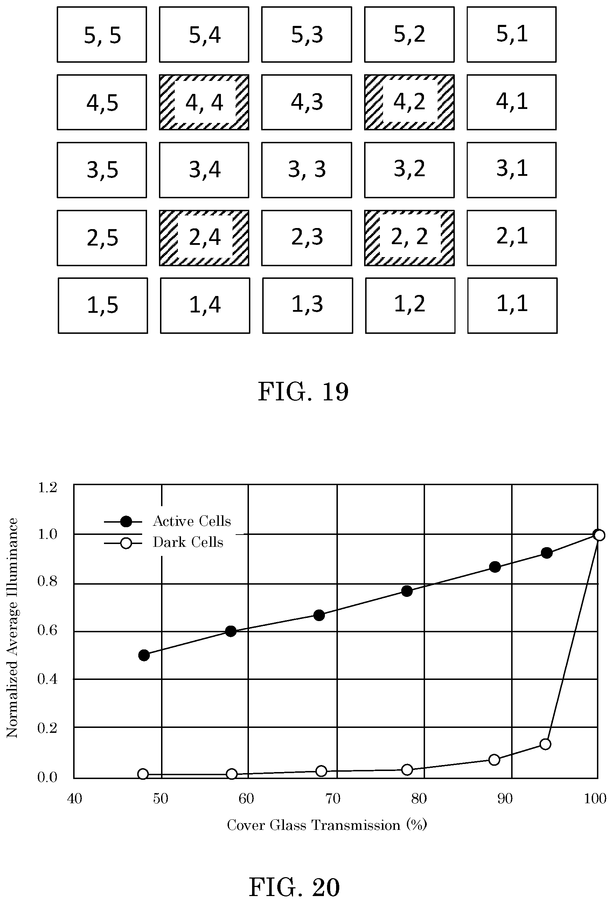

To model the contrast of an encapsulated top-emission micro-LED display, such as a display depicted in FIGS. 7-11, and referring particularly to FIG. 9, several microLEDs in the display center area were turned on, while the remaining micro-LEDs of the display were turned off. FIG. 19 shows a top view of the micro-LED display to be modeled and schematically depicts center area pixels from (1,1) to (5,5). As shown in FIG. 19, for the 5x5 pixels from (1,1) to (5,5), in the display center area, while the microLEDs in four pixels of (2,2), (2,4), (4,2), (4,4) are turned off, while all other microLEDs in the 5x5 array were turned on. Here, the definition of display contrast is defined as Display Contrast (%) = ((Average illuminance of active pixels)/(average illuminance of dark pixels)) x 100.

In the following modeling, dark pixels used to calculate display contrast included pixels (2,2), (2,4), (4,2), (4,4), and all other, active, pixels in the center area were used to calculate display contrast active.

Table 6 shows the encapsulation geometric parameters and glass cover plate and OCA material parameters. Two cases were be studied. One case (case 1) included a device with OCA layer having a refractive index of 1.49, and the other case (case 2) included a device with an OCA layer having a refractive index of 1.40.

Case 1, wherein the OCA layer had a refractive index of 1.49 is modeled. FIG. 18 is a plot of display contrast improvement (described as times improvement) as a function of glass cover plate transmission, in percent, showing an evaluation of the light distribution of the display viewed at a normal to the display when the transmission of the glass cover plate varied from 100% to 48%. It was observed that the light intensity in the dark pixel areas and the area without micro-LEDs decreased with decreasing glass cover plate transmission.

Table 6

|  | Glass Cover Plate | | | OCA Layer | | |
|---|---|---|---|---|---|---|
|  | Thickness (mm) | Transmittance (%) @ 550 nm and 0.7 mm | Refractive Index @ 550 nm | Thickness (mm) | Transmittance (%) | Refractive Index @ 550 nm |
| Case 1 | 0.5 | Variable | 1.51 | 0.06 | >99 | 1.49 |
| Case 2 | 0.5 | Variable | 1.51 | 0.06 | >99 | 1.40 |

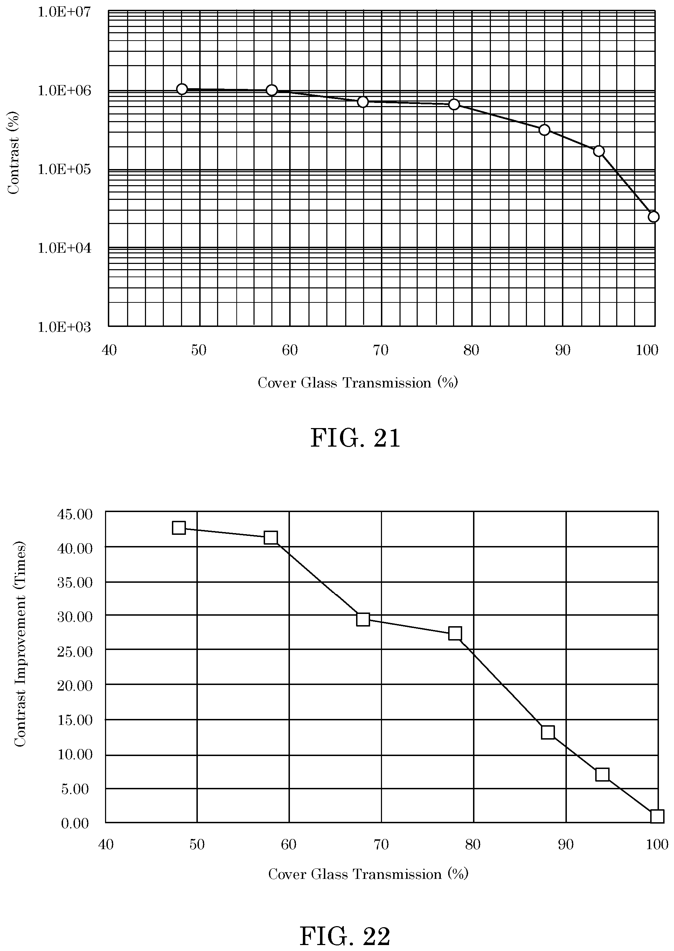

FIG. 20 shows the normalized average illuminances of active and dark pixels as a function of glass cover plate transmission. Figure 21 shows the contrast of the display as a function of the glass cover plate transmission. Figure 22 shows the contrast improvement of the display as a function of glass cover plate transmission. The contrast improvement of the display by reducing the transmission of the glass cover plate is defined by Contrast Improvement (Times) = (Display Contrast w/cover glass transmission Tg)/(Display Contrast w/cover glass transmission Tg=100).

As shown in FIG. 20, the illuminances of both active and dark pixels decrease with decreasing glass cover plate optical transmission. However, with decreasing glass cover plate transmission, the rate of illuminance decrease of the active pixels are much slower than that of the dark pixels. The illuminance of the active pixels linearly decreases with decreasing glass cover plate transmission, and the illuminance of the dark pixels near-exponentially decreases with decreasing the glass cover plate transmission. This results in an improvement of the display contrast by reducing the transmission of the glass cover plate. As shown in FIG. 21, depicting contrast in percent as a function of the cover glass plate transmission in percent, the contrast of the display increases with decreasing glass cover plate transmission, although the improvement begins to saturate after transmission of the glass cover plate falls to less than about 60%. As shown in FIG. 22, contrast improvement increases with decreasing glass cover plate transmission. Compared with a display using a 100%-transmission glass cover plate, the display contrast can be improved more than 25 times when the transmission of the glass cover plate is less than about 80%.

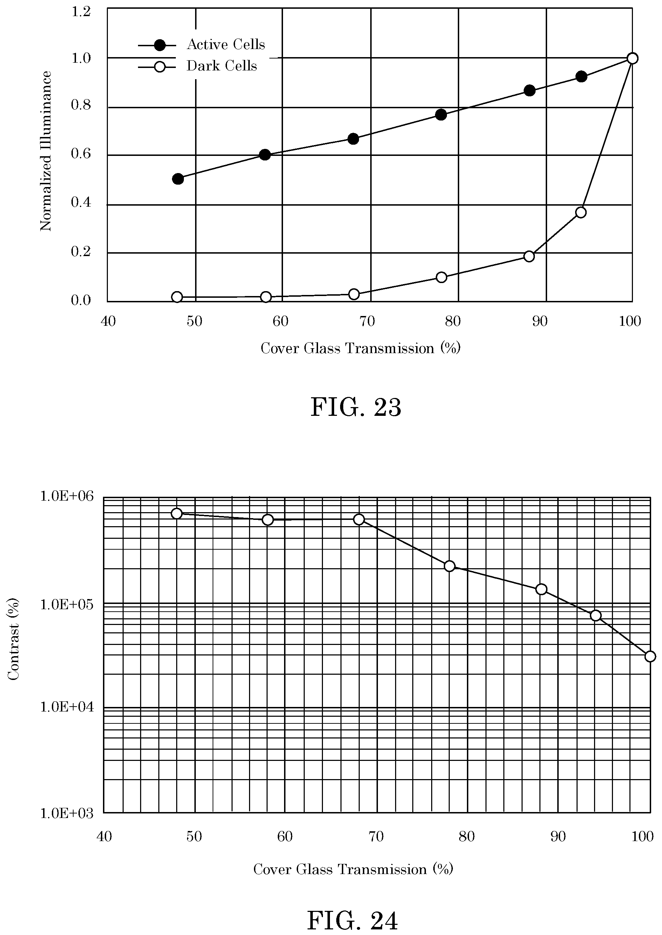

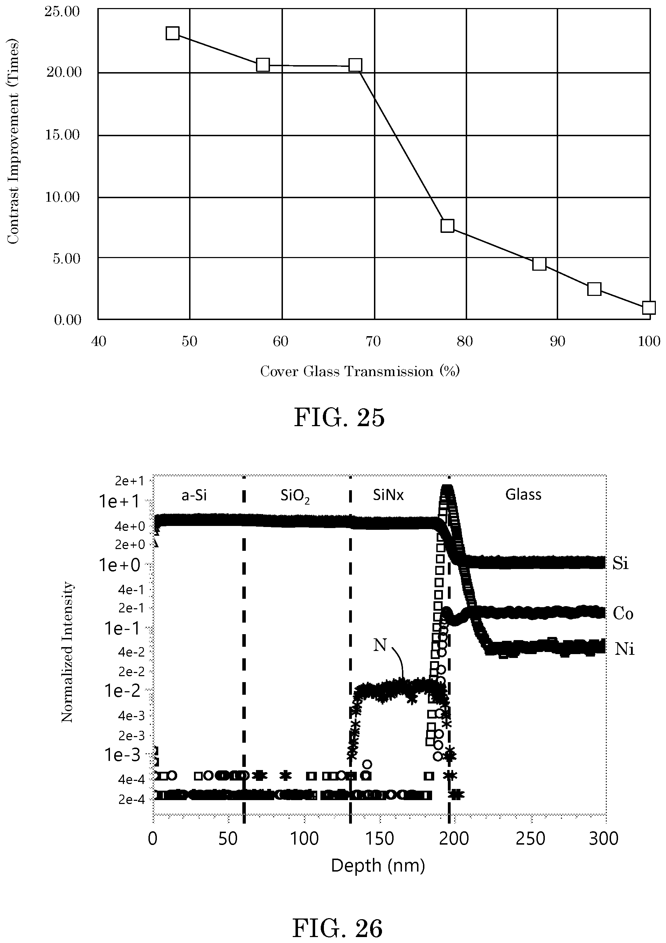

Second, case 2, in which the OCA had a refractive index of 1.40, was modeled. FIG. 23 shows the normalized average illuminances of active and dark pixels as a function of the glass cover plate transmission. FIG. 24 shows the contrast of the display as a function of the glass cover plate transmission. FIG. 25 shows the contrast improvement of the display as a function of the glass cover plate transmission. Like case 1, the data show contrast improvement of the display can be achieved by reducing the transmission of the glass cover plate. Thus, analysis shows that introducing an appropriate, e.g., increased, optical absorption in the glass cover plate of an encapsulated top emission micro-LED display not only can significantly reduce edge light leakage of the display, but also significantly improve contrast of the display.

Example 4

In another experiment, diffusion of the Ni and Co in a transition metal-doped glass substrate was tested in the presence of a barrier layer to determine if glasses described herein and used as a backplane substrate and/or base plate (e.g., to mitigate edge light leakage) risked contamination of TFTs deposited on the backplane substrate. An approximately 100 nm silicon nitride (generally designated as SiNx, where SiNx represent a nitride of silicon, e.g., $Si_3N_4$) layer was first deposited by a plasma enhanced chemical vapor deposition (PECVD) on a 5 cm x 5 cm glass substrate, 0.7 mm thick, at 400°C in a furnace, followed by deposition of an approximately 100 nm silica ($SiO_2$) layer, and finally an amorphous silicon layer (a-Si) overtop the silica layer to represent a TFT. The glass substrate was Corning® NXT glass doped with a sufficient amount of Ni and Co to obtain an optical transmittance of 70%. Subsequent to the addition of the layers the glass substrate was cooled to room temperature at the furnace rate, whereupon the glass substrate was heated to a temperature of 620°C for 30 minutes at a rate of about 5°C per second, in nitrogen ($N_2$), then cooled at about 5°C per second from 620°C to about 350°C, after which the cooling rate was decreased. Measurements of the sample were conducted by TOF-SIMS after the glass cooled to room temperature, wherein the measurements were conducted at varying depths in the layered glass substrate. The data is presented in FIG. 26 showing normalized intensity as a function of depth into the coated surface of the glass substrate.

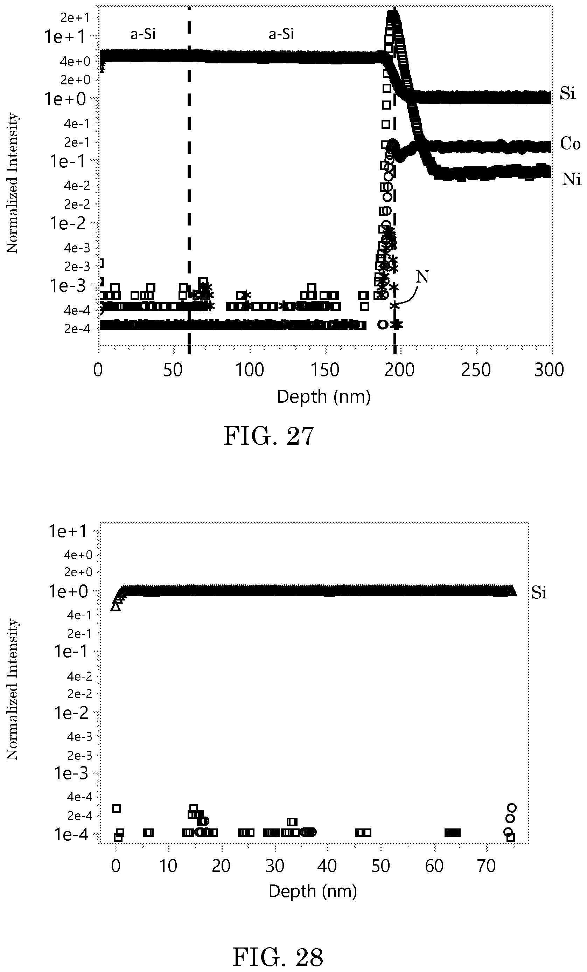

The experiment was also conducted on a second glass substrate with a first layer of silica deposited on the glass substrate to a thickness of about 200 nm, followed by an a-Si layer with a thickness of approximately 60 nm deposited overtop the silica layer. The data for this glass substrate is presented in FIG. 27 again showing normalized intensity as a function of depth into the coated surface of the glass substrate.

FIGS. 26 and 27 show a cobalt (Co, circle data points) signature that is essentially stopped at the glass-SiNx interface. Nickel (Ni, square data points) was more mobile in the glass, resulting in a larger intensity at the glass-SiNx interface, but again, no further diffusion into the SiNx boundary layer. FIG. 26 shows the presence of nitrogen (N, asterisk data points) as a consequence of the nitrided silicon. Silicon (Si) is represented by triangle data points. Referring now to FIG. 27, while the second experiment used a $SiO_2$ barrier layer, without an SiNx layer, and a simulated TFT deposited thereon, the results are almost identical to the results shown in FIG. 26. That is, in view of FIGS. 26 and 27, both SiNx and/or $SiO_2$ are shown to be effective barrier layers to prevent contamination of TFTs deposited on the Ni and/or Co doped glass when positioned between the TFTs (or other electronic, e.g., thin film, component) and the doped glass.

Example 5

A glass substrate comprising Corning ® NXT glass doped with a sufficient amount of Ni and Co to obtain a transmittance of 70% was supported over a silicon wafer and spaced therefrom a distance of 700 $\mu$m by silicon spacers. The purpose of the experiment was to determine the extent to which a glass doped with Co or Ni would release (e.g., through evaporation) Co or Ni to a level that would contaminate either the interior of a furnace (e.g., a furnace used for TFT deposition) or other components in the furnace (e.g., display devices, TFTs, etc.). The sample was heated to 620°C in a furnace and the furnace maintained at 620°C for 30 minutes at a rate of about 5°C per second, in nitrogen ($N_2$). The glass

substrate was then cooled to room temperature. Once cooled, the doped glass was removed and the silicon wafer surface facing the doped glass substrate was measured by TOF-SIMS. The data is presented in FIG. 28. The circle data points represent Co, the square data points represent Ni, and the triangle data points represent Si. Nitrogen is represented by asterisk data points. It is believed the presence of nitrogen results from contamination of the furnace and/or nitrogen from the heating environment. Nevertheless, the data show virtually no intensity signal for Co and/or Ni beyond the barrier layer, indicating glasses described herein doped with Co and/or Ni pose no contamination risk when used in the presence of a boundary layer under typical TFT deposition conditions.

It will be apparent to those skilled in the art that various modifications and variations can be made to the present disclosure within the scope of the appended claims

## Claims

1. A glass article comprising a glass having a composition comprising in mole percent on an oxide basis:

| | |
|---|---|
| $SiO_2$ | 61 - 74; |
| $Al_2O_3$ | 9 - 14; |
| $B_2O_3$ | 0 - 12; |
| MgO | 0 - 9; |
| CaO | 3.5 - 12; |
| SrO | 0 - 5; |
| BaO | 0 - 5; |
| $SnO_2$ | 0 - 0.15; |
| NiO | 0.025 - 0.13; |
| $Co_3O_4$ | 0.005 - 0.04, and |

wherein $(MgO+CaO+SrO+BaO)/Al_2O_3$ is equal to or greater than 1,
and an average optical transmittance of the glass article over a wavelength range from 450 nm to 650 nm for a thickness of 0.7 mm is less than 90%.

2. The glass article of claim 1, wherein the average optical transmittance is in a range from 60% to 82%.

3. The glass article of claim 1, wherein an optical transmittance of the glass article over the wavelength range from 450 nm to 650 nm for a thickness of 0.7 mm is within +/- 5% of the average optical transmittance.

4. The glass article of any one of claims 1 to 3, wherein the glass comprises $B_2O_3$ in an amount in a range from 0.2 mol% to 12 mol%.

5. The glass article of any one of claims 1 to 4, wherein the glass comprises MgO in an amount in a range from 0.9 mol% to 8 mol%.

6. The glass article of claim 1, wherein the glass comprises:

| | |
|---|---|
| $SiO_2$ | 67 - 74; |
| $Al_2O_3$ | 10 - 14; |
| $B_2O_3$ | 0 - 3; |
| MgO | 3 - 8; |
| CaO | 3.9 - 8; |
| SrO | 0 - 2; and |
| BaO | 2 - 5. |

7. The glass article of claim 1, wherein the glass comprises:

| | |
|---|---|
| $SiO_2$ | 64 - 71; |

(continued)

| | |
|---|---|
| $Al_2O_3$ | 9 - 12; |
| $B_2O_3$ | 7 - 12; |
| MgO | 0.9 - 3; |
| CaO | 6 - 12; |
| SrO | 0 - 2; and |
| BaO | 0 - 1. |

8. The glass article of claim 1, wherein the glass comprises:

| | |
|---|---|
| $SiO_2$ | 61 - 69; |
| $Al_2O_3$ | 11 - 14; |
| $B_2O_3$ | 5 - 9; |
| MgO | 2 - 9; |
| CaO | 3 - 9; and |
| SrO | 1 - 5. |

9. The glass article of claim 1, wherein the glass comprises:

| | |
|---|---|
| $SiO_2$ | 66 - 71; |
| $Al_2O_3$ | 11 - 14; |
| $B_2O_3$ | 3 - 6; |
| MgO | 3 - 6; |
| CaO | 4 - 7; |
| SrO | 1 - 5; and |
| BaO | 0 - 2. |

10. The glass article of any one of claims 1 to 9, wherein the glass comprises:

| | |
|---|---|
| NiO | 0.055 - 0.065; and |
| $Co_3O_4$ | 0.011 - 0.013. |

11. The glass of any one of claims 1 to 9, wherein the glass comprises:

| | |
|---|---|
| NiO | 0.077 - 0.128; and |
| $Co_3O_4$ | 0.025 - 0.037. |

12. The glass article of any one of claims 1 to 11, wherein a liquidus temperature of the glass is in a range from 1000°C to 1300°C.

13. A display device comprising a plurality of display substrates arranged on a base plate comprising the glass of any one of claims 1 to 12, each display substrate comprising a plurality of light emitters disposed thereon and configured to direct light through the base plate.

14. The display device of claim 13, wherein each display substrate comprises a barrier layer comprising at least one of $SiO_2$ or SiNx deposited on the display substrate between the display substrate and the plurality of light emitters.

**Patentansprüche**

1. Glasartikel, umfassend ein Glas, das eine Zusammensetzung aufweist, umfassend in Molprozent auf einer Oxidba-

sis:

| | |
|---|---|
| $SiO_2$ | 61-74; |
| $Al_2O_3$ | 9-14; |
| $B_2O_3$ | 0-12; |
| MgO | 0-9; |
| CaO | 3,5-12; |
| SrO | 0-5; |
| BaO | 0-5; |
| $SnO_2$ | 0-0,15; |
| NiO | 0,025-0,13; |
| $Co_3O_4$ | 0,005-0,04, und |

wobei $(MgO+CaO+SrO+BaO)/Al_2O_3$ gleich oder größer als 1 ist,
und eine durchschnittliche optische Durchlässigkeit des Glasartikels über einen Wellenlängenbereich von 450 nm bis 650 nm für eine Dicke von 0,7 mm weniger als 90 % ist.

2. Glasartikel nach Anspruch 1, wobei die durchschnittliche optische Durchlässigkeit in einem Bereich von 60 % bis 82 % ist.

3. Glasartikel nach Anspruch 1, wobei eine optische Durchlässigkeit des Glasartikels über den Wellenlängenbereich von 450 nm bis 650 nm für eine Dicke von 0,7 mm innerhalb von +/- 5 % der durchschnittlichen optischen Durchlässigkeit ist.

4. Glasartikel nach einem der Ansprüche 1 bis 3, wobei das Glas $B_2O_3$ in einer Menge in einem Bereich von 0,2 Mol-% bis 12 Mol-% umfasst.

5. Glasartikel nach einem der Ansprüche 1 bis 4, wobei das Glas MgO in einer Menge in einem Bereich von 0,9 Mol-% bis 8 Mol-% umfasst.

6. Glasartikel nach Anspruch 1, wobei das Glas Folgendes umfasst:

| | |
|---|---|
| $SiO_2$ | 67-74; |
| $Al_2O_3$ | 10-14; |
| $B_2O_3$ | 0-3; |
| MgO | 3-8; |
| CaO | 3,9-8; |
| SrO | 0-2; und |
| BaO | 2-5. |

7. Glasartikel nach Anspruch 1, wobei das Glas Folgendes umfasst:

| | |
|---|---|
| $SiO_2$ | 64-71; |
| $Al_2O_3$ | 9-12; |
| $B_2O_3$ | 7-12; |
| MgO | 0,9-3; |
| CaO | 6-12; |
| SrO | 0-2; und |
| BaO | 0-1. |

8. Glasartikel nach Anspruch 1, wobei das Glas Folgendes umfasst:

| | |
|---|---|
| SiO$_2$ | 61-69; |
| Al$_2$O$_3$ | 11-14; |
| B$_2$O$_3$ | 5-9; |
| MgO | 2-9; |
| CaO | 3-9; und |
| SrO | 1-5. |

9. Glasartikel nach Anspruch 1, wobei das Glas Folgendes umfasst:

| | |
|---|---|
| SiO$_2$ | 66-71; |
| Al$_2$O$_3$ | 11-14; |
| B$_2$O$_3$ | 3-6; |
| MgO | 3-6; |
| CaO | 4-7; |
| SrO | 1-5; und |
| BaO | 0-2. |

10. Glasartikel nach einem der Ansprüche 1 bis 9, wobei das Glas Folgendes umfasst:

| | |
|---|---|
| NiO | 0,055-0,065; und |
| Co$_3$O$_4$ | 0,011-0,013. |

11. Glas nach einem der Ansprüche 1 bis 9, wobei das Glas Folgendes umfasst:

| | |
|---|---|
| NiO | 0,077-0,128; und |
| Co$_3$O$_4$ | 0,025-0,037. |

12. Glasartikel nach einem der Ansprüche 1 bis 11, wobei eine Liquidustemperatur des Glases in einem Bereich von 1000 °C bis 1300 °C ist.

13. Anzeigevorrichtung, umfassend eine Vielzahl von Anzeigesubstraten, die auf einer Basisplatte angeordnet ist, die das Glas nach einem der Ansprüche 1 bis 12 umfasst, wobei jedes Anzeigesubstrat eine Vielzahl von darauf vorgesehenen Lichtemittern umfasst und dazu konfiguriert ist, Licht durch die Basisplatte zu leiten.

14. Anzeigevorrichtung nach Anspruch 13, wobei jedes Anzeigesubstrat eine Barriereschicht umfasst, die zumindest eines von SiO$_2$ oder SiNx umfasst, das auf dem Anzeigesubstrat zwischen dem Anzeigesubstrat und der Vielzahl von Lichtemittern abgeschieden ist.

**Revendications**

1. Article en verre comprenant un verre ayant une composition comprenant en pourcentage molaire sur une base d'oxyde :

| | |
|---|---|
| SiO$_2$ | 61 à 74 ; |
| Al$_2$O$_3$ | 9 à 14 ; |
| B$_2$O$_3$ | 0 à 12 ; |
| MgO | 0 à 9 ; |
| CaO | 3,5 à 12 ; |
| SrO | 0 à 5 ; |
| BaO | 0 à 5 ; |
| SnO$_2$ | 0 à 0,15 ; |

(continued)

| | |
|---|---|
| NiO | 0,025 à 0,13 ; |
| Co$_3$O$_4$ | 0,005 et 0,04 ; et |

dans lequel (MgO+CaO+SrO+BaO)/Al$_2$O$_3$ est égal ou supérieur à 1,
et une transmittance optique moyenne de l'article en verre sur une plage de longueurs d'onde de 450 nm à 650 nm pour une épaisseur de 0,7 mm est inférieure à 90 %.

2. Article en verre selon la revendication 1, dans lequel la transmittance optique moyenne est comprise dans une plage de 60 % à 82 %.

3. Article en verre selon la revendication 1, dans lequel une transmittance optique de l'article en verre sur la plage de longueurs d'onde de 450 nm à 650 nm pour une épaisseur de 0,7 mm se situe à +/- 5 % de la transmittance optique moyenne.

4. Article en verre selon l'une quelconque des revendications 1 à 3, dans lequel le verre comprend du B$_2$O$_3$ en une quantité comprise dans une plage allant de 0,2 % en moles à 12 % moles.

5. Article en verre selon l'une quelconque des revendications 1 à 4, dans lequel le verre comprend du MgO en une quantité comprise dans une plage allant de 0,9 % en moles à 8 % en moles.

6. Article en verre selon la revendication 1, dans lequel le verre comprend :

| | |
|---|---|
| SiO$_2$ | 67 à 74 ; |
| Al$_2$O$_3$ | 10 à 14 ; |
| B$_2$O$_3$ | 0 à 3 ; |
| MgO | 3 à 8 ; |
| CaO | 3,9 à 8 ; |
| SrO | 0 à 2 ; et |
| BaO | 2 à 5. |

7. Article en verre selon la revendication 1, dans lequel le verre comprend :

| | |
|---|---|
| SiO$_2$ | 64 à 71 ; |
| Al$_2$O$_3$ | 9 à 12 ; |
| B$_2$O$_3$ | 7 à 12 ; |
| MgO | 0,9 à 3 ; |
| CaO | 6 à 12 ; |
| SrO | 0 à 2 ; et |
| BaO | 0 à 1. |

8. Article en verre selon la revendication 1, dans lequel le verre comprend :

| | |
|---|---|
| SiO$_2$ | 61 à 69 ; |
| Al$_2$O$_3$ | 11 à 14 ; |
| B$_2$O$_3$ | 5 à 9 ; |
| MgO | 2 à 9 ; |
| CaO | 3 à 9 ; et |
| SrO | 1 à 5. |

9. Article en verre selon la revendication 1, dans lequel le verre comprend :

|  |  |
|---|---|
| SiO$_2$ | 66 à 71 ; |
| Al$_2$O$_3$ | 11 à 14 ; |
| B$_2$O$_3$ | 3 à 6 ; |
| MgO | 3 à 6 ; |
| CaO | 4 à 7 ; |
| SrO | 1 à 5 ; et |
| BaO | 0 à 2. |

10. Article en verre selon l'une quelconque des revendications 1 à 9, dans lequel le verre comprend :

|  |  |
|---|---|
| NiO | 0,055 à 0,065 ; et |
| Co$_3$O$_4$ | 0,011 à 0,013. |

11. Verre selon l'une quelconque des revendications 1 à 9, dans lequel le verre comprend :

NiO 0,077 à 0,128 ; et
Co$_3$O$_4$ 0,025 à 0,037.

12. Article en verre selon l'une quelconque des revendications 1 à 11, dans lequel une température de liquidus du verre est comprise dans une plage allant de 1000° C à 1300° C.

13. Dispositif d'affichage comprenant une pluralité de substrats d'affichage agencés sur une plaque de base comprenant le verre selon l'une quelconque des revendications 1 à 12, chaque substrat d'affichage comprenant une pluralité d'émetteurs de lumière disposés sur celui-ci et configurés pour diriger la lumière à travers la plaque de base.

14. Dispositif d'affichage selon la revendication 13, dans lequel chaque substrat d'affichage comprend une couche barrière comprenant au moins l'un du SiO$_2$ ou SiNx déposé sur le substrat d'affichage entre le substrat d'affichage et la pluralité d'émetteurs de lumière.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

48

400

402

(a)

406

404

402

(b)

408

404

402

(c)

410 412 410

414

404

408

402

(d)

410 416 412 416 410 418

414

404

408

402

(e)

FIG. 14

FIG. 15

FIG. 16

FIG. 17

FIG. 18

| | | | | |
|---|---|---|---|---|
| 5, 5 | 5,4 | 5,3 | 5,2 | 5,1 |
| 4,5 | 4, 4 | 4,3 | 4,2 | 4,1 |
| 3,5 | 3,4 | 3, 3 | 3,2 | 3,1 |
| 2,5 | 2,4 | 2,3 | 2, 2 | 2,1 |
| 1,5 | 1,4 | 1,3 | 1,2 | 1,1 |

FIG. 19

FIG. 20

FIG. 21

FIG. 22

FIG. 23

FIG. 24

FIG. 25

FIG. 26

FIG. 27

FIG. 28

**EP 4 547 614 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 63367225
- US 63432889
- US 63507744
- US 2017152170 A1
- US 2018016183 A1
- US 3338696 A
- US 3682609 A

### Non-patent literature cited in the description

- **J. NOLTE**. ICP Emission Spectrometry: A Practical Guide. Wiley-VCH, 2003
- **H.E. TAYLOR**. Inductively Coupled Plasma Mass Spectroscopy: Practices and Techniques. Academic Press, 2000
- **S.J.B. REED**. Electron Microprobe Analysis. Cambridge University Press, 1997